(19) Europäisches Patentamt
European Patent Office
Office européen des brevets

(11) EP 3 490 023 B1

(12) **EUROPEAN PATENT SPECIFICATION**

(45) Date of publication and mention of the grant of the patent:
**22.04.2020 Bulletin 2020/17**

(51) Int Cl.:
***H01L 51/54*** (2006.01)

(21) Application number: **18206446.9**

(22) Date of filing: **15.11.2018**

(54) **COMPOSITION, THIN FILM INCLUDING THE COMPOSITION, AND ORGANIC LIGHT-EMITTING DEVICE INCLUDING THE THIN FILM**

ZUSAMMENSETZUNG, DÜNNSCHICHT MIT DER ZUSAMMENSETZUNG UND ORGANISCHE LICHTEMITTIERENDE VORRICHTUNG MIT DER DÜNNSCHICHT

COMPOSITION, FILM MINCE COMPRENANT LA COMPOSITION ET DISPOSITIF ÉLECTROLUMINESCENT ORGANIQUE COMPRENANT LE FILM MINCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.11.2017 KR 20170156612**
**14.11.2018 KR 20180140098**

(43) Date of publication of application:
**29.05.2019 Bulletin 2019/22**

(73) Proprietor: **Samsung Electronics Co., Ltd.**
**Gyeonggi-do 16677 (KR)**

(72) Inventors:
- **SIM, Myungsun**
**16678 Gyeonggi-do (KR)**
- **IHN, Sooghang**
**16678 Gyeonggi-do (KR)**
- **KIM, Jongsoo**
**16678 Gyeonggi-do (KR)**
- **KIM, Joonghyuk**
**16678 Gyeonggi-do (KR)**
- **MIYAZAKI, Hiroshi**
**16678 Gyeonggi-do (KR)**
- **LEE, Hasup**
**16678 Gyeonggi-do (KR)**
- **JEON, Soonok**
**16678 Gyeonggi-do (KR)**
- **CHUNG, Yeonsook**
**16678 Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**EP-A1- 2 876 698 EP-A1- 3 142 162**

- **JIN WON SUN ET AL: "A Fluorescent Organic Light-Emitting Diode with 30% External Quantum Efficiency", ADVANCED MATERIALS, vol. 26, no. 32, 30 May 2014 (2014-05-30), pages 5684-5688, XP055335555, DE ISSN: 0935-9648, DOI: 10.1002/adma.201401407**
- **SOO-GHANG IHN ET AL: "An Alternative Host Material for Long-Lifespan Blue Organic Light-Emitting Diodes Using Thermally Activated Delayed Fluorescence", ADVANCED SCIENCE, vol. 4, no. 8, 23 March 2017 (2017-03-23), page 1600502, XP055575310, ISSN: 2198-3844, DOI: 10.1002/advs.201600502**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 490 023 B1

## Description

FIELD OF THE INVENTION

One or more embodiments relate to a composition, a thin film including the composition, and an organic light-emitting device including the thin film.

BACKGROUND OF THE INVENTION

Organic light-emitting devices are self-emission devices that produce full-color images, and also have wide viewing angles, high contrast ratios, short response times, and excellent characteristics in terms of brightness, driving voltage, and response speed, compared to devices in the art.

In an example, an organic light-emitting device includes an anode, a cathode, and an organic layer between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

EP 3 142 162 A1; Adv. Mater., 2014, 26, 5684-5688; EP 2 876 698 A1; and Adv. Sci., 2017, 4, 1600502; all disclose light emitting devices having an emissive compound and a host material, where the first two documents disclose light emitting layers having two host materials, in addition to the emissive compound.

SUMMARY OF THE INVENTION

Aspects of the present disclosure provide a composition including a predetermined first compound, a predetermined second compound, and a predetermined third compound, a thin film including the composition, and an organic light-emitting device including the thin film.

Additional aspects will be set forth in part in the description which follows and, in part, will be apparent from the description, or may be learned by practice of the presented embodiments.

An aspect provides a composition including: a first compound represented by Formula 1; a second compound represented by Formula 2; a third compound satisfying Condition 1, and the second compound is different from the first compound:

<Formula 1> $A_{11}-L_{11}-A_{12}$

<Formula 2> $A_{21}-(L_{21})_{a21}-A_{22}$

<Formula 10-1>

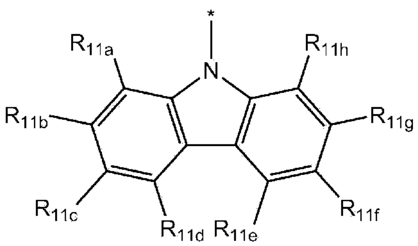

<Formula 10-2>

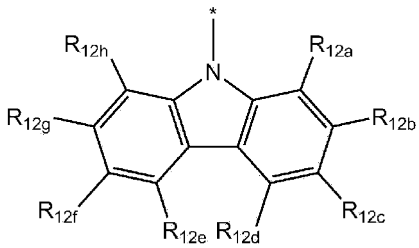

<Formula 11-1>

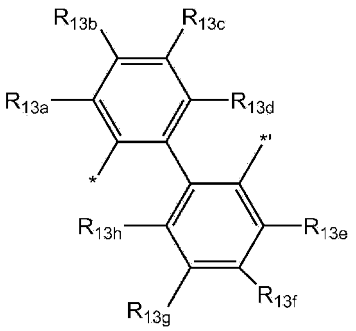

<Formula 11-2>

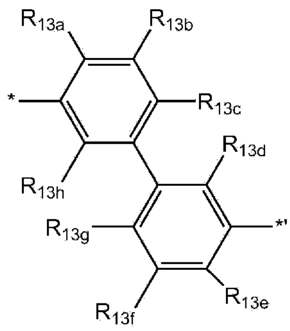

<Formula 11-3>

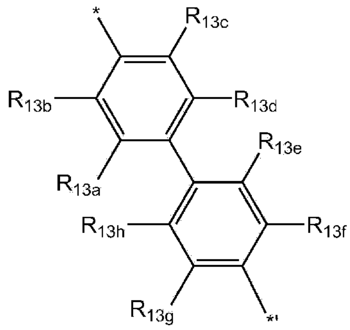

<Formula 20-1>

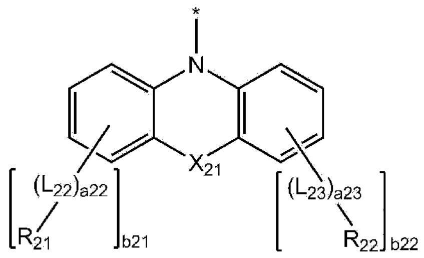

<Formula 20-2>

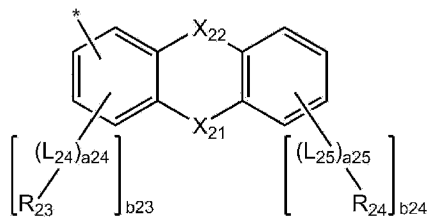

<Condition 1>

$$0\ \text{eV} \leq E_{S1}(C3) - E_{T1}(C3) \leq 0.3\ \text{eV}.$$

In Condition 1,

$E_{S1}(C3)$ is a lowest excitation singlet energy level of the third compound,
$E_{T1}(C3)$ is a lowest excitation triplet energy level of the third compound, and
$E_{S1}(C3)$ and $E_{T1}(C3)$ are evaluated by using a DFT method structurally optimized at a level of B3LYP/6-31G(d,p),

In Formulae 1 and 2,

$A_{11}$ may be a group represented by Formula 10-1,
$A_{12}$ may be a group represented by Formula 10-2,
$L_{11}$ may be a group represented by one selected from Formulae 11-1 to 11-3,
$A_{21}$ may be a group represented by one selected from Formulae 20-1 and 20-2;
$A_{22}$ may be selected from groups represented by Formulae 20-1 and 20-2, a phenyl group, a naphthyl group, and a benzimidazolyl group; and
a phenyl group, a naphthyl group, and a benzimidazolyl group, each substituted with at least one selected from deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, and a dibenzothiophenyl group,
$X_{21}$ may be selected from a single bond, $C[(L_{27})_{a27}$-$R_{26}][(L_{28})_{a28}$-$R_{27}]$, O, and S,
$X_{22}$ may be selected from $N[(L_{26})_{a26}$-$R_{25}]$, $C[(L_{29})_{a29}$-$R_{28}][(L_{30})_{a30}$-$R_{29}]$, O, and S,
$L_{21}$ to $L_{30}$ may each independently be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group,
a21 to a30 may each independently be selected from 0, 1, 2, 3, 4, and 5,

$R_{11a}$ to $R_{11h}$, $R_{12a}$ to $R_{12h}$, $R_{13a}$ to $R_{13h}$, and $R_{21}$ to $R_{29}$ may each independently be selected from hydrogen, deuterium, -F, -Cl, -Br, -I, a hydroxyl group, a cyano group (CN), a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -N($Q_1$)($Q_2$), and-B($Q_1$)($Q_2$), two or more selected from $R_{21}$ to $R_{29}$ are optionally linked to form a ring,

at least one selected from $R_{11a}$ to $R_{11h}$, $R_{12a}$ to $R_{12h}$, and $R_{13a}$ to $R_{13h}$ may be a cyano group,

b21, b22, and b24 may each independently be selected from 1, 2, 3, and 4,

b23 may be selected from 1, 2, and 3,

$Q_1$ to $Q_3$ may each independently be selected from hydrogen, deuterium, -F,-Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, a monovalent non-aromatic condensed heteropolycyclic group, a biphenyl group, and a terphenyl group, and

* and *' each indicate a binding site to a neighboring atom.

Another aspect provides a thin film including the composition.

Another aspect provides an organic light-emitting device including: a first electrode; a second electrode; and an organic layer between the first electrode and the second electrode, wherein the organic layer includes the thin film. The thin film in the organic light-emitting device may be an emission layer.

BRIEF DESCRIPTION OF THE DRAWING

These and/or other aspects will become apparent and more readily appreciated from the following description of the embodiments, taken in conjunction with FIGURE which is a schematic view of an organic light-emitting device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

A composition may include: a first compound represented by Formula 1; a second compound represented by Formula 2 which is different from the first compound; and a third compound satisfying Condition 1:

<Formula 1> $A_{11}$-$L_{11}$-$A_{12}$

<Formula 2> $A_{21}$-$(L_{21})_{a21}$-$A_{22}$

<Condition 1>

$$0\ eV \leq E_{S1}(C3) - E_{T1}(C3) \leq 0.3\ eV.$$

In Condition 1, Esi(C3) is a lowest excitation singlet energy level of the third compound, and $E_{T1}$(C3) is a lowest

excitation triplet energy level of the third compound.

Esi(C3) and $E_{T1}$(C3) are evaluated by using a DFT method structurally optimized at a level of B3LYP/6-31G(d,p). Specifically, $E_{S1}$(C3) and $E_{T1}$(C3) may be evaluated by using the Gaussian program.

In Formula 1, $A_{11}$ may be a group represented by Formula 10-1, and $A_{12}$ may be a group represented by Formula 10-2:

<Formula 10-1>

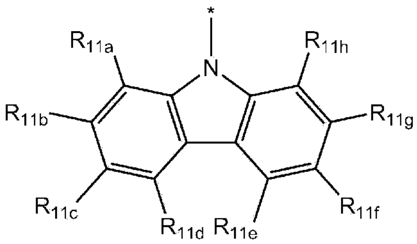

<Formula 10-2>

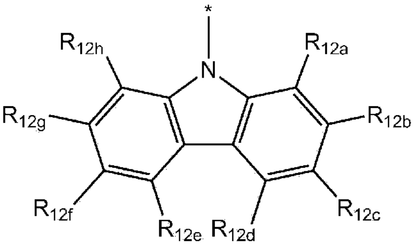

.

In Formulae 10-1 and 10-2, $R_{11a}$ to $R_{11h}$ and $R_{12a}$ to $R_{12h}$ may each independently be the same as described herein, and * indicates a binding site to a neighboring atom.

In Formula 1, $L_{11}$ may be a group represented by one selected from Formulae 11-1 to 11-3:

<Formula 11-1>

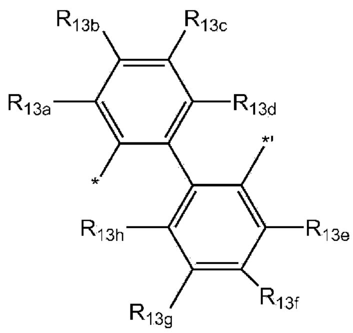

<Formula 11-2>

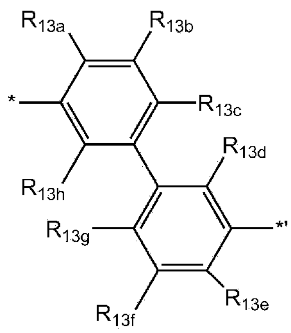

<Formula 11-3>

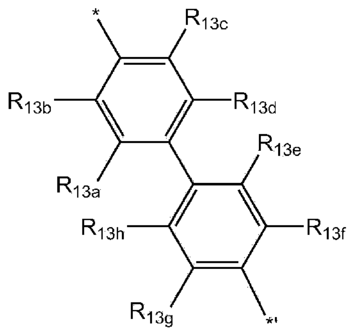

.

In Formulae 11-1 to 11-3, $R_{13a}$ to $R_{13h}$ may each independently be the same as described herein, and * indicates a binding site to a neighboring atom.

For example, in Formula 1, $L_{11}$ may be a group represented by Formula 11-1, but embodiments of the present disclosure are not limited thereto.

In Formulae 10-1, 10-2, and 11-1 to 11-3, $R_{11a}$ to $R_{11h}$, $R_{12a}$ to $R_{12h}$, and $R_{13a}$ to $R_{13h}$ may each independently be selected from hydrogen, deuterium, -F, -Cl, -Br,-I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -N($Q_1$)($Q_2$), and -B($Q_1$)($Q_2$),

at least one selected from $R_{11a}$ to $R_{11h}$, $R_{12a}$ to $R_{12h}$, and $R_{13a}$ to $R_{13h}$ may be a cyano group, and

$Q_1$ to $Q_3$ may each independently be selected from hydrogen, deuterium, -F,-Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, a monovalent non-aromatic condensed heteropolycyclic group, a biphenyl group, and a terphenyl group.

For example, in Formulae 10-1, 10-2, and 11-1 to 11-3, one, two, or three selected from $R_{11a}$ to $R_{11h}$, $R_{12a}$ to

$R_{12h}$, and $R_{13a}$ to $R_{13h}$ may be a cyano group, but embodiments of the present disclosure are not limited thereto.

In one embodiment, in Formulae 10-1, 10-2, and 11-1 to 11-3, $R_{11a}$ to $R_{11h}$, $R_{12a}$ to $R_{12h}$, and $R_{13a}$ to $R_{13h}$ may each independently be selected from:

hydrogen, deuterium, a cyano group, a $C_1$-$C_{10}$ alkyl group, and a $C_1$-$C_{10}$ alkoxy group;
a $C_1$-$C_{10}$ alkyl group and a $C_1$-$C_{10}$ alkoxy group, each substituted with at least one selected from deuterium and a cyano group;
a phenyl group, a biphenyl group, a terphenyl group, a naphthyl group, a fluorenyl group, a pyridinyl group, a pyrazinyl group, a pyrimidinyl group, a carbazolyl group, a dibenzofuranyl group, and a dibenzothiophenyl group; and
a phenyl group, a biphenyl group, a terphenyl group, a naphthyl group, a fluorenyl group, a pyridinyl group, a carbazolyl group, a dibenzofuranyl group, and a dibenzothiophenyl group, each substituted with at least one selected from deuterium, a cyano group, a $C_1$-$C_{10}$ alkyl group, a $C_1$-$C_{10}$ alkoxy group, a phenyl group, a biphenyl group, a terphenyl group, a naphthyl group, a fluorenyl group, a pyridinyl group, a pyrazinyl group, a pyrimidinyl group, a carbazolyl group, a dibenzofuranyl group, and a dibenzothiophenyl group, but embodiments of the present disclosure are not limited thereto.

In one embodiment, in Formulae 10-1, 10-2, and 11-1 to 11-3, $R_{11a}$ to $R_{11h}$, $R_{12a}$ to $R_{12h}$, and $R_{13a}$ to $R_{13h}$ may each independently be selected from:

hydrogen, deuterium, a cyano group, a methyl group, an ethyl group, an n-propyl group, an isopropyl group, an n-butyl group, an isobutyl group, a sec-butyl group, and a tert-butyl group;
a methyl group, an ethyl group, an n-propyl group, an isopropyl group, an n-butyl group, an isobutyl group, a sec-butyl group, and a tert-butyl group, each substituted with at least one selected from deuterium and a cyano group;
a phenyl group, a naphthyl group, a pyridinyl group, a pyrazinyl group, and a pyrimidinyl group; and
a phenyl group, a naphthyl group, a pyridinyl group, a pyrazinyl group, and a pyrimidinyl group, each substituted with at least one selected from deuterium, a cyano group, a methyl group, an ethyl group, an n-propyl group, an isopropyl group, an n-butyl group, an isobutyl group, a sec-butyl group, a tert-butyl group, a phenyl group, and a pyridinyl group, but embodiments of the present disclosure are not limited thereto.

In one embodiment, in Formula 1, $A_{11}$ may be represented by Formula 10-11, $A_{12}$ may be represented by Formula 10-21, and $L_{11}$ may be represented by one selected from Formulae 11-15 to 11-22, 11-27 to 11-34, and 11-37 to 11-40;
$A_{11}$ may be represented by one selected from Formulae 10-12 and 10-13, $A_{12}$ may be represented by one selected from Formulae 10-21 to 10-23, and $L_{11}$ may be represented by one selected from Formulae 11-11 to 11-40; or
$A_{11}$ may be represented by Formula 10-11, $A_{12}$ may be represented by one selected from Formulae 10-22 and 10-23, and $L_{11}$ may be represented by one selected from Formulae 11-11 to 11-40, but embodiments of the present disclosure are not limited thereto:

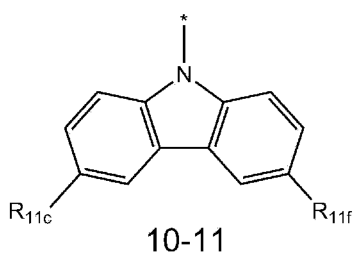
10-11

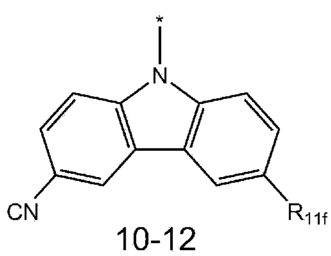
10-12

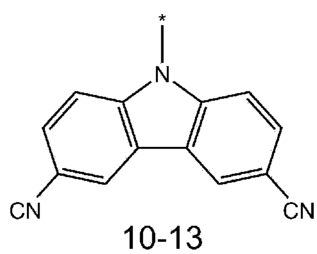
10-13

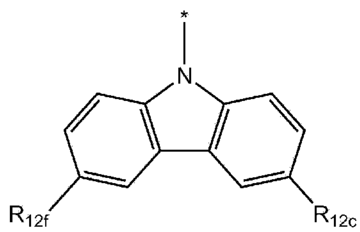
10-21

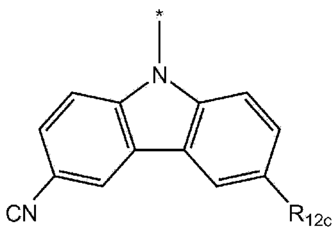
10-22

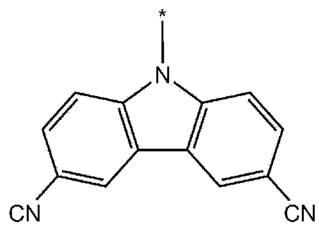
10-23

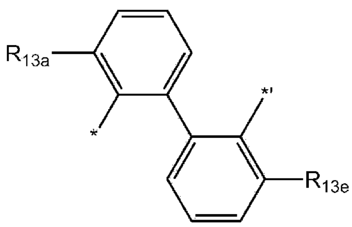

11-11

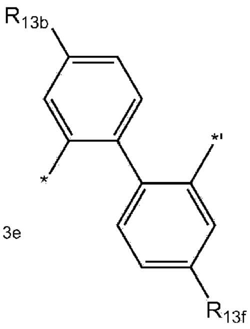

11-12

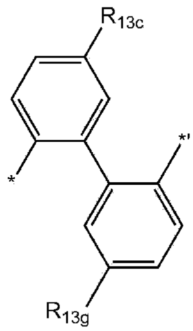

11-13

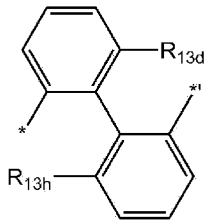

11-14

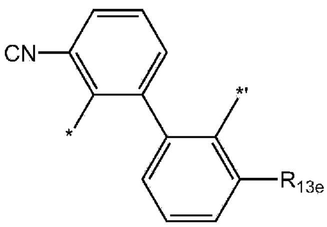

11-15

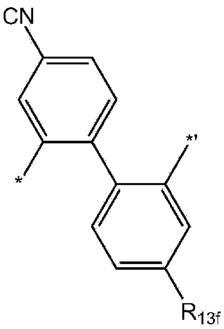

11-16

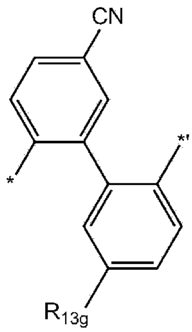

11-17

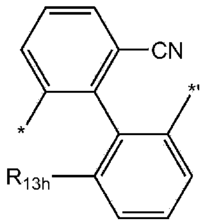

11-18

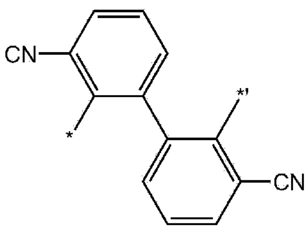

11-19

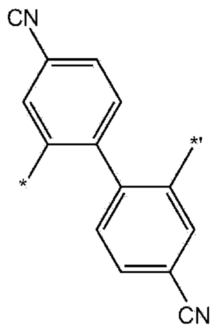

11-20

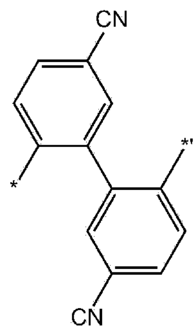

11-21

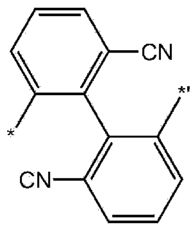

11-22

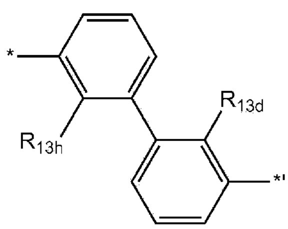

11-23

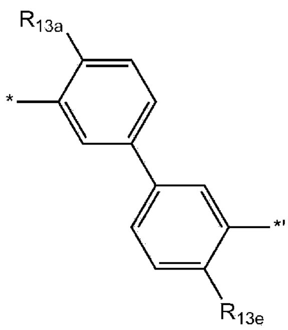

11-24

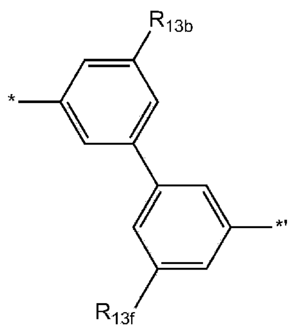

11-25

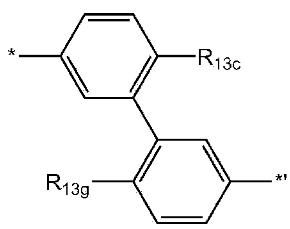

11-26

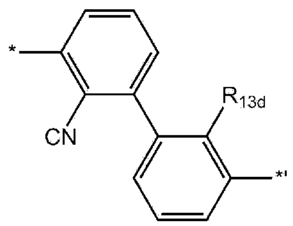
11-27

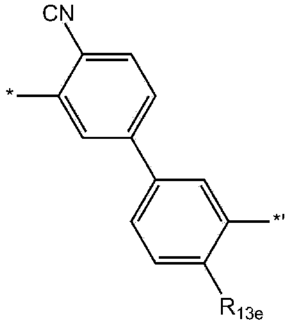
11-28

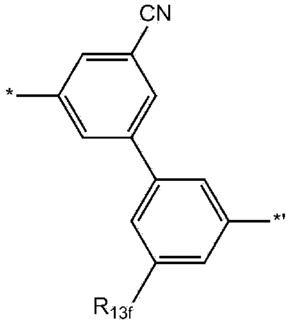
11-29

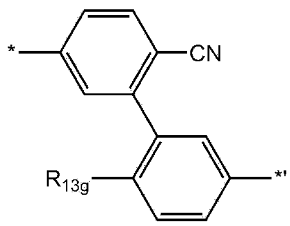
11-30

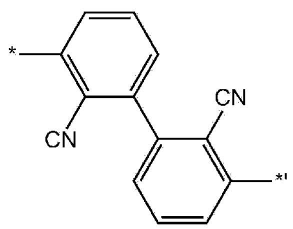
11-31

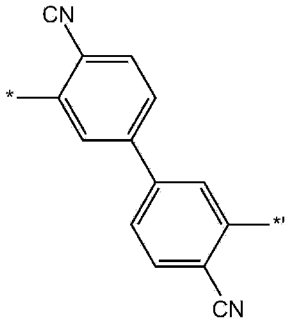
11-32

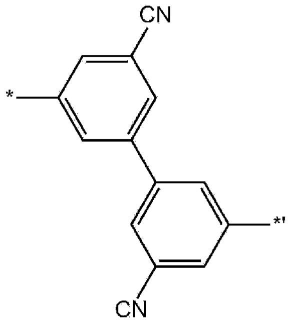
11-33

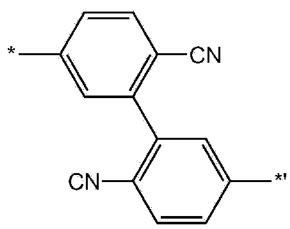
11-34

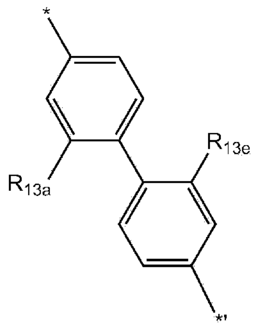
11-35

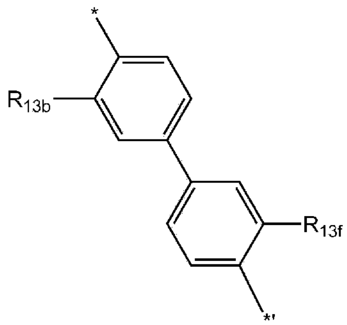
11-36

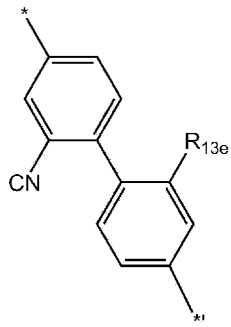
11-37

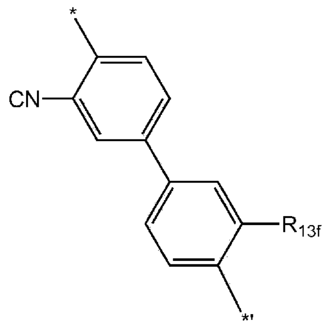
11-38

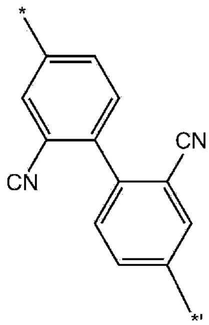
11-39

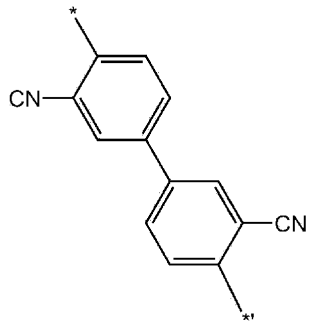
11-40

In Formulae 10-11 to 10-13, 10-21 to 10-23, and 11-11 to 11-40,
$R_{11c}$, $R_{11f}$, $R_{12c}$, $R_{12f}$, and $R_{13a}$ to $R_{13f}$ may each independently be selected from:

hydrogen, deuterium, a $C_1$-$C_{10}$ alkyl group, a $C_1$-$C_{10}$ alkoxy group, a phenyl group, a biphenyl group, a terphenyl

group, a naphthyl group, a fluorenyl group, a pyridinyl group, a pyrazinyl group, a pyrimidinyl group, a carbazolyl group, a dibenzofuranyl group, and a dibenzothiophenyl group;

a $C_1$-$C_{10}$ alkyl group and a $C_1$-$C_{10}$ alkoxy group, each substituted with deuterium; and

a phenyl group, a biphenyl group, a terphenyl group, a naphthyl group, a fluorenyl group, a pyridinyl group, a pyrazinyl group, a pyrimidinyl group, a carbazolyl group, a dibenzofuranyl group, and a dibenzothiophenyl group, each substituted with at least one selected from deuterium, a $C_1$-$C_{10}$ alkyl group, a $C_1$-$C_{10}$ alkoxy group, a phenyl group, a biphenyl group, a terphenyl group, a naphthyl group, a fluorenyl group, a pyridinyl group, a pyrazinyl group, a pyrimidinyl group, a carbazolyl group, a dibenzofuranyl group, and a dibenzothiophenyl group, and

* and *' each indicate a binding site to a neighboring atom.

In one or more embodiments, in Formula 1, $A_{11}$ may be represented by Formula 10-11, $A_{12}$ may be represented by Formula 10-21, and $L_{11}$ may be represented by one selected from Formulae 11-27 to 11-34 and 11-37 to 11-40; $A_{11}$ may be represented by one selected from Formula 10-12 and 10-13, $A_{12}$ may be represented by one selected from Formulae 10-21 to 10-23, and $L_{11}$ may be represented by one selected from Formulae 11-23 to 11-40; or $A_{11}$ may be represented by Formula 10-11, $A_{12}$ may be represented by one selected from Formulae 10-22 and 10-23, and $L_{11}$ may be represented by one selected from Formulae 11-23 to 11-40, but embodiments of the present disclosure are not limited thereto.

In one or more embodiments, in Formula 1, $A_{11}$ may be represented by Formula 10-11, $A_{12}$ may be represented by Formula 10-21, and $L_{11}$ may be represented by one selected from Formulae 11-27 to 11-34 and 11-37 to 11-40; $A_{11}$ may be represented by one selected from Formulae 10-12 and 10-13, $A_{12}$ may be represented by one selected from Formulae 10-21 to 10-23, and $L_{11}$ may be represented by one selected from Formulae 11-23 to 11-40; or $A_{11}$ may be represented by Formula 10-11, $A_{12}$ may be represented by one selected from Formulae 10-22 and 10-23, and $L_{11}$ may be represented by one selected from Formulae 11-23 to 11-40.

In Formulae 10-11 to 10-13, 10-21 to 10-23, and 11-23 to 11-40, $R_{11c}$, $R_{11f}$, $R_{12c}$, $R_{12f}$, and $R_{13a}$ to $R_{13f}$ may each independently be selected from:

hydrogen, deuterium, a methyl group, an ethyl group, an n-propyl group, an isopropyl group, an n-butyl group, an isobutyl group, a sec-butyl group, a tert-butyl group, a phenyl group, a naphthyl group, a pyridinyl group, a pyrazinyl group, and a pyrimidinyl group;

a methyl group, an ethyl group, an n-propyl group, an isopropyl group, an n-butyl group, an isobutyl group, a sec-butyl group, and a tert-butyl group, each substituted with deuterium; and

a phenyl group, a naphthyl group, a pyridinyl group, a pyrazinyl group, and a pyrimidinyl group, each substituted with at least one selected from deuterium, a methyl group, an ethyl group, an n-propyl group, an isopropyl group, an n-butyl group, an isobutyl group, a sec-butyl group, a tert-butyl group, a phenyl group, a naphthyl group, a pyridinyl group, a pyrazinyl group, and a pyrimidinyl group, but embodiments of the present disclosure are not limited thereto.

In detail, the first compound may be selected from Compounds E-1 to E-20, but embodiments of the present disclosure are not limited thereto:

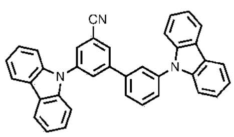

E-1

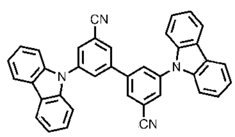

E-2

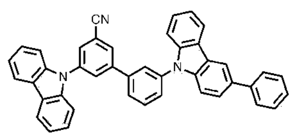

E-3

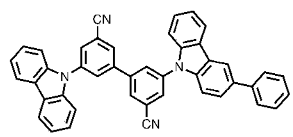

E-4

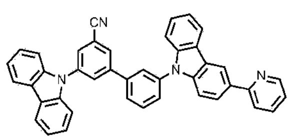

E-5

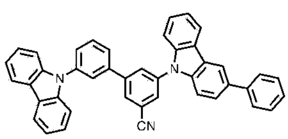

E-6

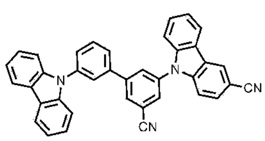

E-7

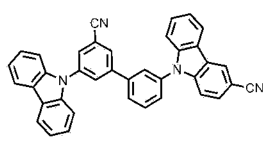

E-8

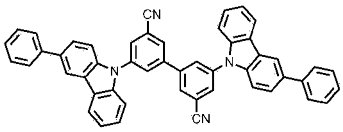
E-9

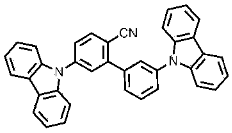
E-10

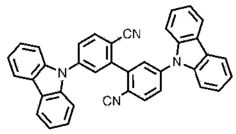
E-11

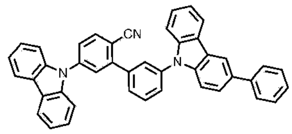
E-12

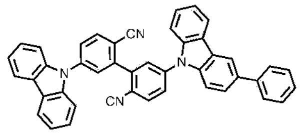
E-13

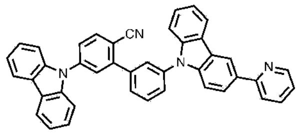
E-14

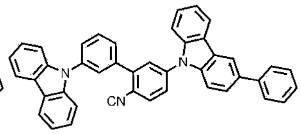
E-15

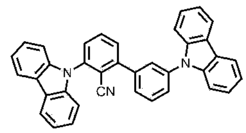
E-16

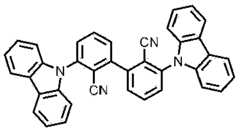
E-17

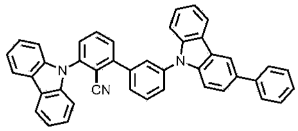
E-18

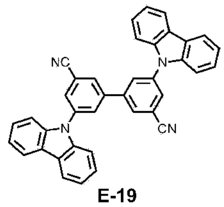
E-19

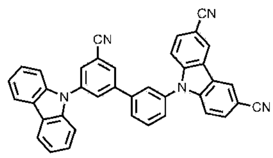
E-20

In Formula 2, $A_{21}$ may be a group represented by one selected from Formulae 20-1 and 20-2;
$A_{22}$ may be selected from groups represented by Formulae 20-1 and 20-2, a phenyl group, a naphthyl group, and a benzimidazolyl group; and
a phenyl group, a naphthyl group, and a benzimidazolyl group, each substituted with at least one selected from deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, and a dibenzothiophenyl group:

<Formula 20-1>

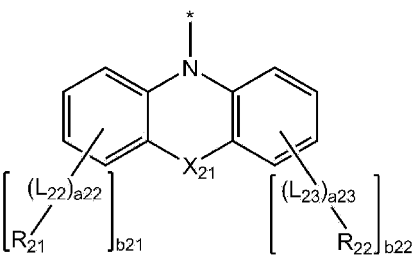

<Formula 20-2>

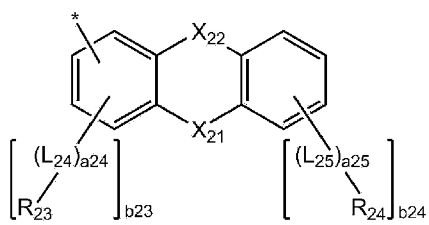

In Formulae 20-1 and 20-2, $X_{21}$ may be selected from a single bond, $C[(L_{27})_{a27}-R_{26}][(L_{28})_{a28}-R_{27}]$, O, and S; $X_{22}$ may be selected from $N[(L_{26})_{a26}-R_{25}]$, $C[(L_{29})_{a29}-R_{28}][(L_{30})_{a30}-R_{29}]$, O, and S; $L_{22}$ to $L_{30}$, a22 to a30, $R_{21}$ to $R_{29}$, and b21 to b24 may each independently be the same as defined above; and * indicates a binding site to a neighboring atom.
For example, in Formulae 20-1 and 20-2, $X_{21}$ may be a single bond; and $X_{22}$ may be selected from $N(R_{25})$, $C(R_{28})(R_{29})$, O, and S, but embodiments of the present disclosure are not limited thereto.
In Formulae 2, 20-1, and 20-2, $L_{22}$ to $L_{30}$ may each independently be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group.
For example, in Formulae 2, 20-1, and 20-2, $L_{21}$ to $L_{30}$ may each independently be selected from:

a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a divalent non-aromatic condensed polycyclic group, and a divalent non-aromatic condensed heteropolycyclic group; and

a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a divalent non-aromatic condensed polycyclic group, and a divalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a biphenyl group, a terphenyl group, a $C_1$-$C_{60}$ heteroaryl group, a monovalent non-aromatic condensed polycyclic group, a monovalent non-aromatic condensed heteropolycyclic group, and -Si($Q_{31}$)($Q_{32}$)($Q_{33}$), and

$Q_{31}$ to $Q_{33}$ may each independently be selected from hydrogen, a $C_1$-$C_{10}$ alkyl group, a $C_6$-$C_{30}$ aryl group, a biphenyl group, a terphenyl group, a $C_1$-$C_{30}$ heteroaryl group, a monovalent non-aromatic condensed polycyclic group, and a monovalent non-aromatic condensed heteropolycyclic group, but embodiments of the present disclosure are not limited thereto.

In one embodiment, in Formulae 2, 20-1, and 20-2, $L_{21}$ to $L_{30}$ may each independently be selected from:

a phenylene group, a naphthylene group, a pyridinylene group, a pyrazinylene group, a pyrimidinylene group, a quinolinylene group, an isoquinolinylene group, a fluorenylene group, a carbazolylene group, a dibenzofuranylene group, and a dibenzothiophenylene group; and

a phenylene group, a naphthylene group, a pyridinylene group, a pyrazinylene group, a pyrimidinylene group, a quinolinylene group, an isoquinolinylene group, a fluorenylene group, a carbazolylene group, a dibenzofuranylene group, and a dibenzothiophenylene group, each substituted with at least one selected from deuterium, -F, -Cl, -Br, -I, a cyano group, a $C_1$-$C_{10}$ alkyl group, a $C_1$-$C_{10}$ alkoxy group, a phenyl group, a biphenyl group, a terphenyl group, a naphthyl group, a fluorenyl group, a pyridinyl group, a pyrazinyl group, a pyrimidinyl group, a quinolinyl group, an isoquinolinyl group, a carbazolyl group, a dibenzofuranyl group, and a dibenzothiophenyl group, but embodiments of the present disclosure are not limited thereto.

In Formula 2, a21 indicates the number of repeated $L_{21}$(s), and may be selected from 0, 1, 2, 3, 4, and 5, wherein, when a21 is 0, $(L_{21})_{a21}$ may be a single bond, and when a21 is two or more, a plurality of $L_{21}$(s) may be identical to or different from each other.

Similarly, in Formulae 20-1 and 20-2, a22 to a30 may each independently be selected from 0, 1, 2, 3, 4, and 5.

For example, in Formulae 2, 20-1, and 20-2, a21 to a30 may each independently be selected from 0, 1 and 2, but embodiments of the present disclosure are not limited thereto.

In Formulae 2, 20-1, and 20-2, $R_{21}$ to $R_{29}$ may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -N($Q_1$)($Q_2$), and-B($Q_1$)($Q_2$),

two or more selected from $R_{21}$ to $R_{29}$ are optionally linked to form a ring, and

$Q_1$ to $Q_3$ may each independently be selected from hydrogen, deuterium, -F,-Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, a monovalent non-aromatic condensed heteropolycyclic group, a biphenyl group, and a terphenyl group.

For example, in Formulae 2, 20-1, and 20-2, $R_{21}$ to $R_{29}$ may each independently be selected from:

hydrogen, deuterium, -F, -Cl, -Br, -I, a cyano group, a $C_1$-$C_{10}$ alkyl group, a $C_1$-$C_{10}$ alkoxy group, a $C_3$-$C_{10}$ cycloalkyl group, and a $C_1$-$C_{10}$ heterocycloalkyl group;

a $C_1$-$C_{10}$ alkyl group, a $C_1$-$C_{10}$ alkoxy group, a $C_3$-$C_{10}$ cycloalkyl group, and a $C_1$-$C_{10}$ heterocycloalkyl group, each substituted with at least one selected from deuterium, -F, -Cl, -Br, -I, and a cyano group;

a $C_6$-$C_{30}$ aryl group, a biphenyl group, a terphenyl group, a $C_6$-$C_{30}$ aryloxy group, a $C_6$-$C_{30}$ arylthio group, a $C_1$-$C_{30}$ heteroaryl group, a monovalent non-aromatic condensed polycyclic group, and a monovalent non-aromatic condensed heteropolycyclic group;

a $C_6$-$C_{30}$ aryl group, a biphenyl group, a terphenyl group, a $C_6$-$C_{30}$ aryloxy group, a $C_6$-$C_{30}$ arylthio group, a $C_1$-$C_{30}$ heteroaryl group, a monovalent non-aromatic condensed polycyclic group, and a monovalent non-aromatic condensed heteropolycyclic group, each substituted with at least one selected from deuterium,-F, -Cl, -Br, -I, a cyano group, a $C_1$-$C_{10}$ alkyl group, a $C_1$-$C_{10}$ alkoxy group, a $C_3$-$C_{10}$ cycloalkyl group, a $C_1$-$C_{10}$ heterocycloalkyl group, a $C_6$-$C_{30}$ aryl group, a biphenyl group, a terphenyl group, a $C_6$-$C_{30}$ aryloxy group, a $C_6$-$C_{30}$ arylthio group, a $C_1$-$C_{30}$ heteroaryl group, a monovalent non-aromatic condensed polycyclic group, and a monovalent non-aromatic condensed heteropolycyclic group; and

$-Si(Q_1)(Q_2)(Q_3)$, $-N(Q_1)(Q_2)$, and $-B(Q_1)(Q_2)$,

two or more selected from $R_{21}$ to $R_{29}$ are optionally linked to form a ring; and

$Q_1$ to $Q_3$ may each independently be selected from hydrogen, a $C_1$-$C_{10}$ alkyl group, a $C_6$-$C_{30}$ aryl group, a biphenyl group, a terphenyl group, a $C_1$-$C_{30}$ heteroaryl group, a monovalent non-aromatic condensed polycyclic group, and a monovalent non-aromatic condensed heteropolycyclic group, but embodiments of the present disclosure are not limited thereto.

In one embodiment, in Formulae 2, 20-1, and 20-2, $R_{21}$ to $R_{29}$ may each independently be selected from:

hydrogen, deuterium, -F, -Cl, -Br, -I, a cyano group, a methyl group, an ethyl group, an n-propyl group, an isopropyl group, an n-butyl group, an isobutyl group, a sec-butyl group, a tert-butyl group, a methoxy group, an ethoxy group, an n-propoxy group, an isopropoxy group, an n-butoxy group, an isobutoxy group, a sec-butoxy group, a tert-butoxy group, a cyclopentyl group, and a cyclohexyl group;

a methyl group, an ethyl group, an n-propyl group, an isopropyl group, an n-butyl group, an isobutyl group, a sec-butyl group, a tert-butyl group, a methoxy group, an ethoxy group, an n-propoxy group, an isopropoxy group, an n-butoxy group, an isobutoxy group, a sec-butoxy group, a tert-butoxy group, a cyclopentyl group, and a cyclohexyl group, each substituted with at least one selected from deuterium, -F, -Cl, -Br, -I and a cyano group;

a phenyl group, a biphenyl group, a terphenyl group, a naphthyl group, a fluorenyl group, a pyridinyl group, a pyrazinyl group, a pyrimidinyl group, a quinolinyl group, an isoquinolinyl group, a carbazolyl group, a dibenzofuranyl group, and a dibenzothiophenyl group;

a phenyl group, a biphenyl group, a terphenyl group, a naphthyl group, a fluorenyl group, a pyridinyl group, a pyrazinyl group, a pyrimidinyl group, a quinolinyl group, an isoquinolinyl group, a carbazolyl group, a dibenzofuranyl group, and a dibenzothiophenyl group, each substituted with at least one selected from deuterium, -F, -Cl, -Br, -I, a cyano group, a methyl group, an ethyl group, an n-propyl group, an isopropyl group, an n-butyl group, an isobutyl group, a sec-butyl group, a tert-butyl group, a methoxy group, an ethoxy group, an n-propoxy group, an isopropoxy group, an n-butoxy group, an isobutoxy group, a sec-butoxy group, a tert-butoxy group, a cyclopentyl group, a cyclohexyl group, a phenyl group, a biphenyl group, a terphenyl group, a naphthyl group, a fluorenyl group, a pyridinyl group, a pyrazinyl group, a pyrimidinyl group, a quinolinyl group, an isoquinolinyl group, a carbazolyl group, a dibenzofuranyl group, and a dibenzothiophenyl group; and

$-Si(Q_1)(Q_2)(Q_3)$, $-N(Q_1)(Q_2)$, and $-B(Q_1)(Q_2)$,

two or more selected from $R_{21}$ to $R_{29}$ are optionally linked to form a ring; and

$Q_1$ to $Q_3$ may each independently be selected from hydrogen, a methyl group, an ethyl group, an n-propyl group, an isopropyl group, an n-butyl group, an isobutyl group, a sec-butyl group, a tert-butyl group, a phenyl group, a biphenyl group, a terphenyl group, a naphthyl group, a fluorenyl group, a pyridinyl group, a pyrazinyl group, a pyrimidinyl group, a quinolinyl group, an isoquinolinyl group, a carbazolyl group, a dibenzofuranyl group, and a dibenzothiophenyl group, but embodiments of the present disclosure are not limited thereto.

In Formula 20-1, b21 indicates the number of $(L_{22})_{a22}$-$R_{21}$(s), and may be selected from 1, 2, 3, and 4, wherein, when b21 is two or more, a plurality of $(L_{22})_{a22}$-$R_{21}$(s) may be identical to or different from each other.

Similarly, b22 and b24 may each independently be selected from 1, 2, 3, and 4.

Similarly, b23 may be selected from 1, 2, and 3.

In one embodiment, in Formula 2,

$A_{21}$ and $A_{22}$ may each independently be represented by Formula 20-1;

$A_{21}$ may be represented by Formula 20-1, and $A_{22}$ may be represented by Formula 20-2; or

$A_{21}$ and $A_{22}$ may each independently be represented by Formula 20-2, but embodiments of the present disclosure are not limited thereto.

In one or more embodiments, the group represented by Formula 20-2 may be a group represented by one selected from Formulae 20-21 to 20-24, but embodiments of the present disclosure are not limited thereto:

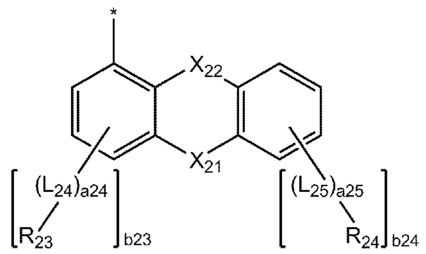

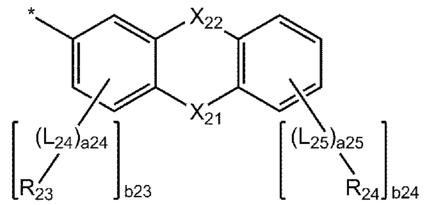

20-21

20-22

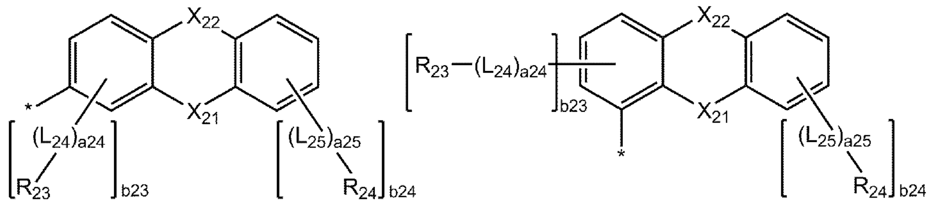

20-23

20-24

,

In Formulae 20-21 to 20-24, $X_{21}$, $X_{22}$, $L_{24}$, $L_{25}$, a24, a25, $R_{23}$, $R_{24}$, b23 and b24 may each independently be the same as described in connection with Formula 20-2,
* indicates a binding site to a neighboring atom.

In one or more embodiments, the second compound may be represented by one selected from Formulae 2-1 to 2-3, but embodiments of the present disclosure are not limited thereto:

<Formula 2-1>

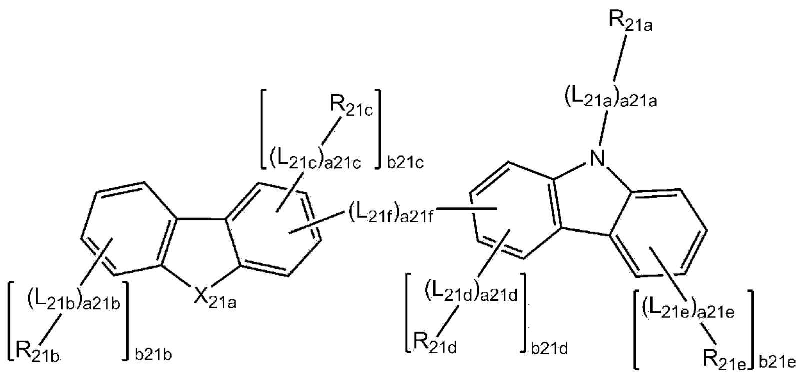

<Formula 2-2>

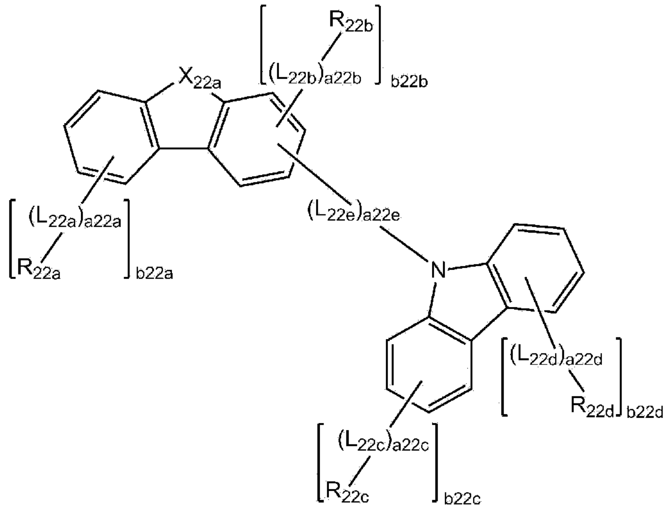

<Formula 2-3>

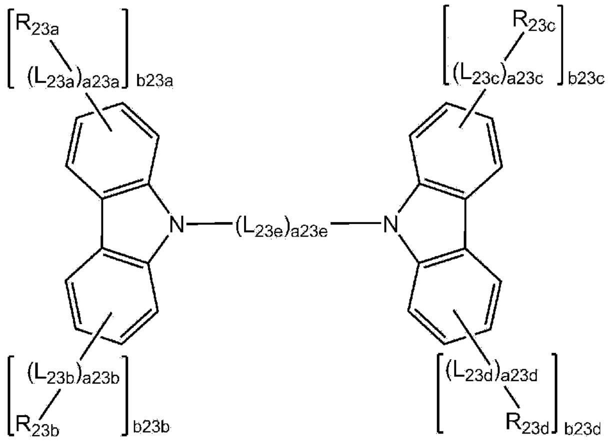

In Formulae 2-1 to 2-3,
$X_{21a}$ may be selected from $N[(L_{21g})_{a21g}-R_{21f}]$, O, and S, and $X_{22a}$ may be selected from $N[(L_{22r})_{a22f}-R_{22e}]$, O, and S,
$L_{21a}$ to $L_{21g}$, $L_{22a}$ to $L_{22f}$, and $L_{23a}$ to $L_{23e}$ may each independently be defined the same as $L_{21}$ in Formula 2,
a21a to a21g, a22a to a22f, and a23a to a23e may each independently be defined the same as a21 in Formula 2,
$R_{21a}$ to $R_{21f}$, $R_{22a}$ to $R_{22e}$, and $R_{23a}$ to $R_{23d}$ may each independently be defined the same as $R_{21}$ in Formula 2,
b21b, b21e, b22a, b22c, b22d, and b23a to b23d may each independently be defined the same as b21 in Formula 2, and
b21c, b21d and b22b may each independently be defined the same as b23 in Formula 2.

For example, in Formula 2-3, $(L_{23e})_{a23e}$ may be selected from groups represented by Formulae 9-1 to 9-6, but embodiments of the present disclosure are not limited thereto:

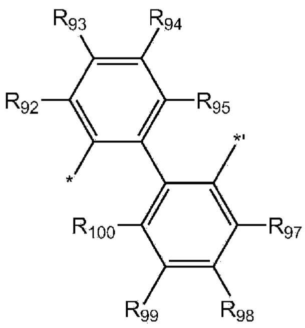

9-1

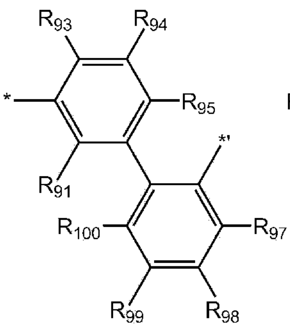

9-2

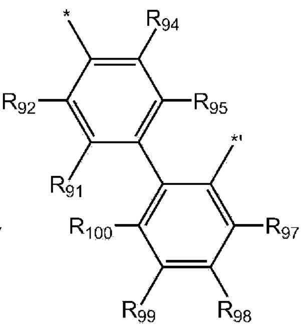

9-3

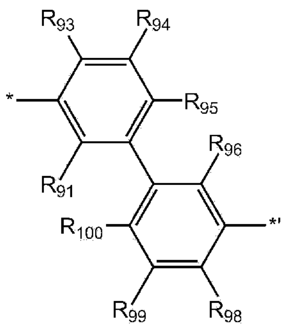

9-4

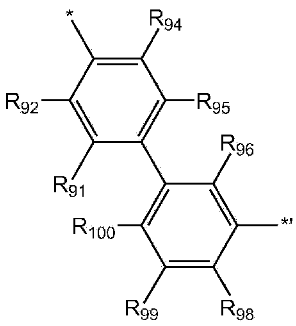

9-5

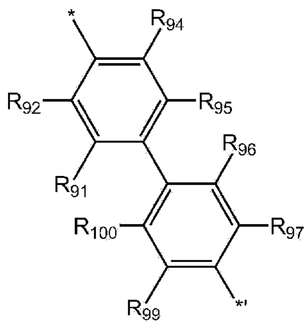

9-6

In Formulae 9-1 to 9-6,

$R_{91}$ to $R_{100}$ may each independently be selected from hydrogen, deuterium,-F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a biphenyl group, a terphenyl group, a $C_1$-$C_{60}$ heteroaryl group, a monovalent non-aromatic condensed polycyclic group, a monovalent non-aromatic condensed heteropolycyclic group. and -Si($Q_{31}$)($Q_{32}$)($Q_{33}$), and

$Q_{31}$ to $Q_{33}$ may each independently be selected from hydrogen, a $C_1$-$C_{10}$ alkyl group, a $C_6$-$C_{30}$ aryl group, a biphenyl group, a terphenyl group, a $C_1$-$C_{30}$ heteroaryl group, a monovalent non-aromatic condensed polycyclic group, and a monovalent non-aromatic condensed heteropolycyclic group.

For example, in Formulae 9-1 to 9-6,

$R_{91}$ to $R_{100}$ may each independently be selected from hydrogen, deuterium,-F, -Cl, -Br, -I, a cyano group, a $C_1$-$C_{10}$ alkyl group, a $C_1$-$C_{10}$ alkoxy group, a phenyl group, a biphenyl group, a terphenyl group, a naphthyl group, a fluorenyl group, a pyridinyl group, a pyrazinyl group, a pyrimidinyl group, a quinolinyl group, an isoquinolinyl group, a carbazolyl group, a dibenzofuranyl group, and a dibenzothiophenyl group, but embodiments of the present disclosure are not limited thereto.

In one or more embodiments, the second compound may be represented by one selected from Formulae 2-11, 2-21, and 2-31 to 2-33, but embodiments of the present disclosure are not limited thereto:

<Formula 2-11>

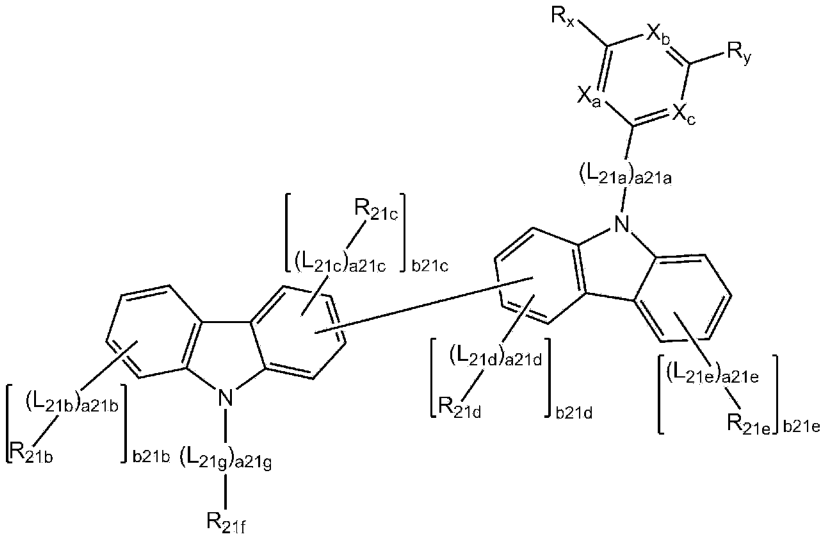

<Formula 2-21>

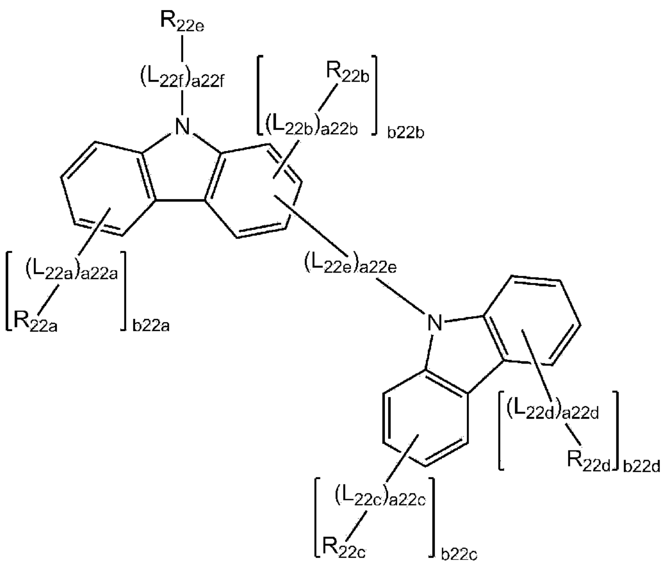

<Formula 2-31>

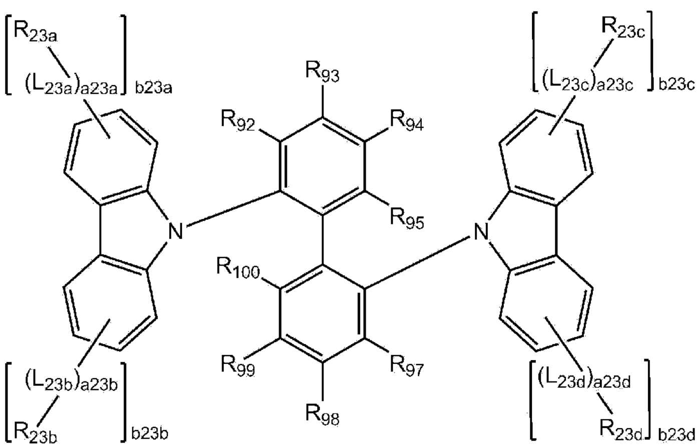

<Formula 2-32>

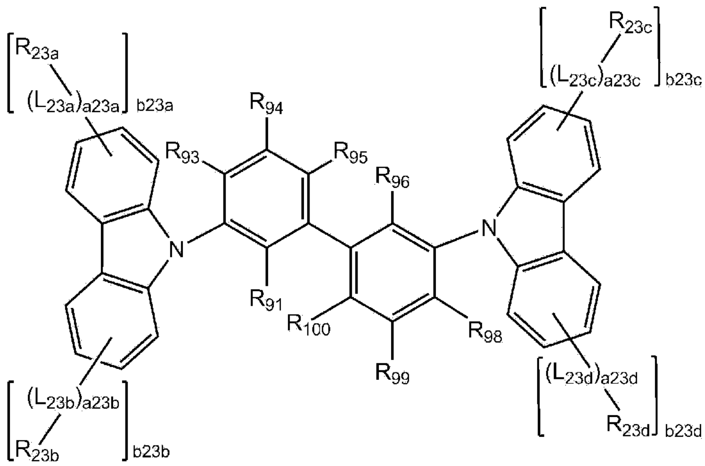

<Formula 2-33>

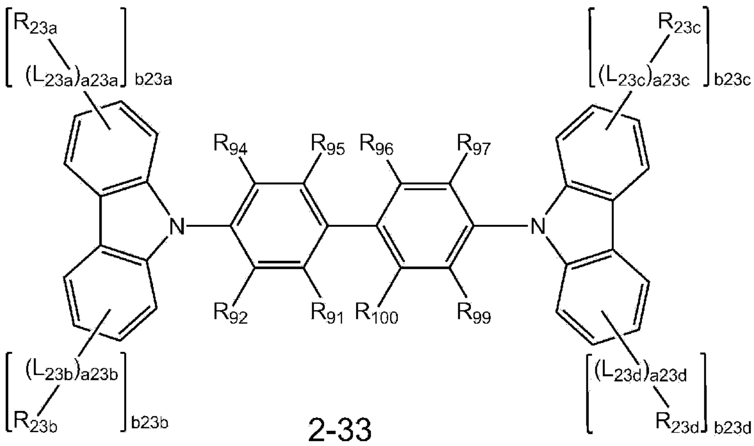

2-33

.

In Formulae 2-11, 2-21, and 2-31 to 2-33,

$X_a$, $X_b$, and $X_c$ may each independently be selected from C and $N(R_z)$,

$X_a$, $X_b$, and $X_c$ may not be simultaneously $N(R_z)$,

$L_{21a}$ to $L_{21e}$, $L_{21g}$, $L_{22a}$ to $L_{22f}$, and $L_{23a}$ to $L_{23d}$ may each independently be the same as described in connection with $L_{21}$ in Formula 2,

a21a to a21e, a21g, a22a to a22f, and a23a to a23d may each independently be the same as described in connection with a21 in Formula 2,

$R_{21b}$ to $R_{21f}$, $R_{22a}$ to $R_{22e}$, and $R_{23a}$ to $R_{23d}$ may each independently be the same as described in connection with $R_{21}$ in Formula 2,

b21b, b21e, b22a, b22c, b22d, and b23a to b23d may each independently be the same as described in connection with b21 in Formula 2,

b21e, b21d, and b22b may each independently be the same as described in connection with b23 in Formula 2, and

$R_{91}$ to $R_{100}$, $R_x$, $R_y$, and $R_z$ may each independently be selected from hydrogen, deuterium, -F, -Cl, -Br, -I, a cyano group, a methyl group, an ethyl group, an n-propyl group, an isopropyl group, an n-butyl group, an isobutyl group, a sec-butyl group, a tert-butyl group, a phenyl group, a biphenyl group, a terphenyl group, a naphthyl group, a fluorenyl group, a pyridinyl group, a pyrazinyl group, a pyrimidinyl group, a quinolinyl group, an isoquinolinyl group, a carbazolyl group, a dibenzofuranyl group, and a dibenzothiophenyl group.

In one embodiment, the second compound may be selected from Compounds H-1 to H-19, but embodiments of the present disclosure are not limited thereto:

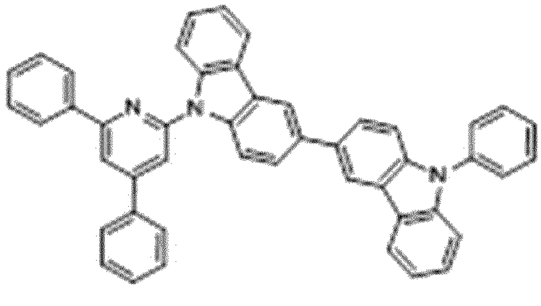

H-1

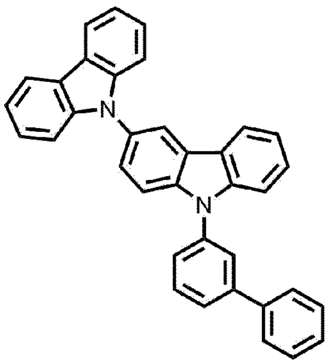

H-2

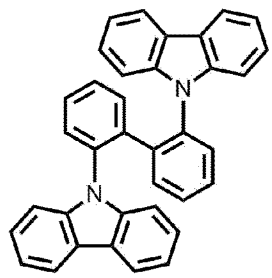

H-3

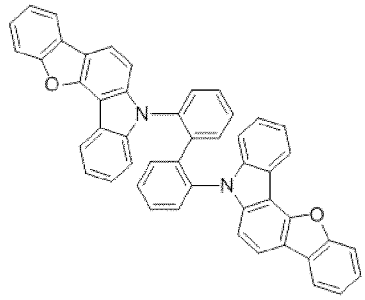

H-4

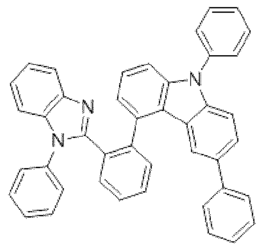

H-5

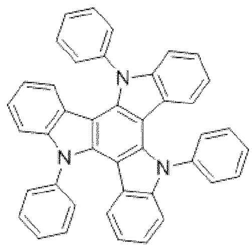

H-6

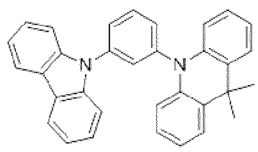

H-7

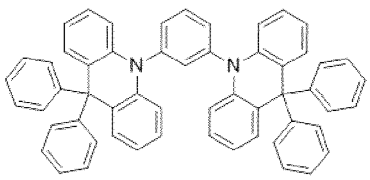

H-8

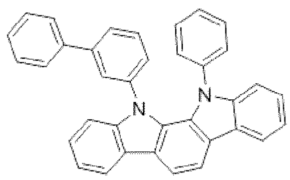

H-9

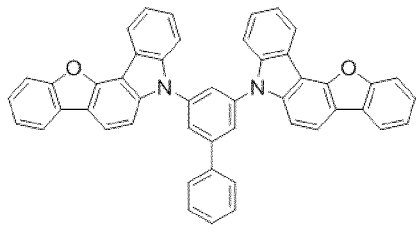

H-10

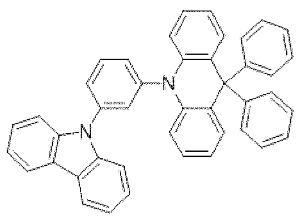

H-11

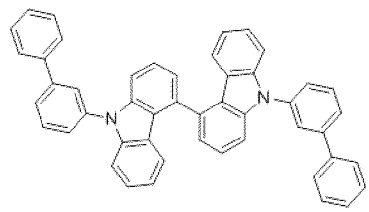

H-12

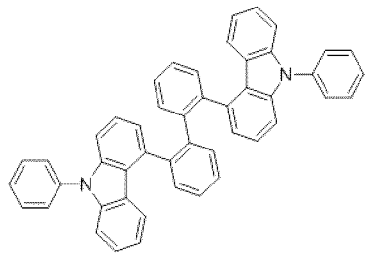

H-13

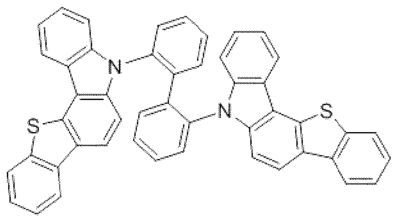

H-14

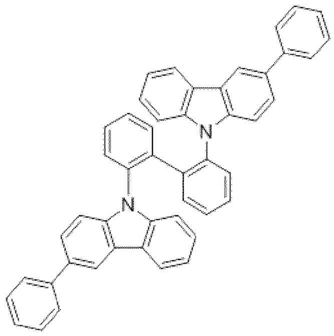

H-15

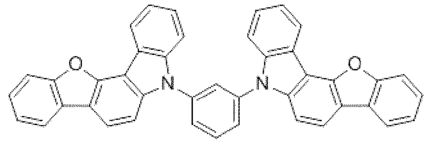

H-16

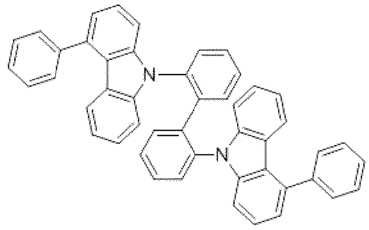

H-17

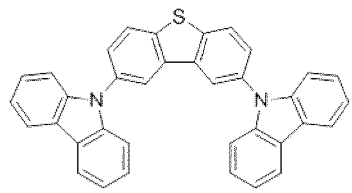

H-18

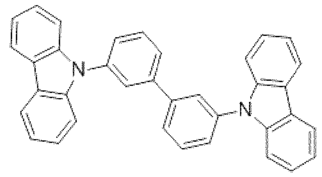

H-19

For example, the third compound may emit delayed fluorescence.
In one embodiment, the third compound may be represented by one selected from Formulae 3 and 4, but embodiments of the present disclosure are not limited thereto:

<Formula 3>

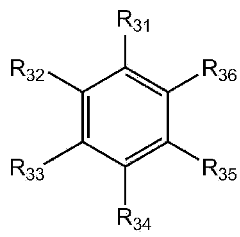

<Formula 12-1>

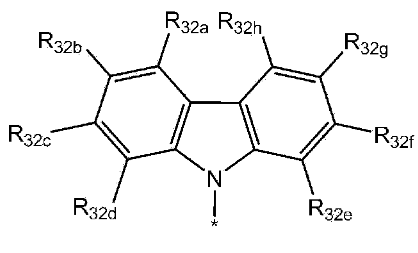

<Formula 12-2>

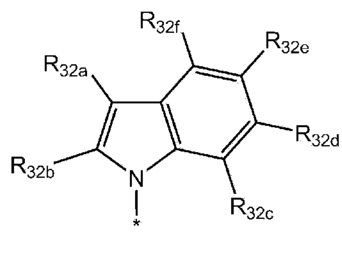

<Formula 4>

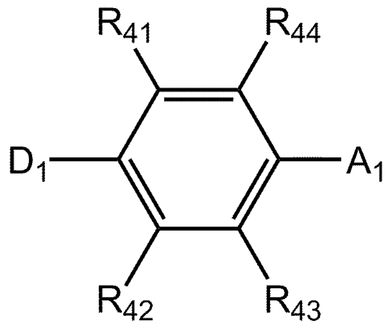

<Formula 13-1>

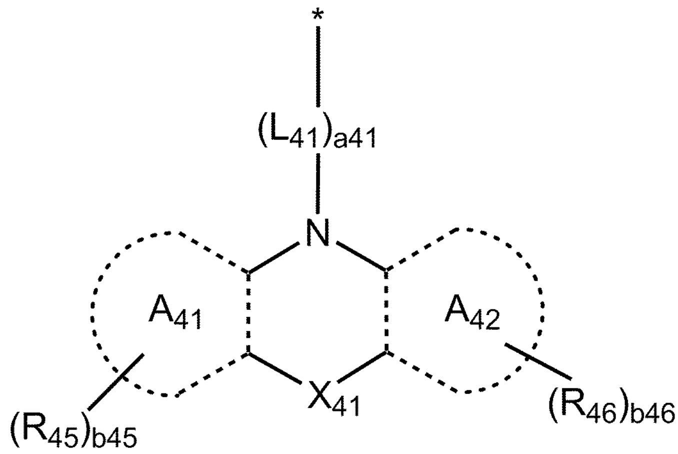

<Formula 14-1>

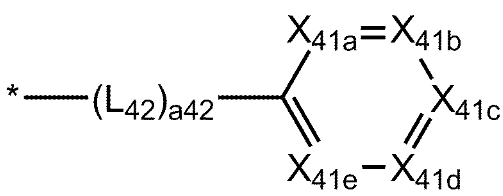

,

wherein, in Formulae 3, 4, 12-1, 12-2, 13-1, and 14-1,

$R_{31}$ to $R_{36}$ may each independently be selected from a group represented by Formula 12-1, a group represented by Formula 12-2, hydrogen, deuterium, -F, -Cl,-Br, -I, a hydroxyl group, a cyano group, a substituted or unsubstituted $C_1$-$C_{60}$ alkyl group, a substituted or unsubstituted $C_1$-$C_{60}$ alkoxy group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, and a substituted or unsubstituted $C_1$-$C_{60}$ heteroaryl group,
at least one selected from $R_{31}$ to $R_{36}$ may be a cyano group,
at least one selected from $R_{31}$ to $R_{36}$ may be selected from a group represented by Formula 12-1 and a group represented by Formula 12-2,
$D_1$ may be a group represented by Formula 13-1,
$A_1$ may be a group represented by Formula 14-1,
$X_{41}$ may be selected from a single bond, O, S, $N(R_{47})$, and $C(R_{47})(R_{48})$,
$A_{41}$ and $A_{42}$ may each independently be selected from a benzene group, a fluorene group, a carbazole group, a dibenzofuran group, a dibenzothiophene group, an indolofluorene group, an indolocarbazole group, an indolodibenzofuran group, an indolodibenzothiophene group, an indenofluorene group, an indenocarbazole group, an indenodibenzofuran group, an indenodibenzothiophene group, a benzofuranofluorene group, a benzofuranocarbazole group, a benzofuranodibenzofuran group, a benzofuranodibenzothiophene group, a benzothienofluorene group, a benzothienocarbazole group, a benzothienodibenzofuran group, and a benzothienodibenzothiophene group,

$L_{41}$ and $L_{42}$ may each independently be selected from a substituted or unsubstituted $C_5$-$C_{30}$ carbocyclic group and a substituted or unsubstituted $C_1$-$C_{30}$ heterocyclic group,

a41 and a42 may each independently be selected from 0, 1, 2, and 3,

$X_{41a}$ may be N or C($R_{41a}$); $X_{41b}$ may be N or C($R_{41b}$); $X_{41c}$ may be N or C($R_{41c}$); $X_{41d}$ may be N or C($R_{41d}$); and $X_{41e}$ may be N or C($R_{41e}$), wherein at least one selected from $X_{41a}$ to $X_{41e}$ is N,

$R_{32a}$ to $R_{32h}$, $R_{41}$ to $R_{48}$, and $R_{41a}$ to $R_{41e}$ may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -N($Q_4$)($Q_5$), and-B($Q_6$)($Q_7$),

b45 and b46 may each independently be selected from 1, 2, 3, 4, 5, 6, 7, and 8,

$Q_1$ to $Q_7$ may each independently be selected from hydrogen, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group, and

* indicates a binding site to a neighboring atom.

For example, in Formula 3, one, two, or three selected from $R_{31}$ to $R_{36}$ may be a cyano group,
one, two, three, four, or five selected from $R_{31}$ to $R_{36}$ may be selected from a group represented by Formula 12-1 and a group represented by Formula 12-2, but embodiments of the present disclosure are not limited thereto.

In one embodiment, in Formula 3, one or two selected from $R_{31}$ to $R_{36}$ may be a cyano group,
one, two, three, four, or five selected from $R_{31}$ to $R_{36}$ may be selected from a group represented by Formula 12-1 and a group represented by Formula 12-2, but embodiments of the present disclosure are not limited thereto.

In one embodiment, in Formula 3, one selected from $R_{31}$ to $R_{36}$ may be a cyano group, and three, four, or five selected from $R_{31}$ to $R_{36}$ may be selected from a group represented by Formula 12-1 and a group represented by Formula 12-2; or
two selected from $R_{31}$ to $R_{36}$ may be a cyano group, and three or four selected from $R_{31}$ to $R_{36}$ may be selected from a group represented by Formula 12-1 and a group represented by Formula 12-2, but embodiments of the present disclosure are not limited thereto.

For example, in Formula 3, $R_{31}$ to $R_{36}$ may each independently be selected from a group represented by Formula 12-1, a group represented by Formula 12-2, hydrogen, deuterium, -F, -Cl, -Br, -I, a hydroxyl group, a cyano group, a $C_1$-$C_{10}$ alkyl group, and a $C_1$-$C_{10}$ alkoxy group, but embodiments of the present disclosure are not limited thereto.

In one embodiment, in Formula 3, $R_{31}$ to $R_{36}$ may each independently be selected from a group represented by Formula 12-1, a group represented by Formula 12-2, hydrogen, deuterium, -F, -Cl, -Br, -I, a hydroxyl group, a cyano group, a methyl group, an ethyl group, an n-propyl group, an isopropyl group, an n-butyl group, an isobutyl group, a sec-butyl group, a tert-butyl group, a methoxy group, an ethoxy group, an n-propoxy group, an isopropoxy group, an n-butoxy group, an isobutoxy group, a sec-butoxy group, and a tert-butoxy group, but embodiments of the present disclosure are not limited thereto.

For example, in Formulae 12-1 and 12-2, $R_{32a}$ to $R_{32h}$ may each independently be selected from hydrogen, deuterium, -F, -Cl, -Br, -I, a hydroxyl group, a cyano group, a methyl group, an ethyl group, an n-propyl group, an isopropyl group, an n-butyl group, an isobutyl group, a sec-butyl group, a tert-butyl group, a methoxy group, an ethoxy group, an n-propoxy group, an isopropoxy group, an n-butoxy group, an isobutoxy group, a sec-butoxy group, a tert-butoxy group, a phenyl group, a biphenyl group, a terphenyl group, a naphthyl group, a pyridinyl group, a pyrazinyl group, and a pyrimidinyl group, but embodiments of the present disclosure are not limited thereto.

In one embodiment, in Formula 13-1, $A_{41}$ may be a benzene group, and $A_{42}$ may be selected from a benzene group, a fluorene group, a carbazole group, a dibenzofuran group, a dibenzothiophene group, an indolofluorene group, an indolocarbazole group, an indolodibenzofuran group, an indolodibenzothiophene group, an indenofluorene group, an indenocarbazole group, an indenodibenzofuran group, an indenodibenzothiophene group, a benzofuranofluorene group, a benzofuranocarbazole group, a benzofuranodibenzofuran group, a benzofuranodibenzothiophene group, a

benzothienofluorene group, a benzothienocarbazole group, a benzothienodibenzofuran group, and a benzothienodibenzothiophene group, but embodiments of the present disclosure are not limited thereto.

In one embodiment, in Formula 13-1, $X_{41}$ may be selected from a single bond, and $C(R_{47})(R_{48})$, but embodiments of the present disclosure are not limited thereto.

In one or more embodiments, the third compound may be represented by one selected from Formulae 3-1 to 3-5, but embodiments of the present disclosure are not limited thereto:

<Formula 3-1>

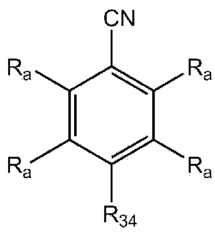

<Formula 3-2>

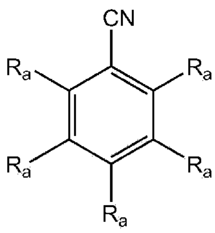

<Formula 3-3>

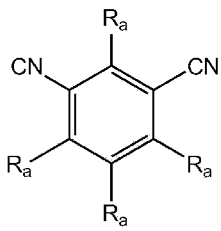

<Formula 3-4>

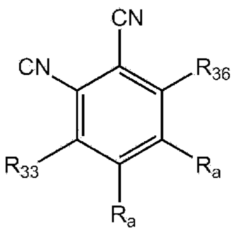

<Formula 3-5>

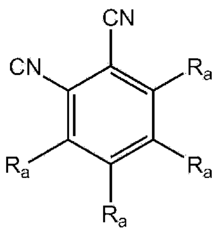

<Formula 12-11>

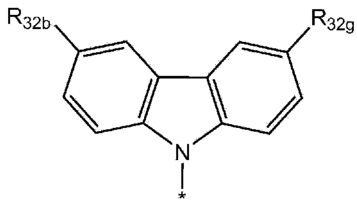

.

In Formulae 3-1 to 3-5, 12-1, and 12-2,
$R_a$ may be a group represented by Formula 12-11,
$R_{33}$, $R_{34}$, and $R_{36}$ may each independently be selected from hydrogen, deuterium, -F, -Cl, -Br, -I, a hydroxyl group, a $C_1$-$C_{10}$ alkyl group, and a $C_1$-$C_{10}$ alkoxy group,
$R_{32b}$ and $R_{32g}$ may each independently be selected from hydrogen, deuterium, -F, -Cl, -Br, -I, a hydroxyl group, a $C_1$-$C_{10}$ alkyl group, a $C_1$-$C_{10}$ alkoxy group, a $C_6$-$C_{30}$ aryl group, and a $C_1$-$C_{30}$ heteroaryl group, and
* indicates a binding site to a neighboring atom.

In one or more embodiments, the third compound may be selected from Compounds D-1 to D-23, but embodiments of the present disclosure are not limited thereto:

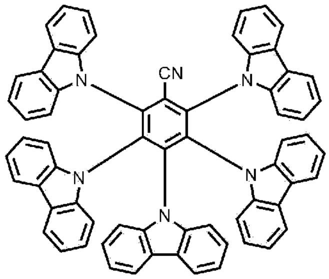

**D-1**

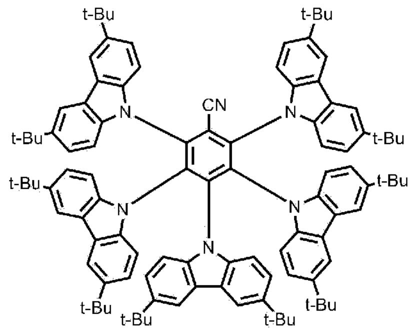

**D-2**

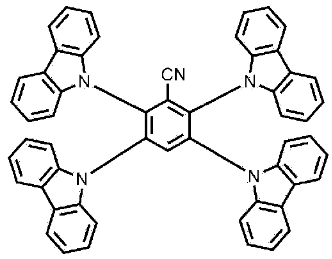

**D-3**

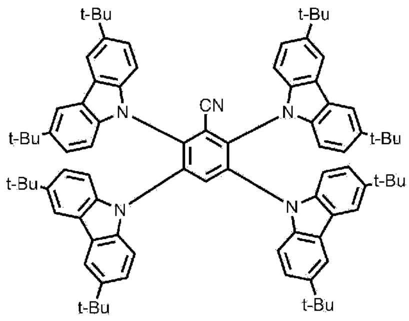

**D-4**

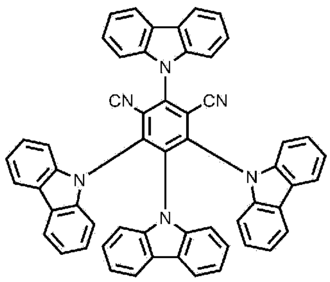

**D-5**

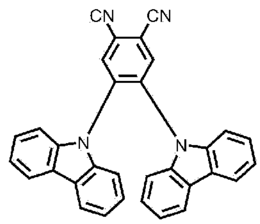

**D-6**

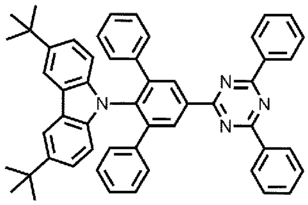

**D-7**

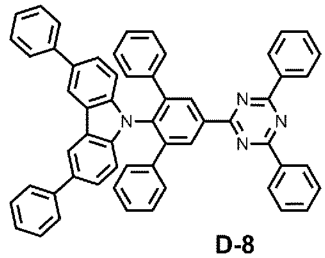

**D-8**

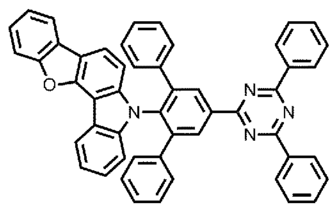

**D-9**

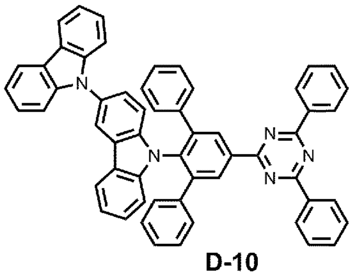

**D-10**

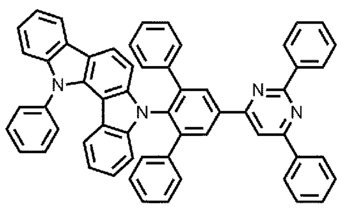

**D-11**

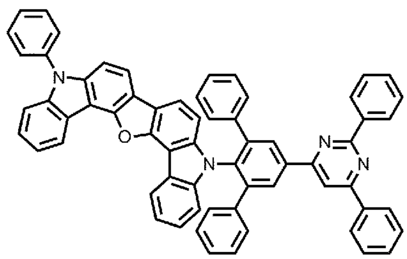

**D-12**

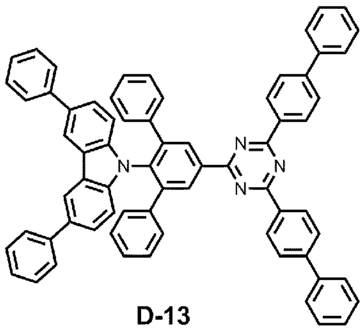

D-13

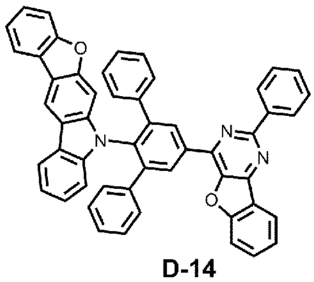

D-14

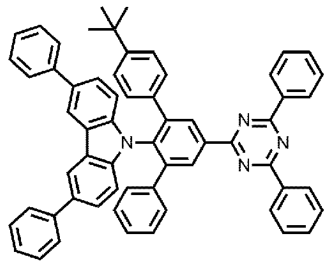

D-15

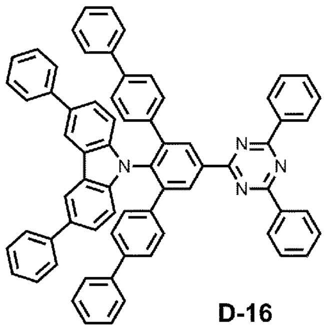

D-16

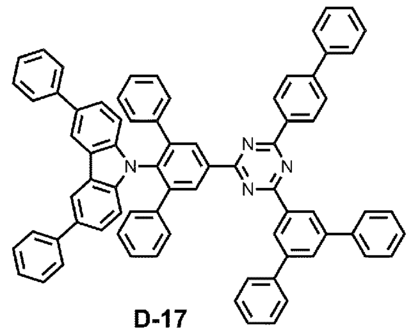

D-17

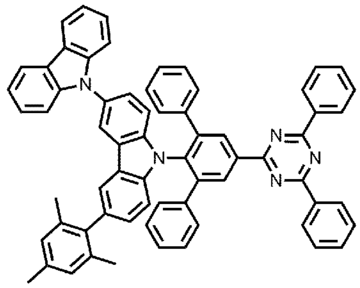

D-18

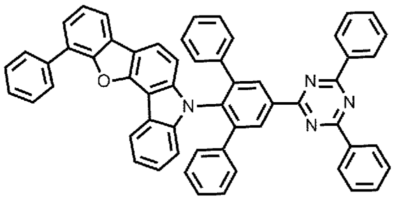

D-19

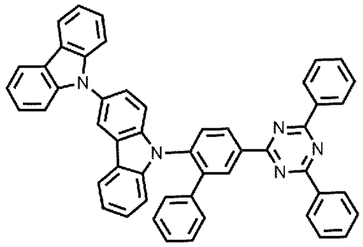

D-20

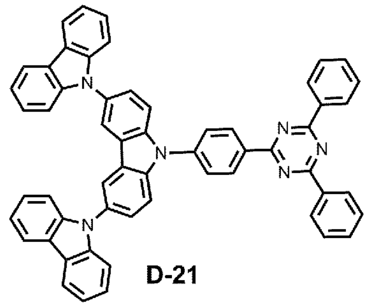

D-21

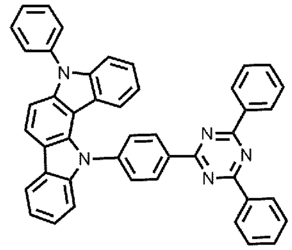

D-22

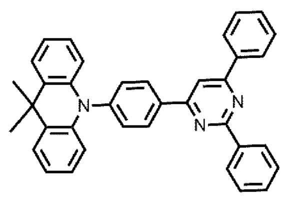

D-23

In one embodiment, the first compound and the second compound may be different from each other, but embodiments of the present disclosure are not limited thereto.

In one embodiment, the second compound may satisfy Condition 2, but embodiments of the present disclosure are not limited thereto:

<Condition 2>

$$E_{HOMO}\ (C2) > -5.45\ eV.$$

In Condition 2,

$E_{HOMO}$ (C2) is a highest occupied molecular orbital (HOMO) energy level of the second compound.

$E_{HOMO}$ (C2) is evaluated by using a DFT method of Gaussian program structurally optimized at a level of B3LYP/6-31G(d,p).

In one embodiment, the third compound may satisfy Condition 3:

<Condition 3>

$$E_{LUMO}\ (C3) < -1.70\ eV.$$

In Condition 3,

$E_{LUMO}$ (C3) is a lowest unoccupied molecular orbital (LUMO) energy level of the third compound.

$E_{LUMO}$ (C3) is evaluated by using a DFT method of Gaussian program structurally optimized at a level of B3LYP/6-31G(d,p).

Since the composition includes the first compound represented by Formula 1, the second compound represented by Formula 2, and the third compound satisfying Condition 1, the mobility properties of the electron and the hole may be improved. Therefore, an electronic device, for example, an organic light-emitting device, which includes the composition, may have a low roll-off and high luminescent efficiency.

The first compound represented by Formula 1 essentially includes at least one cyano group. Therefore, since the first compound represented by Formula 1 has excellent heat resistance, an electronic device, for example, an organic light-emitting device, which includes a thin film including the first compound, the second compound, and the third compound, may have a long lifespan.

Specifically, since the composition essentially includes the first compound represented by Formula 1, the composition may have excellent charge mobility and material stability and thus have a low roll-off and a long lifespan.

The composition may not include a transition metal-containing organometallic compound, and that is, the composition does not include a phosphorescent dopant. Therefore, the composition is clearly distinguished from other compositions in which at least one of the first compound to the third compound serves as a phosphorescent host.

Specifically, in the composition, the first compound and the second compound each serve a host, and the third compound may serve as a dopant, in particular, as a delayed fluorescent dopant. Specifically, since the composition essentially includes the second compound represented by Formula 2, the composition may have excellent hole mobility and material stability and thus have high efficiency and a long lifespan when mixed with the first compound.

For example, HOMO, LUMO, singlet ($S_1$), and triplet ($T_1$) energy levels of Compounds were evaluated by using a DFT method of Gaussian program structurally optimized at a level of B3LYP/6-31G(d,p), and results thereof are shown in Table 1.

[Table 1]

| | HOMO (eV) | LUMO (eV) | $S_1$ (eV) | $T_1$ (eV) |
|---|---|---|---|---|
| Compound H-1 | -4.98 | -1.46 | 3.09 | 2.92 |
| Compound H-2 | -5.13 | -1.09 | 3.61 | 3.15 |
| Compound H-3 | -5.42 | -1.07 | 3.38 | 3.17 |
| Compound E-1 | -5.64 | -2.06 | 3.14 | 3.03 |
| Compound D-1 | -5.56 | -2.21 | 2.73 | 2.53 |
| Compound D-4 | -5.37 | -1.93 | 2.81 | 2.63 |
| mCBP | -5.41 | -1.20 | 3.45 | 3.17 |
| DPEPO | -6.31 | -0.87 | 3.68 | 3.60 |
| PO-T2T | -6.92 | -2.32 | 3.76 | 3.03 |

The weight ratio of the first compound to the second compound in the composition may be in a range of about 0.1:99.9 to about 99.9:0.1, for example, about 1:9 to about 9:1. In one embodiment, the weight ratio of the first compound to the second compound may be in a range of about 3:7 to about 7:3. When the weight ratio of the first compound to the second compound in the composition is within this range, effective charge balance in the emission layer may be achieved. Therefore, an organic light-emitting device having a low roll-off, high efficiency, and a long lifespan may be implemented.

An amount of the third compound in the composition may be in a range of about 0.01 wt% to about 30 wt% based on the total amount of the first compound, the second compound, and the third compound, but embodiments of the present disclosure are not limited thereto. Specifically, the amount of the third compound in the composition may be in a range of about 5 wt% to about 20 wt% based on the total amount of the first compound, the second compound, and the third compound, but embodiments of the present disclosure are not limited thereto. When the amount of the third compound is within this range, light emission may be implemented without quenching phenomenon.

According to another aspect of the present disclosure, there is provided a thin film including the composition. The thin film may be formed by using one or more suitable methods selected from vacuum deposition, spin coating, casting, and Langmuir-Blodgett (LB) deposition.

When thin film is formed by vacuum deposition, the deposition conditions may vary according to a material that is used to form the thin film, and the structure and thermal characteristics of the thin film. For example, the deposition conditions may include a deposition temperature of about 100°C to about 500°C, a vacuum pressure of about $10^{-8}$ torr to about $10^{-3}$ torr, and a deposition rate of about 0.01 Å/sec to about 100 Å/sec. However, the deposition conditions are not limited thereto.

When the thin film is formed using spin coating, coating conditions may vary according to the material used to form the thin film, and the structure and thermal properties of the thin film. For example, a coating speed may be from about 2,000 rpm to about 5,000 rpm, and a temperature at which a heat treatment is performed to remove a solvent after coating may be from about 80°C to about 200°C However, the coating conditions are not limited thereto.

The thin film includes the composition described above.

The thin film may be applied to an electronic device, for example, an organic layer of an organic light-emitting device. Therefore, an aspect provides an organic light-emitting device including a first electrode; a second electrode; and an organic layer between the first electrode and the second electrode, wherein the organic layer includes the composition or the thin film.

In one embodiment, the thin film included in the organic layer may be an emission layer. The first compound and the second compound included in the emission layer may act as a host. The third compound included in the emission layer may act as a dopant.

Specifically, the third compound may emit delayed fluorescence. The third compound in the emission layer may emit delayed fluorescence when exciton moving from a $^3$n-$\pi$* excited state to a $^1\pi$-$\pi$* excited state transitions to a ground state through reverse intersystem crossing. A ratio of delayed fluorescence in a light amount emitted from the emission layer may be about 90 % or more, for example, about 92 % or more, for example, about 95 % or more, but embodiments of the present disclosure are not limited thereto.

When the thin film is the emission layer including the composition, the first compound and the second compound in the emission layer may increase the mobility of electron and hole in the organic light-emitting device and may adjust charge balance in the emission layer. Therefore, an organic light-emitting device having a low roll-off, high efficiency, and a long lifespan may be implemented.

When the thin film includes the composition, an organic light-emitting device that emits blue light may be implemented.

FIGURE is a schematic view of an organic light-emitting device 10 according to an embodiment. Hereinafter, the structure of an organic light-emitting device according to an embodiment and a method of manufacturing an organic light-emitting device according to an embodiment will be described in connection with the FIGURE. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide ($SnO_2$), or zinc oxide (ZnO). In one or more embodiments, the material for forming the first electrode 11 may be metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

When the hole transport region includes a hole injection layer (HIL), the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100°C to about 500°C, a vacuum pressure of about $10^{-8}$ torr to about $10^{-3}$ torr, and a deposition rate of about 0.01 Å/sec to about 100 Å/sec.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80°C to about 200°C . However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonicacid (PANI/CSA), polyaniline/poly(4-styrenesulfonate) (PANI/PSS), a compound represented by Formula 201, and a compound represented by Formula 202:

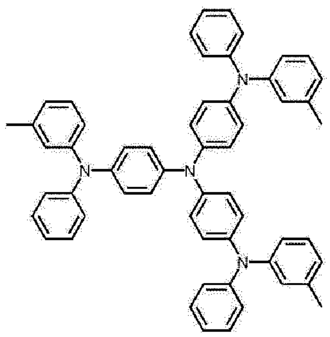

m-MTDATA

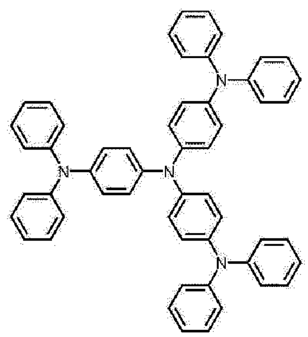

TDATA

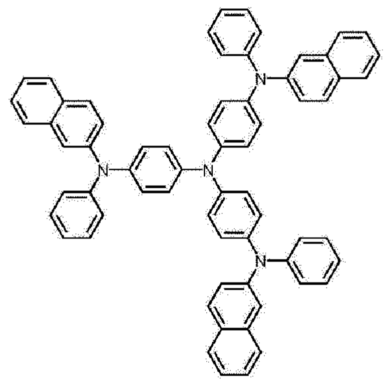

2-TNATA

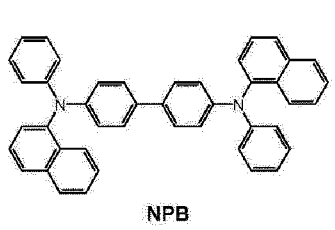

NPB

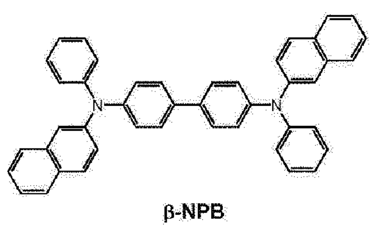

β-NPB

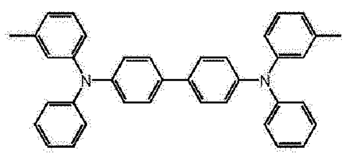

TPD

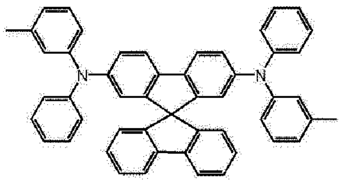

Spiro-TPD

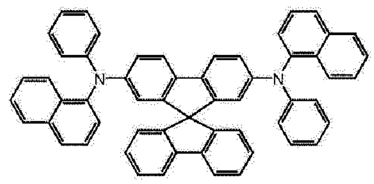

Spiro-NPB

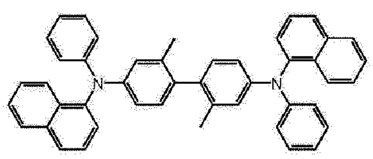

methylated NPB

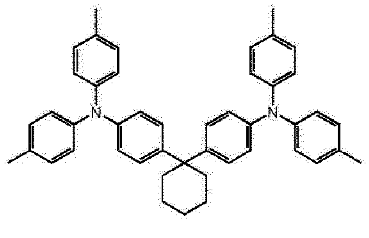

TAPC

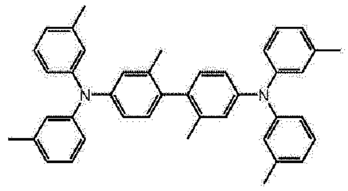

HMTPD

<Formula 201>

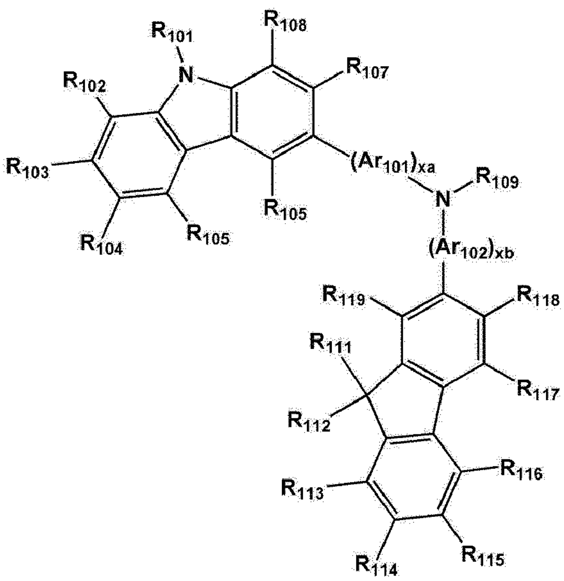

<Formula 202>

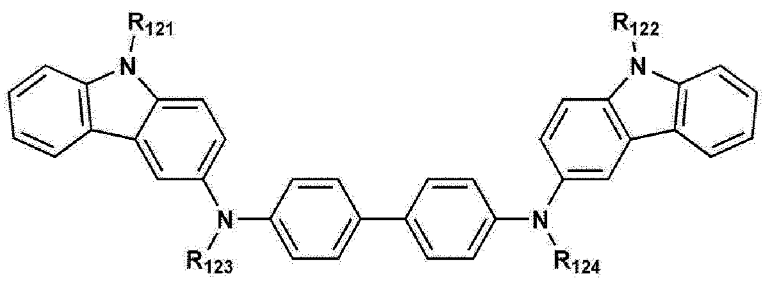

$Ar_{101}$ and $Ar_{102}$ in Formula 201 may each independently be selected from:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

In Formula 201, xa and xb may each independently be an integer from 0 to 5, or 0, 1 or 2. For example, xa may be 1 and xb may be 0, but xa and xb are not limited thereto.

In Formulae 201 and 202, $R_{101}$ to $R_{108}$, $R_{111}$ to $R_{119}$, and $R_{121}$ to $R_{124}$ may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, and so on), or a $C_1$-$C_{10}$ alkoxy group (for example, a methoxy group, an ethoxy group, a propoxy group, a butoxy group, a pentoxy group, and so on);

a $C_1$-$C_{10}$ alkyl group and a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;

a phenyl group, a naphthyl group, an anthracenyl group, a fluorenyl group, or a pyrenyl group; or

a phenyl group, a naphthyl group, an anthracenyl group, a fluorenyl group, and a pyrenyl group, each substituted with at least one selected from deuterium, -F,-Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group, but embodiments of the present disclosure are not limited thereto.

$R_{109}$ in Formula 201 may be selected from:

a phenyl group, a naphthyl group, an anthracenyl group, and a pyridinyl group; and

a phenyl group, a naphthyl group, an anthracenyl group, and a pyridinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, and a pyridinyl group.

In one embodiment, the compound represented by Formula 201 may be represented by Formula 201A, but embodiments of the present disclosure are not limited thereto:

<Formula 201A>

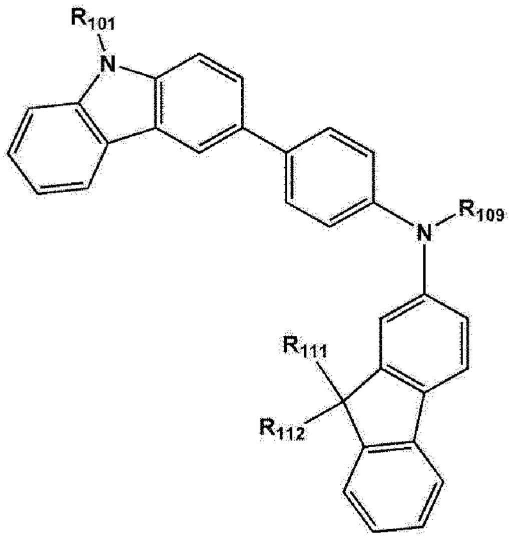

In Formula 201A, $R_{101}$, $R_{111}$, $R_{112}$, and $R_{109}$ may each independently be the same as described above.

For example, the compound represented by Formula 201, and the compound represented by Formula 202 may include compounds HT1 to HT20, but are not limited thereto.

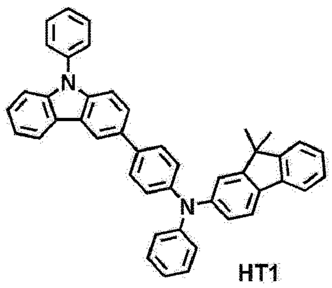

HT1

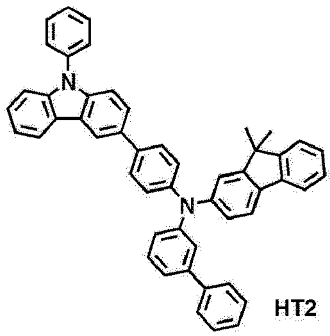

HT2

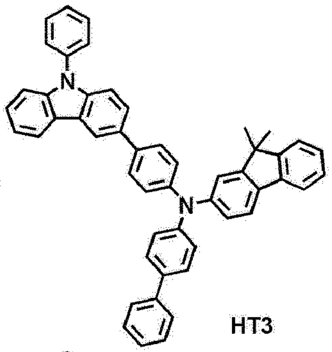

HT3

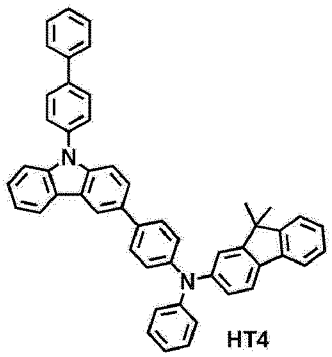

HT4

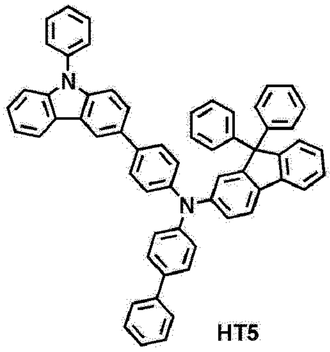

HT5

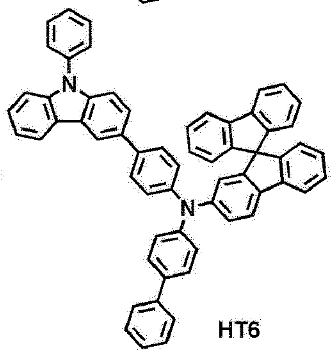

HT6

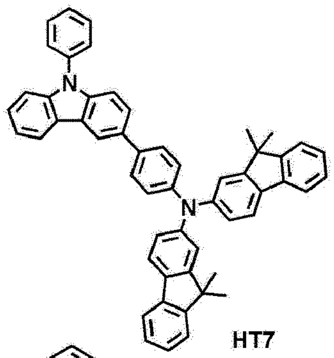
HT7

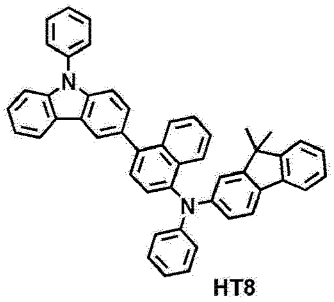
HT8

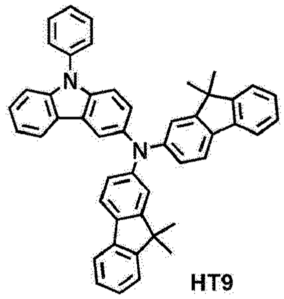
HT9

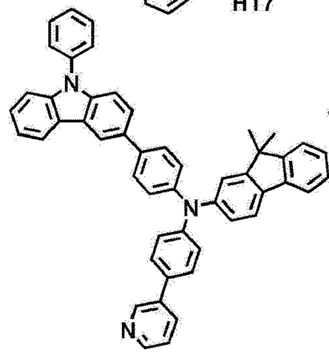
HT10

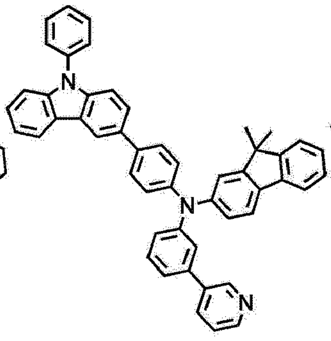
HT11

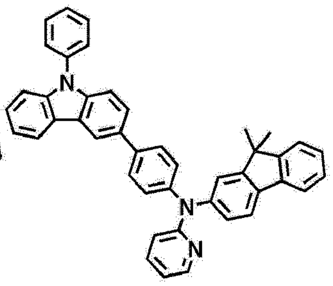
HT12

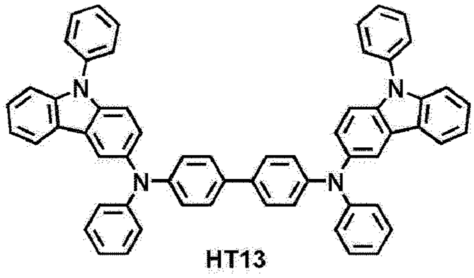
HT13

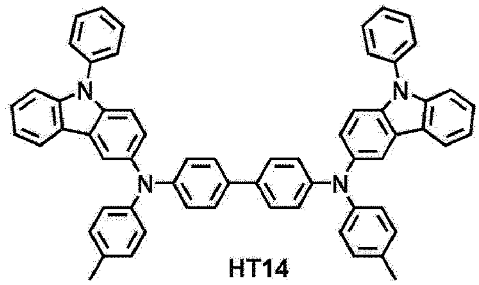
HT14

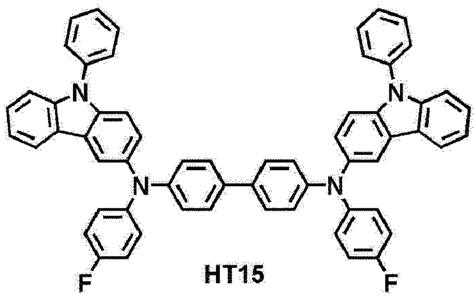
HT15

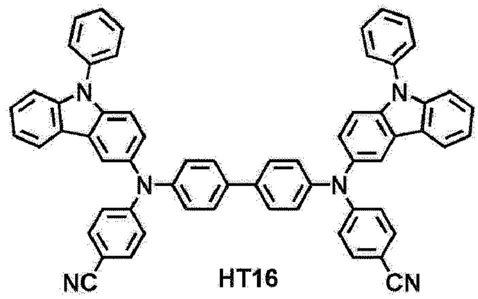
HT16

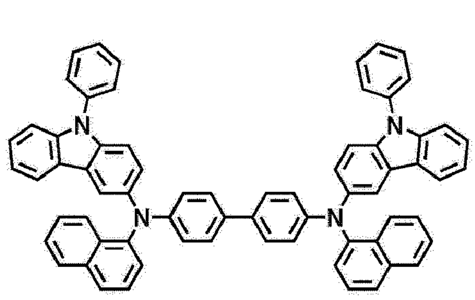
HT17

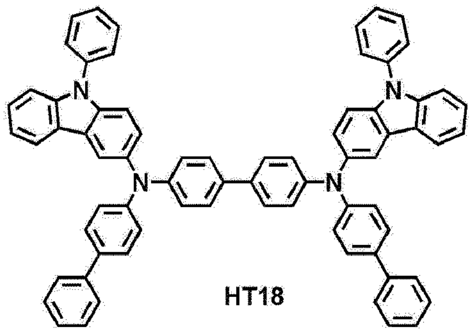
HT18

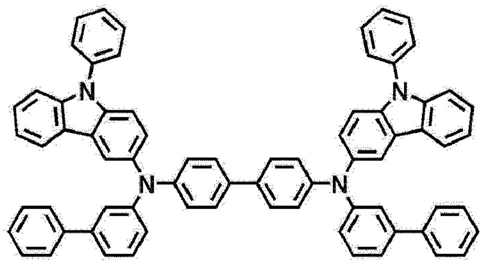
HT19

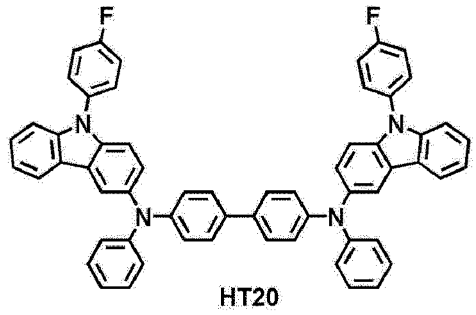
HT20

A thickness of the hole transport region may be in a range of about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 or HP-1, but are not limited thereto.

<Compound HT-D1>

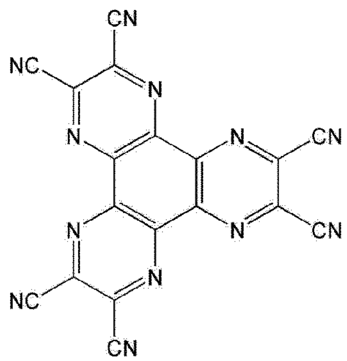

<F4-TCNQ>

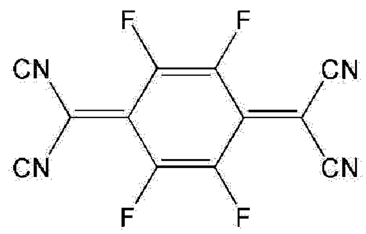

<HP-1>

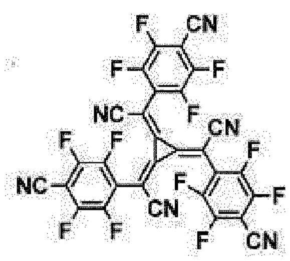

The hole transport region may include a buffer layer.

Also, the buffer layer may compensate for an optical resonance distance according to a wavelength of light

emitted from the emission layer, and thus, efficiency of a formed organic light-emitting device may be improved.

The electron transport region may further include an electron blocking layer. The electron blocking layer may include, for example, mCP, but a material therefor is not limited thereto.

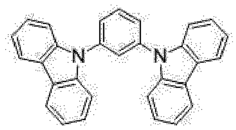

mCP

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

The emission layer may include the thin film.

For example, the emission layer may have a single-layered structure including only the thin film, or a multi-layered structure further including other known emission layers.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Then, an electron transport region may be disposed on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer. When the electron transport region includes a hole blocking layer, the hole blocking layer may include, for example, at least one of BCP and Bphen, but may also include other materials.

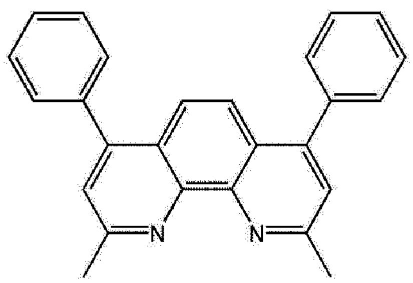

BCP

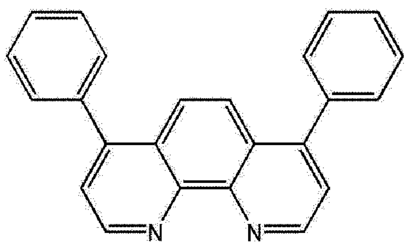

Bphen

For example, as a material for the hole blocking layer, the first compound represented by Formula 1 may be used, but embodiments of the present disclosure are not limited thereto.

A thickness of the hole blocking layer may be in a range of about 20 Å to about 1,000 Å, for example, about 30 Å to about 300 Å. When the thickness of the hole blocking layer is within these ranges, the hole blocking layer may have excellent hole blocking characteristics without a substantial increase in driving voltage.

The electron transport layer may include at least one selected from BCP, Bphen, $Alq_3$, BAlq, TAZ, and NTAZ.

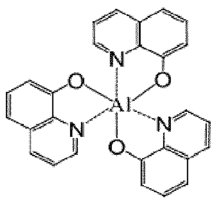

Alq$_3$

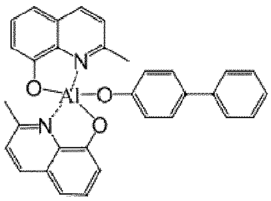

BAlq

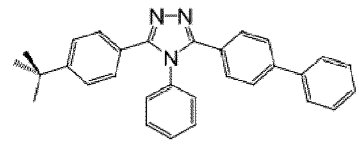

TAZ

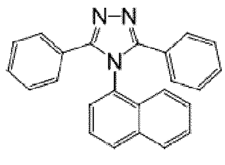

NTAZ

In one or more embodiments, the electron transport layer may include at least one of ET1 to ET25, but are not limited thereto:

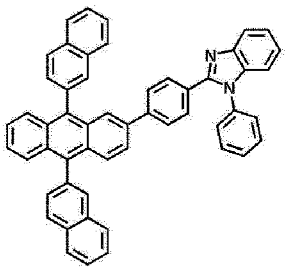

ET1

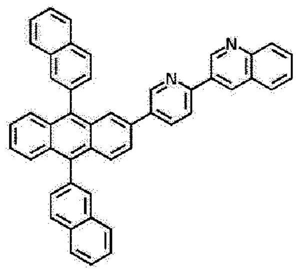

ET2

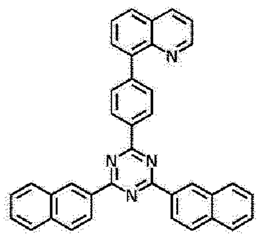

ET3

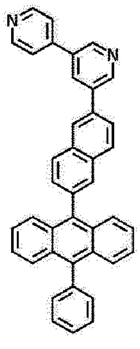

ET4

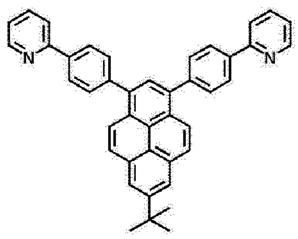

ET5

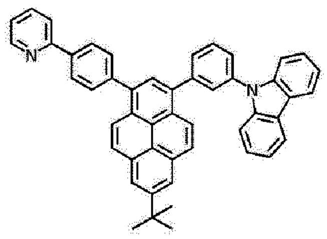

ET6

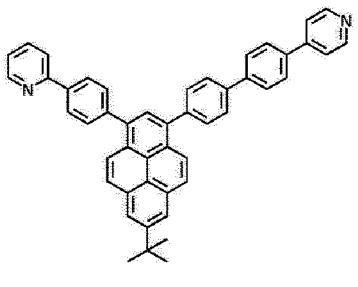

ET7

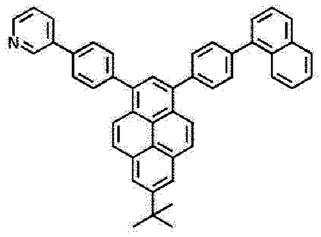

ET8

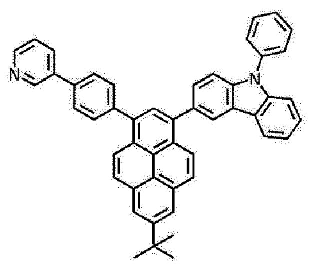

ET9

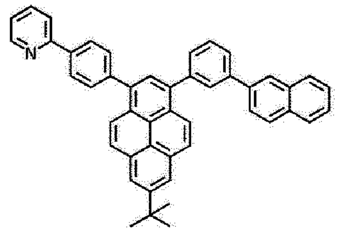

ET10

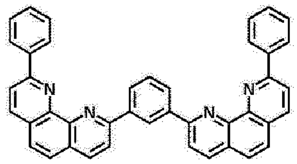

ET11

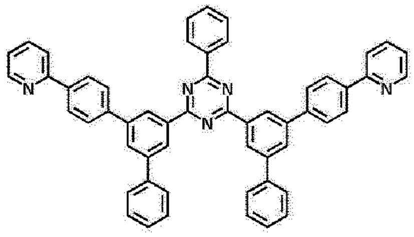

ET12

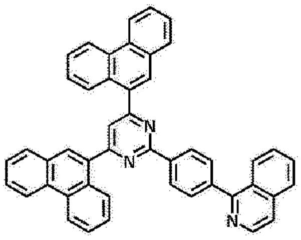

ET13

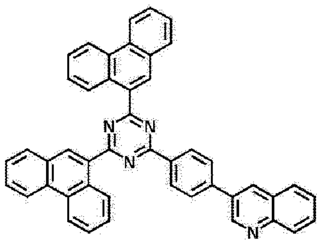

ET14

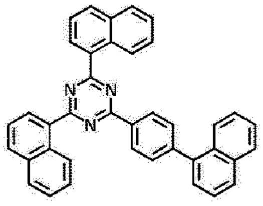

ET15

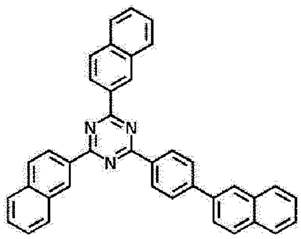

ET16

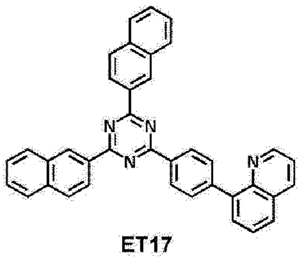

ET17

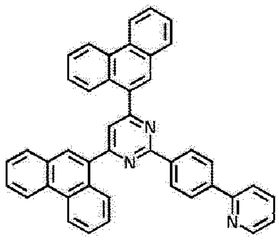

ET18

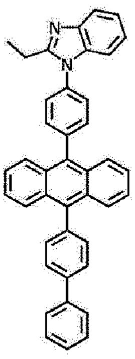

ET19

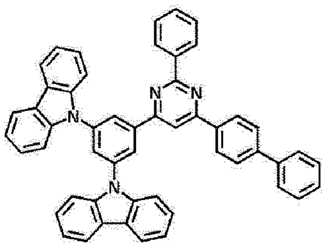

ET20

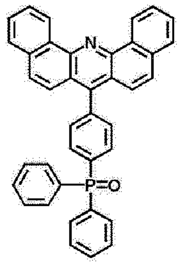

ET21

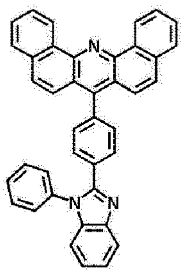

ET22

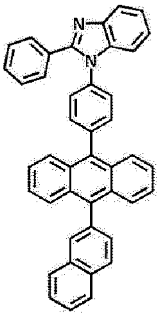

ET23

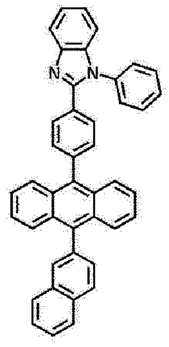

ET24

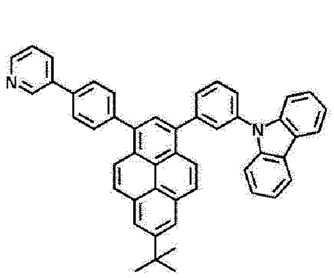

ET25

A thickness of the electron transport layer may be in a range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium quinolate, LiQ) or ET-D2.

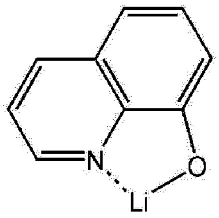

ET-D1

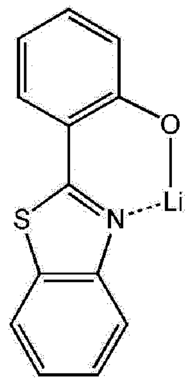

ET-D2

The electron transport region may include an electron injection layer (EIL) that promotes flow of electrons from the second electrode 19 thereinto.

The electron injection layer may include at least one selected from LiF, NaCl, CsF, $Li_2O$, and BaO.

A thickness of the electron injection layer may be in a range of about 1 Å to about 100 Å, and, for example, about 3 Å to about 90 Å. When the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be formed as the material for forming the second electrode 19. To manufacture a top-emission type light-emitting device, a transmissive electrode formed using ITO or IZO may be used as the second electrode 19.

Hereinbefore, the organic light-emitting device has been described with reference to the FIGURE, but embodiments of the present disclosure are not limited thereto.

The term "$C_1$-$C_{60}$ alkyl group" as used herein refers to a linear or branched saturated aliphatic hydrocarbon monovalent group having 1 to 60 carbon atoms, and examples thereof include a methyl group, an ethyl group, a propyl group, an isobutyl group, a sec-butyl group, a tert-butyl group, a pentyl group, an isoamyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by $-OA_{101}$ (wherein $A_{101}$ is the $C_1$-$C_{60}$ alkyl group), and examples thereof include a methoxy group, an ethoxy group, and an isopropyloxy group.

The term "$C_2$-$C_{60}$ alkenyl group" as used herein refers to a hydrocarbon group having at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group having at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group," used herein, refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group," used herein, refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Examples of the $C_6$-$C_{60}$ aryl group are a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_1$-$C_{60}$ heteroaryl group" as used herein refers to a monovalent group having a heterocyclic aromatic system that has at least one heteroatom selected from N, O, P, Si, and S as a ring-forming atom, in addition to 1 to 60 carbon atoms. The term "$C_1$-$C_{60}$ heteroarylene group" as used herein refers to a divalent group having a heterocyclic aromatic system that has at least one heteroatom selected from N, O, P, Si, and S as a ring-forming atom, in addition to 1 to 60 carbon atoms. Examples of the $C_1$-$C_{60}$ heteroaryl group are a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_6$-$C_{60}$ aryloxy group" as used herein indicates $-OA_{102}$ (wherein $A_{102}$ is the $C_6$-$C_{60}$ aryl group), and a $C_6$-$C_{60}$ arylthio group indicates $-SA_{103}$ (wherein $A_{103}$ is the $C_6$-$C_{60}$ aryl group).

The term "monovalent non-aromatic condensed polycyclic group" as used herein refers to a monovalent group having two or more rings condensed to each other, only carbon atoms (for example, the number of carbon atoms may be in a range of 8 to 60) as a ring-forming atom, and no aromaticity in its entire molecular structure. Non-limiting examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group having two or more rings condensed to each other, a heteroatom selected from N, O, P, Si, and S, other than carbon atoms (for example, the number of carbon atoms may be in a range of 2 to 60), as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The term "$C_5$-$C_{30}$ carbocyclic group" as used herein refers to a monocyclic group or a polycyclic group, and, according to its chemical structure, a monovalent, divalent, trivalent, tetravalent, pentavalent, or hexavalent group.

The term "$C_1$-$C_{30}$ heterocyclic group" as used herein refers to a saturated or unsaturated cyclic group having, as a ring-forming atom, at least one heteroatom selected from N, O, Si, P, and S other than 1 to 30 carbon atoms. The term "$C_1$-$C_{30}$ heterocyclic group" as used herein refers to a monocyclic group or a polycyclic group, and, according to its chemical structure, a monovalent, divalent, trivalent, tetravalent, pentavalent, or hexavalent group.

At least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{11})(Q_{12})$,$-Si(Q_{13})(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one selected from deuterium,-F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group,$-N(Q_{21})(Q_{22})$, $-Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$, and

$Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a $C_1$-$C_{60}$ alkyl group, and a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

The term "room temperature" as used herein refers to about 25°C.

The term "biphenyl group" refers to a monovalent group in which two benzene groups are linked via a single bond.

The term "terphenyl group" refers to a monovalent group in which three benzene groups are linked via a single bond.

Hereinafter, a compound and an organic light-emitting device according to embodiments are described in detail with reference to Synthesis Example and Examples. However, the organic light-emitting device is not limited thereto. The wording "'B' was used instead of 'A' " used in describing Synthesis Examples means that a molar equivalent of 'A' was identical to a molar equivalent of 'B'.

**[Examples]**

**Example 1**

As an anode, a glass substrate, on which an ITO electrode was formed, was cut to a size of 50 mm x 50 mm x 0.5 mm, sonicated with acetone, isopropyl alcohol, and pure water each for 15 minutes, and then cleaned by exposure to ultraviolet rays and ozone for 30 minutes.

Compound HT3 and HP-1 (concentration of HP-1: 3 wt%) were co-deposited on the anode to form a hole injection layer having a thickness of 100 Å, Compound HT3 was deposited on the hole injection layer to form a hole transport layer having a thickness of 1,350 Å, and Compound H-1 was deposited on the hole transport layer to form an electron blocking layer having a thickness of 100 Å, thereby forming a hole transport region.

Compound E-1 and H-1 (weight ratio of 9:1) as a host and Compound D-1 (15 wt% based on the total weight

of the host and the dopant) as a dopant were co-deposited on the hole transport region to form an emission layer having a thickness of 400 Å.

Compound E-1 was vacuum-deposited on the emission layer to form a hole blocking layer having a thickness of 100 Å, Compound ET17 and LiQ were co-deposited on the hole blocking layer at a weight ratio of 5:5 to form an electron transport layer having a thickness of 300 Å, LiQ was deposited on the electron transport layer to form an electron injection layer having a thickness of 10 Å, and Al was formed on the electron injection layer to a thickness of 1,000 Å, thereby completing the manufacture of an organic light-emitting device.

**Examples 2 to 4 and Comparative Examples 1 to 8**

Organic light-emitting devices were manufactured in the same manner as in Example 1, except that a host and a dopant were changed as shown in Table 2 in forming an emission layer.

[Table 2]

| | Host | | Dopant | Weight ratio of first compound to second compound | Weight ratio of dopant |
|---|---|---|---|---|---|
| | First compound | Second compound | Third compound | | |
| Example 1 | E-1 | H-1 | D-1 | 9:1 | 15 |
| Example 2 | E-1 | H-3 | D-1 | 9:1 | 15 |
| Example 3 | E-1 | H-2 | D-4 | 7:3 | 15 |
| Example 4 | E-1 | H-3 | D-4 | 9:1 | 15 |
| Comparative Example 1 | DPEPO | | D-1 | - | 15 |
| Comparative Example 2 | mCBP | | D-1 | - | 40 |
| Comparative Example 3 | E-1 | | D-1 | - | 15 |
| Comparative Example 4 | H-3 | PO-T2T | D-1 | 9:1 | 15 |
| Comparative Example 5 | DPEPO | | D-4 | - | 15 |
| Comparative Example 6 | mCBP | | D-4 | - | 40 |
| Comparative Example 7 | E-1 | | D-4 | - | 15 |
| Comparative Example 8 | H-3 | PO-T2T | D-4 | 9:1 | 15 |

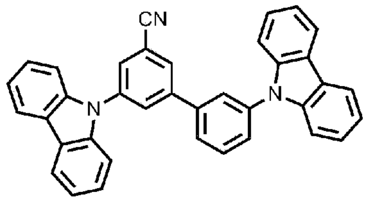

**E-1**

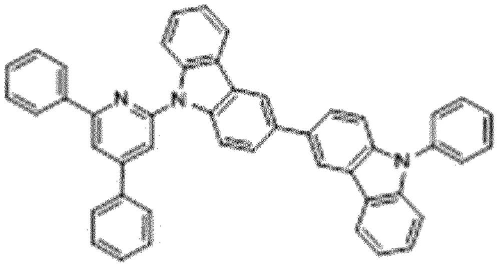

H-1

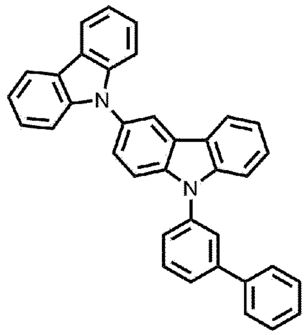

H-2

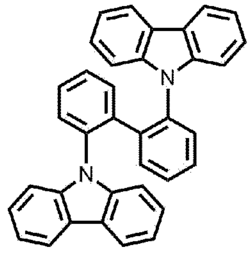

H-3

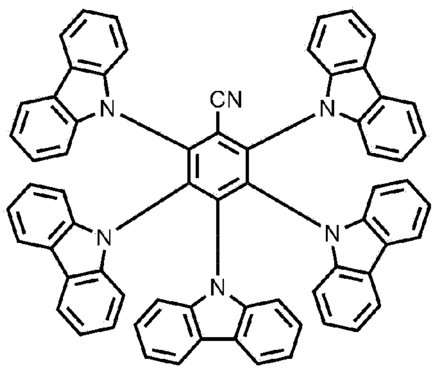

D-1

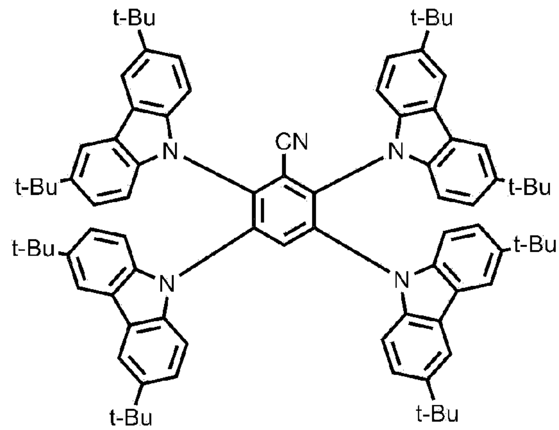

D-4

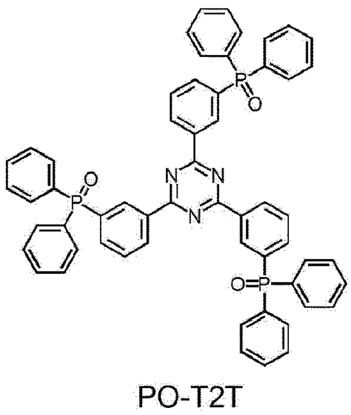

PO-T2T

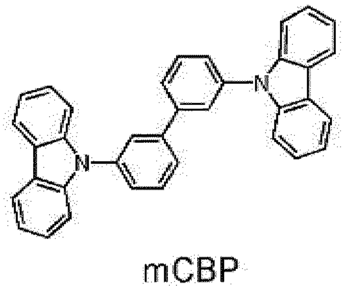

mCBP

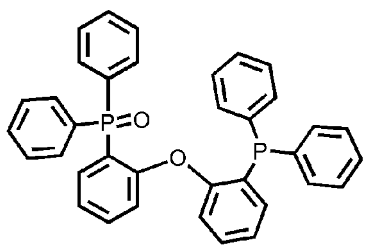

DPEPO

**Evaluation Example 1: Evaluation of device characteristics**

The driving voltage (at 10 cd/m$^2$), maximum external quantum efficiency ($EQE_{max}$), maximum power efficiency ($PE_{max}$), luminance, external quantum efficiency (EQE, at 500 cd/m$^2$), roll-off (roll-off, 1-($EQE/EQE_{max}$)), CIE color coordinates, and lifespan ($T_{50}$) characteristics of the organic light-emitting devices manufactured according to Examples 1 to 4 and Comparative Examples 1 to 8 were measured by using a current-voltage meter (Keithley 2400) and a luminance meter (Minolta Cs-1000A), and results thereof are shown in Table 3. $T_{50}$ (at 500 cd/m$^2$) in Table 3 indicates lifespan data evaluating the amount of time that lapsed when luminance was 50 % of initial luminance (100 %).

[Table 3]

| | Host | | Dopant | Driving voltage (V) | $EQE_{max}$ (%) | $PE_{max}$ (lm/W) | Luminance ($cd/m^2$) | EQE (%) | Roll-off (%) | CIEx | CIEy | Lifespan (time) |
|---|---|---|---|---|---|---|---|---|---|---|---|---|
| | first compound | second compound | third compound | | | | | | | | | |
| Example 1 | E-1 | H-1 | D-1 | 3.12 | 19.6 | 51.4 | 500 | 15.8 | 19.4 | 0.20 | 0.36 | 770 |
| Example 2 | E-1 | H-3 | D-1 | 3.02 | 20.9 | 54.3 | 500 | 17.3 | 17.2 | 0.19 | 0.35 | 500 |
| Example 3 | E-1 | H-2 | D-4 | 3.16 | 20.7 | 32.6 | 500 | 20.1 | 2.9 | 0.16 | 0.22 | 225 |
| Example 4 | E-1 | H-3 | D-4 | 3.09 | 23.2 | 42.7 | 500 | 20.5 | 11.6 | 0.16 | 0.22 | 280 |
| Comparative Example 1 | DPEPO | | D-1 | 4.23 | 17.7 | 33.1 | 500 | 11.5 | 35.0 | 0.19 | 0.34 | < 1 |
| Comparative Example 2 | mCBP | | D-1 | 3.69 | 19.8 | 50.0 | 500 | 14.6 | 26.3 | 0.22 | 0.42 | 34 |
| Comparative Example 3 | E-1 | | D-1 | 2.99 | 19.7 | 46.2 | 500 | 15.0 | 23.9 | 0.19 | 0.33 | 180 |
| Comparative Example 4 | H-3 | PO-T2T | D-1 | 3.21 | 16.1 | 44.8 | 500 | 14.3 | 11.2 | 0.26 | 0.47 | 4 |
| Comparative Example 5 | DPEPO | | D-4 | 5.36 | 22.7 | 29.0 | 500 | 7.0 | 69.2 | 0.16 | 0.25 | < 1 |
| Comparative Example 6 | mCBP | | D-4 | 4.05 | 20.5 | 28.4 | 500 | 15.2 | 25.9 | 0.16 | 0.22 | 2 |
| Comparative Example 7 | E-1 | | D-4 | 3.10 | 22.0 | 39.2 | 500 | 19.6 | 10.9 | 0.16 | 0.22 | 170 |
| Comparative Example 8 | H-3 | PO-T2T | D-4 | 3.29 | 16.2 | 44.6 | 500 | 14.0 | 13.6 | 0.23 | 0.39 | 3 |

Referring to Table 3, it is confirmed that the organic light-emitting devices manufactured according to Examples 1 to 4 have high power efficiency, high quantum efficiency, and a long lifespan, as compared with the organic light-emitting devices manufactured according to Comparative Examples 1 to 8.

The organic light-emitting device including the thin film including the first compound, the second compound, and the third compound may have a low roll-off, high efficiency, and a long lifespan simultaneously.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

**1.** A composition comprising:

a first compound represented by Formula 1;
a second compound represented by Formula 2;
a third compound satisfying Condition 1, and
the second compound is different from the first compound:

<Formula 1> $A_{11}\text{-}L_{11}\text{-}A_{12}$

<Formula 2> $A_{21}\text{-}(L_{21})_{a21}\text{-}A_{22}$

<Formula 10-1>

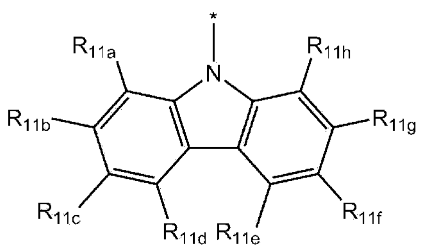

<Formula 10-2>

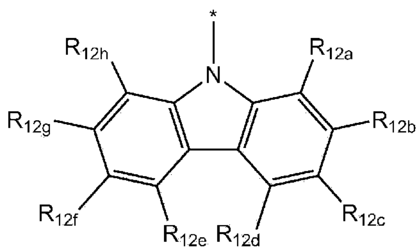

<Formula 11-1>

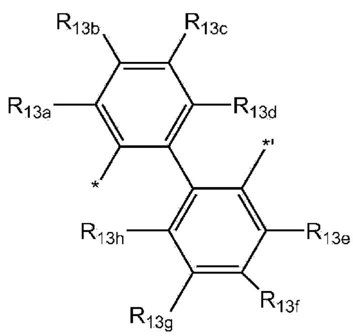

<Formula 11-2>

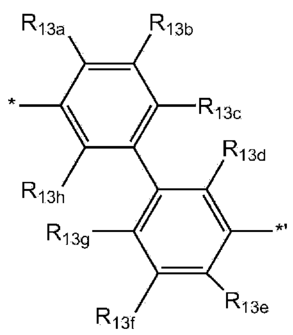

<Formula 11-3>

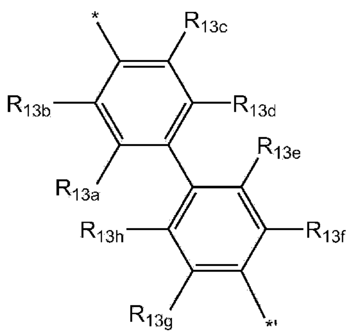

<Formula 20-1>

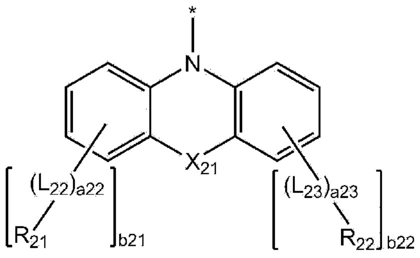

<Formula 20-2>

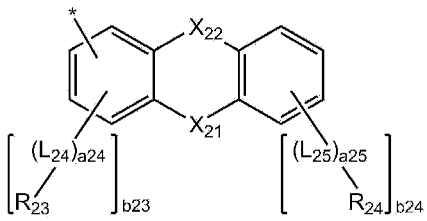

<Condition 1>

$$0\ \text{eV} \le E_{S1}(C3) - E_{T1}(C3) \le 0.3\ \text{eV},$$

wherein, in Condition 1,

$E_{S1}(C3)$ is a lowest excitation singlet energy level of the third compound,
$E_{T1}(C3)$ is a lowest excitation triplet energy level of the third compound, and
$E_{S1}(C3)$ and $E_{T1}(C3)$ are evaluated by using a DFT method structurally optimized at a level of B3LYP/6-31G(d,p),

in Formulae 1 and 2,

$A_{11}$ is a group represented by Formula 10-1,
$A_{12}$ is a group represented by Formula 10-2,
$L_{11}$ is a group represented by one selected from Formulae 11-1 to 11-3,
$A_{21}$ is a group represented by one selected from Formulae 20-1 and 20-2;
$A_{22}$ is selected from groups represented by Formulae 20-1 and 20-2, a phenyl group, a naphthyl group, and a benzimidazolyl group; and
a phenyl group, a naphthyl group, and a benzimidazolyl group, each substituted with at least one selected from deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, and a dibenzothiophenyl group,
$X_{21}$ is selected from a single bond, $C[(L_{27})_{a27}\text{-}R_{26}][(L_{28})_{a28}\text{-}R_{27}]$, O, and S,
$X_{22}$ is selected from $N[(L_{26})_{a26}\text{-}R_{25}]$, $C[(L_{29})_{a29}\text{-}R_{28}][(L_{30})_{a30}\text{-}R_{29}]$, O, and S,
$L_{21}$ to $L_{30}$ are each independently selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group,
a21 to a30 are each independently selected from 0, 1, 2, 3, 4, and 5,
$R_{11a}$ to $R_{11h}$, $R_{12a}$ to $R_{12h}$, $R_{13a}$ to $R_{13h}$, and $R_{21}$ to $R_{29}$ are each independently selected from hydrogen, deuterium, -F, -Cl, -Br, -I, a hydroxyl group, a cyano group (CN), a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic

group, $-Si(Q_1)(Q_2)(Q_3)$, $-N(Q_1)(Q_2)$, and$-B(Q_1)(Q_2)$, two or more selected from $R_{21}$ to $R_{29}$ are optionally linked to form a ring,
at least one selected from $R_{11a}$ to $R_{11h}$, $R_{12a}$ to $R_{12h}$, and $R_{13a}$ to $R_{13h}$ is a cyano group,
b21, b22, and b24 are each independently selected from 1, 2, 3, and 4,
b23 is selected from 1, 2, and 3,
$Q_1$ to $Q_3$ are each independently selected from hydrogen, deuterium, -F, -Cl,-Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, a monovalent non-aromatic condensed heteropolycyclic group, a biphenyl group, and a terphenyl group, and
* and *' each indicate a binding site to a neighboring atom.

**2.** The composition of claim 1, wherein
one, two, or three selected from $R_{11a}$ to $R_{11h}$, $R_{12a}$ to $R_{12h}$, and $R_{13a}$ to $R_{13h}$ are a cyano group; and/or wherein
$R_{11a}$ to $R_{11h}$, $R_{12a}$ to $R_{12h}$, and $R_{13a}$ to $R_{13h}$ are each independently selected from:

hydrogen, deuterium, a cyano group, a $C_1$-$C_{10}$ alkyl group, and a $C_1$-$C_{10}$ alkoxy group,
a $C_1$-$C_{10}$ alkyl group and a $C_1$-$C_{10}$ alkoxy group, each substituted with at least one selected from deuterium and a cyano group,
a phenyl group, a biphenyl group, a terphenyl group, a naphthyl group, a fluorenyl group, a pyridinyl group, a pyrazinyl group, a pyrimidinyl group, a carbazolyl group, a dibenzofuranyl group, and a dibenzothiophenyl group, and
a phenyl group, a biphenyl group, a terphenyl group, a naphthyl group, a fluorenyl group, a pyridinyl group, a carbazolyl group, a dibenzofuranyl group, and a dibenzothiophenyl group, each substituted with at least one selected from deuterium, a cyano group, a $C_1$-$C_{10}$ alkyl group, a $C_1$-$C_{10}$ alkoxy group, a phenyl group, a biphenyl group, a terphenyl group, a naphthyl group, a fluorenyl group, a pyridinyl group, a pyrazinyl group, a pyrimidinyl group, a carbazolyl group, a dibenzofuranyl group, and a dibenzothiophenyl group.

**3.** The composition of claims 1 or 2, wherein
$A_{11}$ is represented by Formula 10-11, $A_{12}$ is represented by Formula 10-21, and $L_{11}$ is represented by one selected from Formulae 11-15 to 11-22, 11-27 to 11-34, and 11-37 to 11-40;
$A_{11}$ is represented by one selected from Formulae 10-12 and 10-13, $A_{12}$ is represented by one selected from Formulae 10-21 to 10-23, and $L_{11}$ is represented by one selected from Formulae 11-11 to 11-40; or
$A_{11}$ is represented by Formula 10-11, $A_{12}$ is represented by one selected from Formulae 10-22 and 10-23, and $L_{11}$ is represented by one selected from Formulae 11-11 to 11-40:

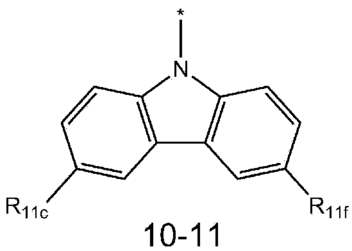
10-11

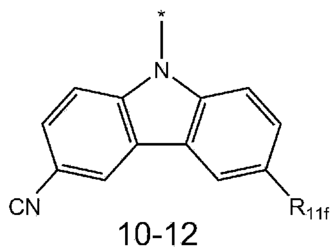
10-12

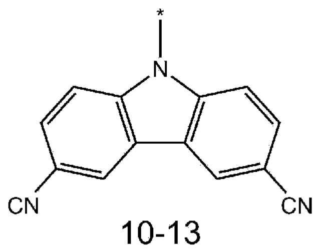
10-13

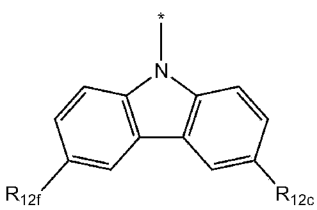
10-21

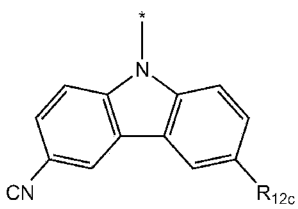
10-22

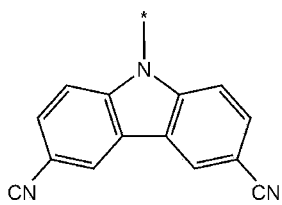
10-23

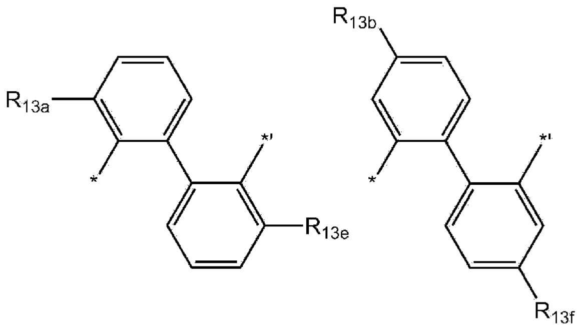

11-11 11-12

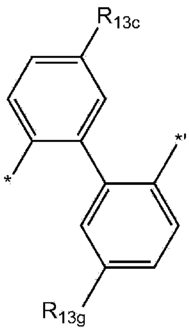

11-13

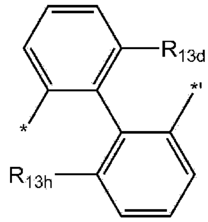

11-14

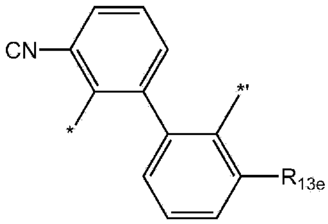

11-15

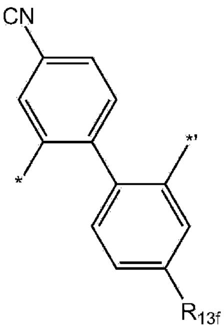

11-16

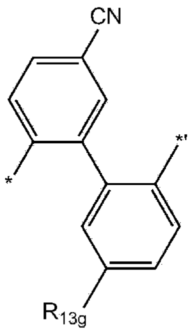

11-17

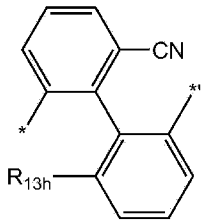

11-18

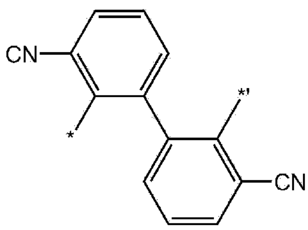

11-19

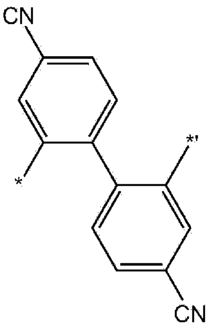

11-20

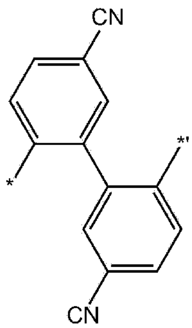

11-21

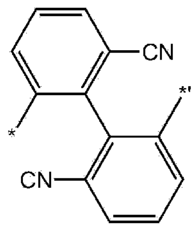

11-22

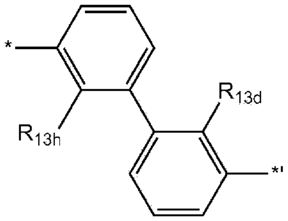

11-23

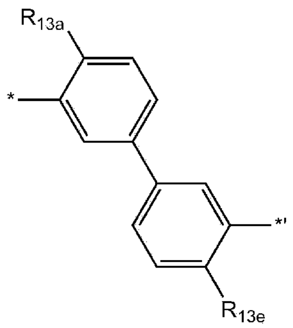

11-24

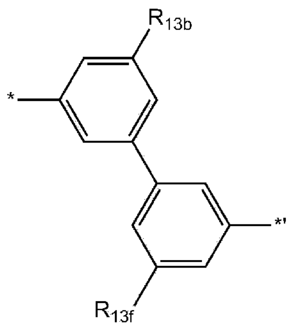

11-25

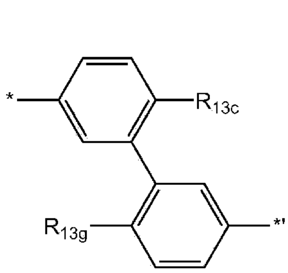

11-26

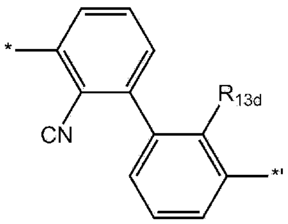

11-27

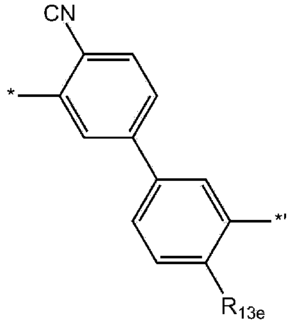

11-28

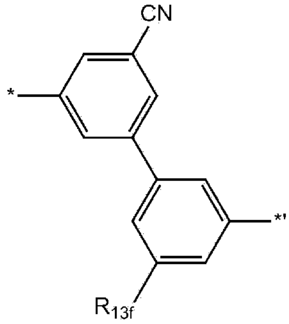

11-29

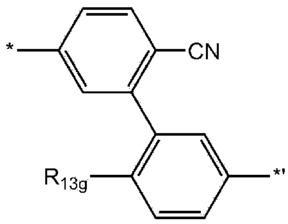

11-30

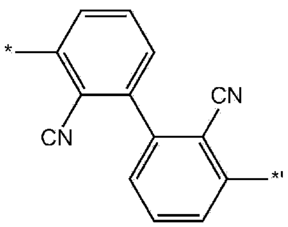

11-31

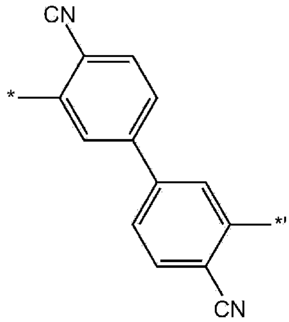

11-32

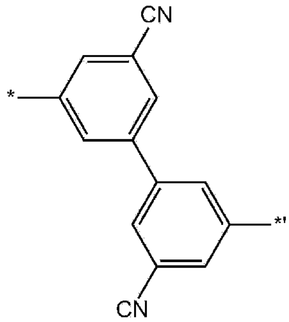

11-33

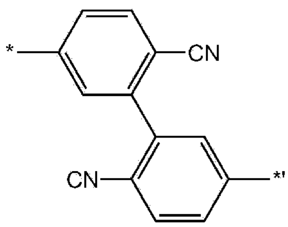

11-34

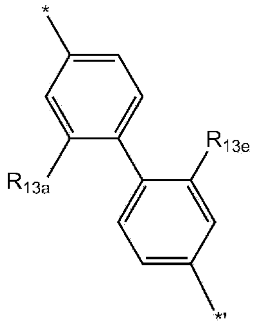

11-35

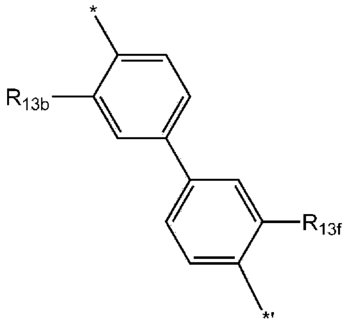

11-36

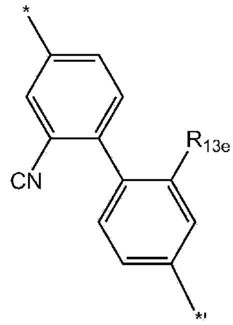

11-37

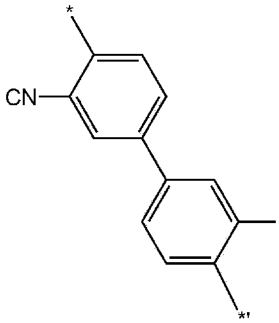

11-38

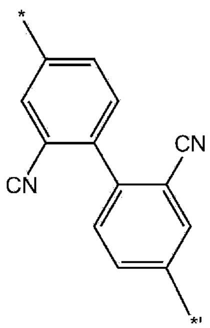

11-39

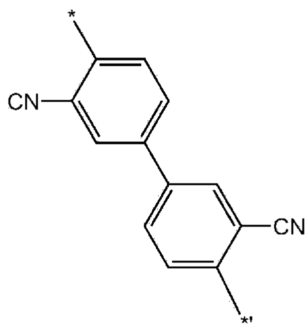

11-40

,

wherein, in Formulae 10-11 to 10-13, 10-21 to 10-23, and 11-11 to 11-40,
$R_{11c}$, $R_{11f}$, $R_{12c}$, $R_{12f}$, and $R_{13a}$ to $R_{13f}$ are each independently selected from:

hydrogen, deuterium, a $C_1$-$C_{10}$ alkyl group, a $C_1$-$C_{10}$ alkoxy group, a phenyl group, a biphenyl group, a terphenyl group, a naphthyl group, a fluorenyl group, a pyridinyl group, a pyrazinyl group, a pyrimidinyl group, a carbazolyl group, a dibenzofuranyl group, and a dibenzothiophenyl group;
a $C_1$-$C_{10}$ alkyl group and a $C_1$-$C_{10}$ alkoxy group, each substituted with deuterium; and
a phenyl group, a biphenyl group, a terphenyl group, a naphthyl group, a fluorenyl group, a pyridinyl group, a pyrazinyl group, a pyrimidinyl group, a carbazolyl group, a dibenzofuranyl group, and a dibenzothiophenyl group, each substituted with at least one selected from deuterium, a $C_1$-$C_{10}$ alkyl group, a $C_1$-$C_{10}$ alkoxy group, a phenyl group, a biphenyl group, a terphenyl group, a naphthyl group, a fluorenyl group, a pyridinyl group, a pyrazinyl group, a pyrimidinyl group, a carbazolyl group, a dibenzofuranyl group, and a dibenzothiophenyl group, and
* and *' each indicate a binding site to a neighboring atom.

**4.** The composition of any of claims 1-3, wherein
the first compound is selected from Compounds E-1 to E-20:

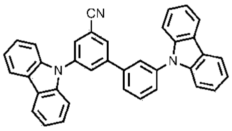
E-1

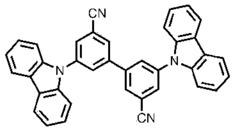
E-2

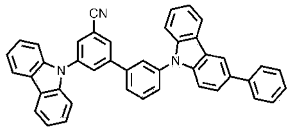
E-3

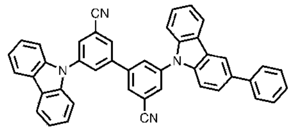
E-4

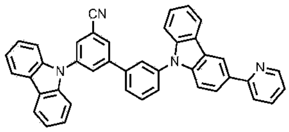
E-5

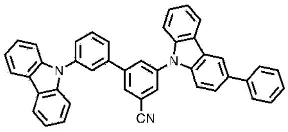
E-6

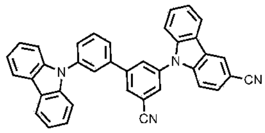
E-7

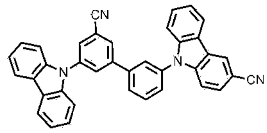
E-8

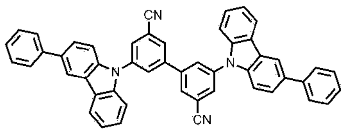
E-9

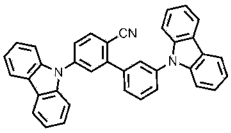
E-10

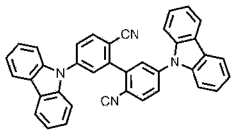
E-11

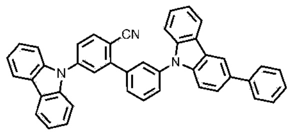
E-12

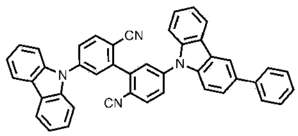
E-13

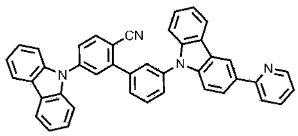
E-14

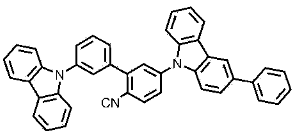
E-15

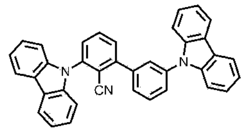
E-16

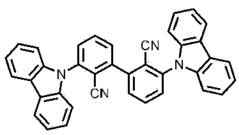
E-17

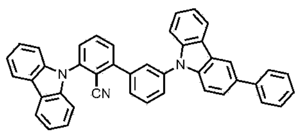
E-18

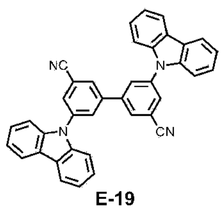
E-19

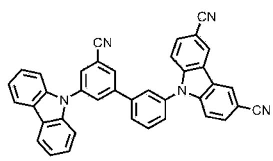
E-20

**5.** The composition of any of claims 1-4, wherein
$A_{21}$ and $A_{22}$ are each independently represented by Formula 20-1,
$A_{21}$ is represented by Formula 20-1, and $A_{22}$ is represented by Formula 20-2, or
$A_{21}$ and $A_{22}$ are each independently represented by Formula 20-2; and/or
wherein
$X_{21}$ is a single bond, and
$X_{22}$ is selected from $N(R_{25})$, $C(R_{28})(R_{29})$, O, and S.

**6.** The composition of any of claims 1-5, wherein
$R_{21}$ to $R_{29}$ are each independently selected from:

hydrogen, deuterium, -F, -Cl, -Br, -I, a cyano group, a $C_1$-$C_{10}$ alkyl group, a $C_1$-$C_{10}$ alkoxy group, a $C_3$-$C_{10}$ cycloalkyl group, and a $C_1$-$C_{10}$ heterocycloalkyl group;
a $C_1$-$C_{10}$ alkyl group, a $C_1$-$C_{10}$ alkoxy group, a $C_3$-$C_{10}$ cycloalkyl group, and a $C_1$-$C_{10}$ heterocycloalkyl group, each substituted with at least one selected from deuterium, -F, -Cl, -Br, -I, and a cyano group,
a $C_6$-$C_{30}$ aryl group, a biphenyl group, a terphenyl group, a $C_6$-$C_{30}$ aryloxy group, a $C_6$-$C_{30}$ arylthio group, a $C_1$-$C_{30}$ heteroaryl group, a monovalent non-aromatic condensed polycyclic group, and a monovalent non-aromatic condensed heteropolycyclic group,
a $C_6$-$C_{30}$ aryl group, a biphenyl group, a terphenyl group, a $C_6$-$C_{30}$ aryloxy group, a $C_6$-$C_{30}$ arylthio group, a $C_1$-$C_{30}$ heteroaryl group, a monovalent non-aromatic condensed polycyclic group, and a monovalent non-aromatic condensed heteropolycyclic group, each substituted with at least one selected from deuterium,-F, -Cl, -Br, -I, a cyano group, a $C_1$-$C_{10}$ alkyl group, a $C_1$-$C_{10}$ alkoxy group, a $C_3$-$C_{10}$ cycloalkyl group, a $C_1$-$C_{10}$ heterocycloalkyl group, a $C_6$-$C_{30}$ aryl group, a biphenyl group, a terphenyl group, a $C_6$-$C_{30}$ aryloxy group, a $C_6$-$C_{30}$ arylthio group, a $C_1$-$C_{30}$ heteroaryl group, a monovalent non-aromatic condensed polycyclic group, and a monovalent non-aromatic condensed heteropolycyclic group, and
$-Si(Q_1)(Q_2)(Q_3)$, $-N(Q_1)(Q_2)$, and $-B(Q_1)(Q_2)$,
two or more selected from $R_{21}$ to $R_{29}$ are optionally linked to form a ring, and
$Q_1$ to $Q_3$ are each independently selected from hydrogen, a $C_1$-$C_{10}$ alkyl group, a $C_6$-$C_{30}$ aryl group, a biphenyl group, a terphenyl group, a $C_1$-$C_{30}$ heteroaryl group, a monovalent non-aromatic condensed polycyclic group, and a monovalent non-aromatic condensed heteropolycyclic group; and/or
wherein
the group represented by Formula 20-2 is a group represented by one selected from Formulae 20-21 to 20-24:

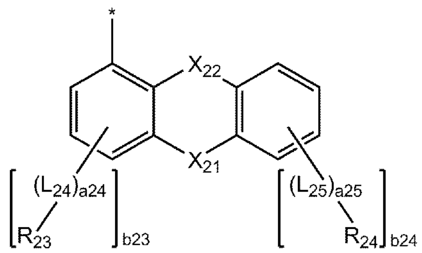
20-21

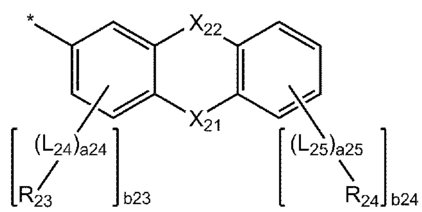
20-22

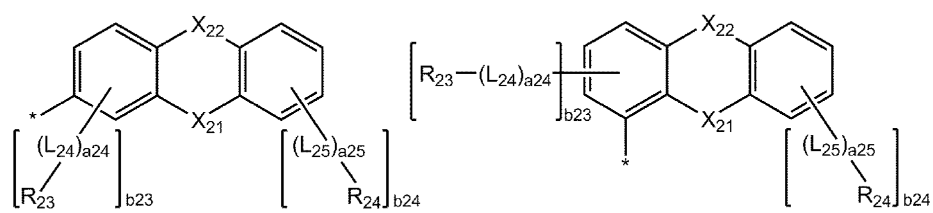
20-23 20-24

,

wherein, in Formulae 20-21 to 20-24,

$X_{21}$, $X_{22}$, $L_{24}$, $L_{25}$, a24, a25, $R_{23}$, $R_{24}$, b23 and b24 are each independently the same as defined in Formula 20-2, and
* indicates a binding site to a neighboring atom.

**7.** The composition of any of claims 1-6, wherein
the second compound is represented by one selected from Formulae 2-1 to 2-3:

<Formula 2-1>

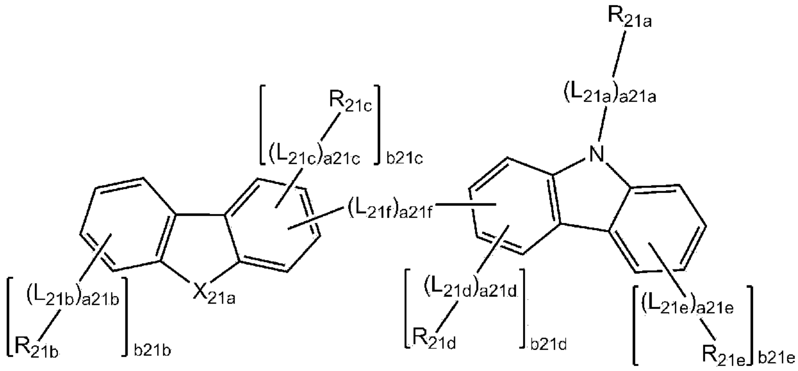

<Formula 2-2>

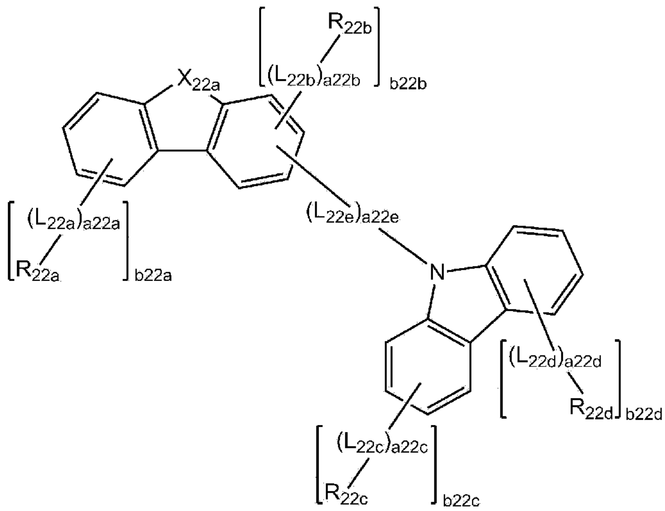

<Formula 2-3>

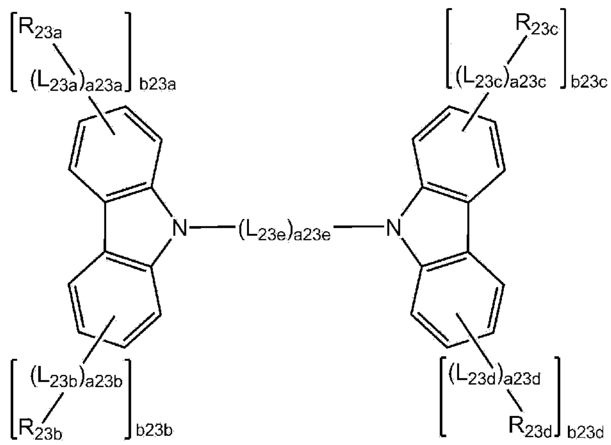

,

wherein, in Formulae 2-1 to 2-3,

$X_{21a}$ is selected from $N[(L_{21g})_{a21g}\text{-}R_{21f}]$, O, and S, and $X_{22a}$ is selected from $N[(L_{22f})_{a22f}\text{-}R_{22e}]$, O, and S, $L_{21a}$ to $L_{21g}$, $L_{22a}$ to $L_{22f}$, and $L_{23a}$ to $L_{23e}$ are each independently the same as described in connection with $L_{21}$

in Formula 2,
a21a to a21g, a22a to a22f, and a23a to a23e are each independently the same as described in connection with a21 in Formula 2,
$R_{21a}$ to $R_{21f}$, $R_{22a}$ to $R_{22e}$, and $R_{23a}$ to $R_{23d}$ are each independently the same as described in connection with $R_{21}$ in Formula 2,
b21b, b21e, b22a, b22c, b22d, and b23a to b23d are each independently the same as described in connection with b21 in Formula 2, and
b21c, b21d, and b22b are each independently the same as described in connection with b23 in Formula 2;
preferably wherein
$(L_{23e})_{a23e}$ is selected from Formulae 9-1 to 9-6:

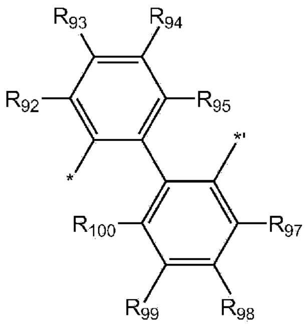
9-1

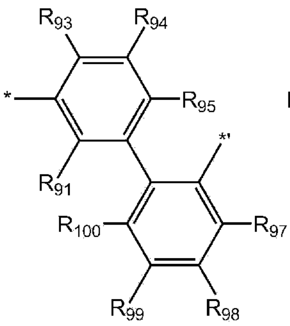
9-2

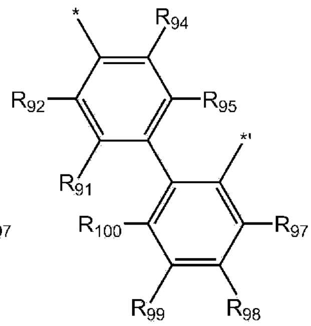
9-3

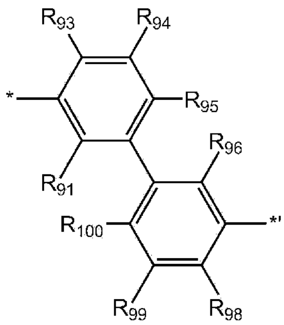
9-4

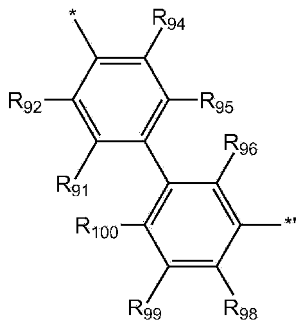
9-5

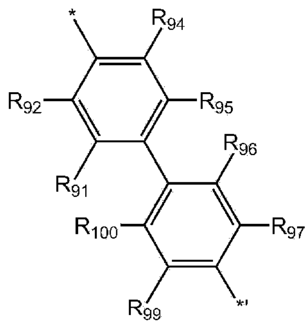
9-6

,

wherein, in Formulae 9-1 to 9-6,

$R_{91}$ to $R_{100}$ are each independently selected from hydrogen, deuterium, -F,-Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a biphenyl group, a terphenyl group, a $C_1$-$C_{60}$ heteroaryl group, a monovalent non-aromatic condensed polycyclic group, a monovalent non-aromatic condensed heteropolycyclic group, and -Si($Q_{31}$)($Q_{32}$)($Q_{33}$), and
$Q_{31}$ to $Q_{33}$ are each independently selected from hydrogen, a $C_1$-$C_{10}$ alkyl group, a $C_6$-$C_{30}$ aryl group, a biphenyl group, a terphenyl group, a $C_1$-$C_{30}$ heteroaryl group, a monovalent non-aromatic condensed polycyclic group, and a monovalent non-aromatic condensed heteropolycyclic group.

**8.** The composition of any of claims 1-7, wherein
the second compound is represented by one selected from Formulae 2-11, 2-21, and 2-31 to 2-33:

<Formula 2-11>

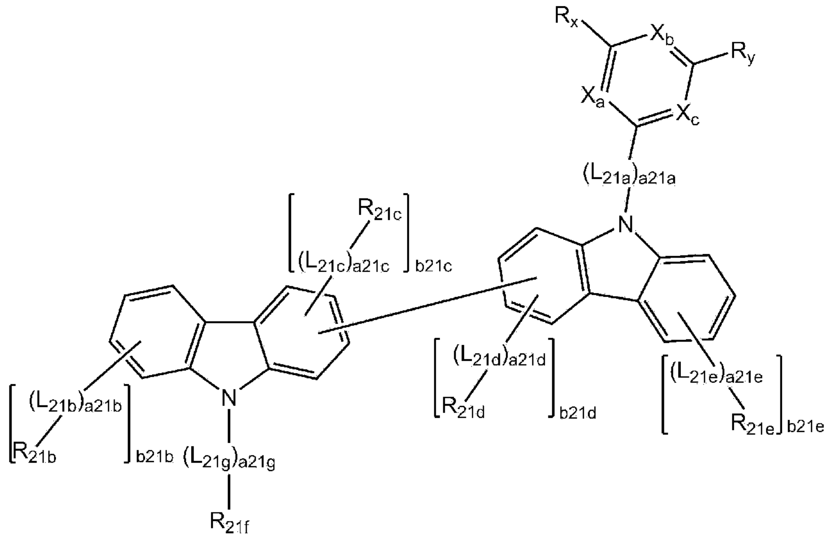

<Formula 2-21>

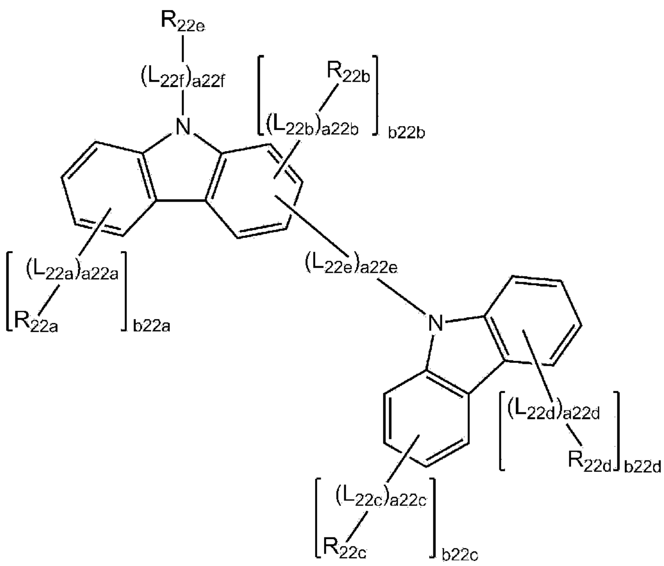

<Formula 2-31>

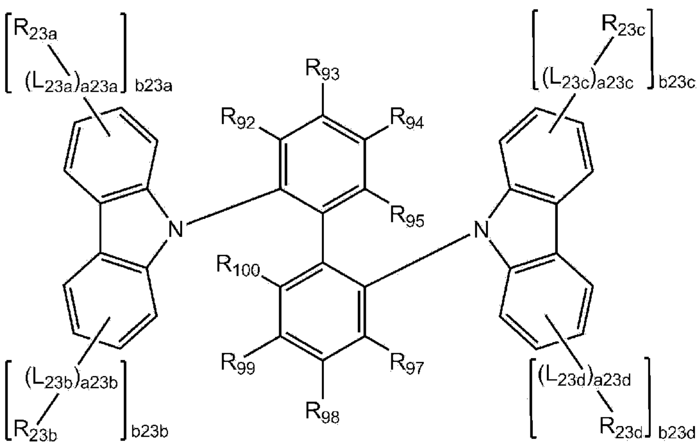

<Formula 2-32>

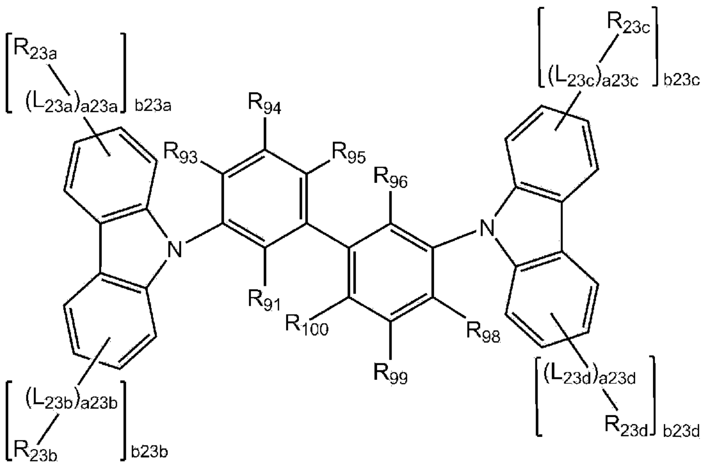

<Formula 2-33>

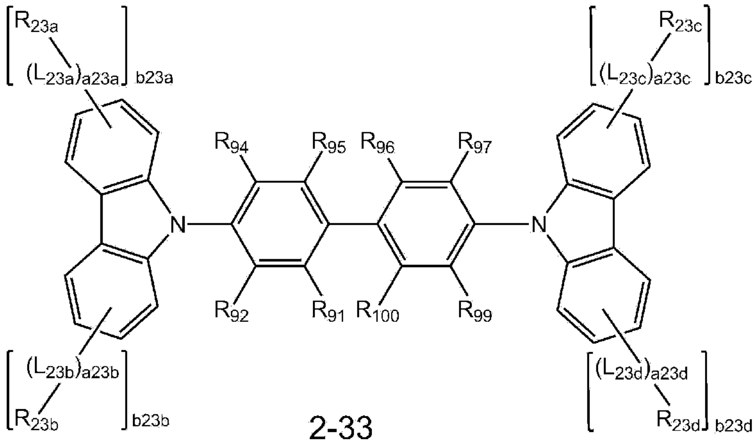

2-33

,

wherein, in Formulae 2-11, 2-21, and 2-31 to 2-33,

$X_a$, $X_b$, and $X_c$ are each independently selected from C and $N(R_z)$,
$X_a$, $X_b$, and $X_c$ are not $N(R_z)$ simultaneously,
$L_{21a}$ to $L_{21e}$, $L_{21g}$, $L_{22a}$ to $L_{22f}$, and $L_{23a}$ to $L_{23d}$ are each independently the same as described in connection with $L_{21}$ in Formula 2,
a21a to a21e, a21g, a22a to a22f, and a23a to a23d are each independently the same as described in connection with a21 in Formula 2,
$R_{21b}$ to $R_{21f}$, $R_{22a}$ to $R_{22e}$, and $R_{23a}$ to $R_{23d}$ are each independently the same as described in connection with $R_{21}$ in Formula 2,
b21b, b21e, b22a, b22c, b22d, and b23a to b23d are each independently the same as described in connection with b21 in Formula 2,
b21c, b21d, and b22b are each independently the same as described in connection with b23 in Formula 2, and
$R_{91}$ to $R_{100}$, $R_x$, $R_y$, and $R_z$ are each independently selected from hydrogen, deuterium, -F, -Cl, -Br, -I, a cyano group, a methyl group, an ethyl group, an n-propyl group, an isopropyl group, an n-butyl group, an isobutyl group, a sec-butyl group, a tert-butyl group, a phenyl group, a biphenyl group, a terphenyl group, a naphthyl group, a fluorenyl group, a pyridinyl group, a pyrazinyl group, a pyrimidinyl group, a quinolinyl group, an isoquinolinyl group, a carbazolyl group, a dibenzofuranyl group, and a dibenzothiophenyl group.

**9.** The composition of any of claims 1-8, wherein
the second compound is selected from Compounds H-1 to H-19:

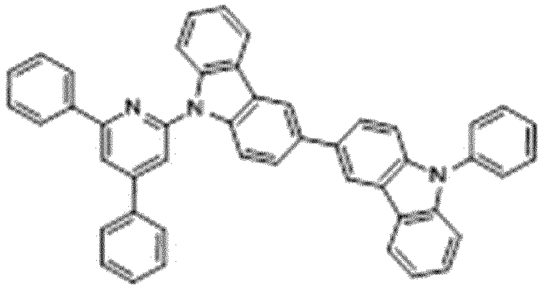

H-1

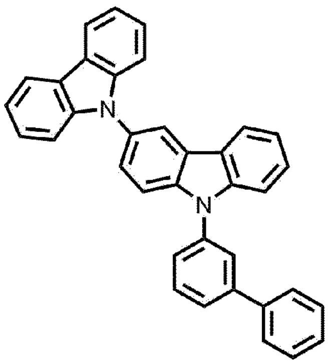

H-2

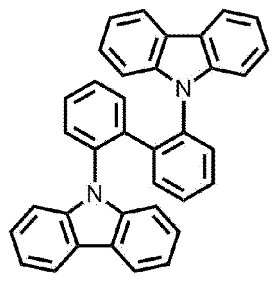

H-3

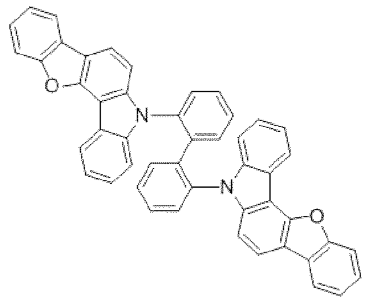

H-4

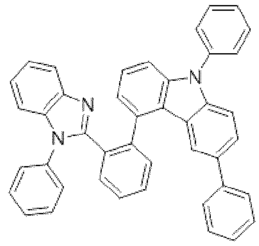

H-5

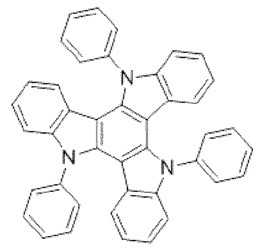

H-6

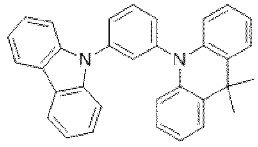

H-7

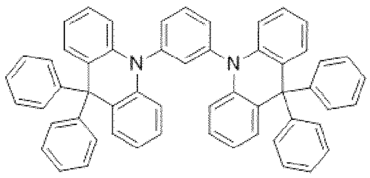

H-8

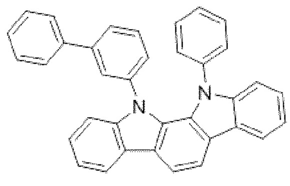

H-9

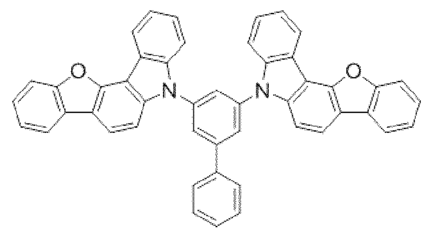

H-10

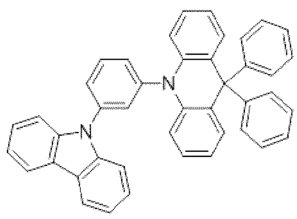

H-11

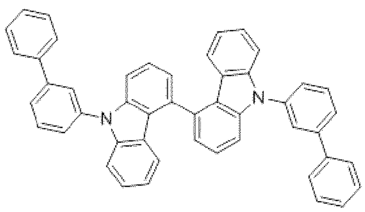

H-12

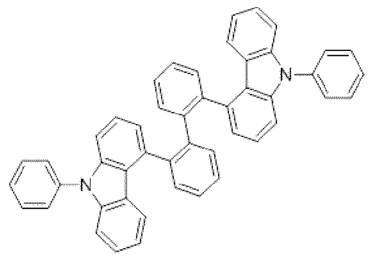

H-13

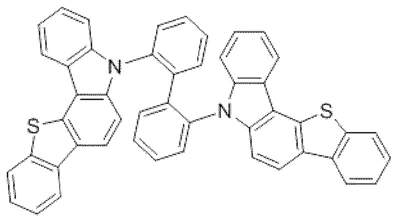

H-14

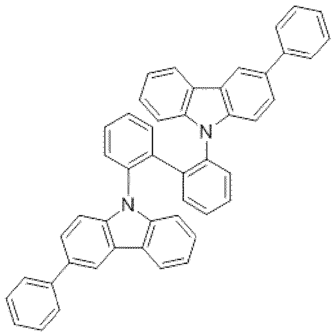

H-15

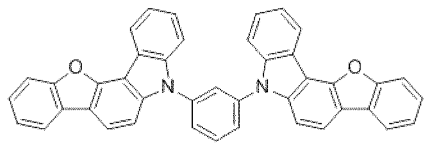

H-16

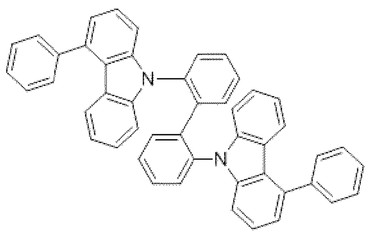

H-17

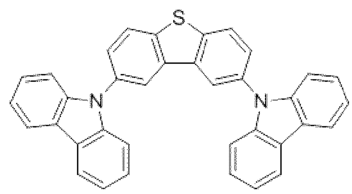

H-18

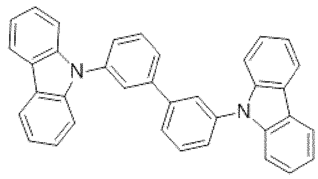

H-19

.

**10.** The composition of any of claims 1-9, wherein
the third compound emits delayed fluorescence; and/or
wherein
the third compound is represented by one selected from Formulae 3 and 4:

<Formula 3>

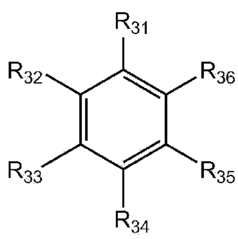

<Formula 12-1> <Formula 12-2>

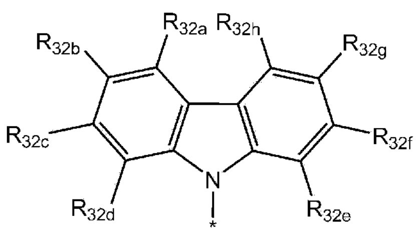

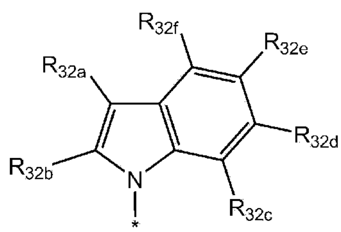

<Formula 4>

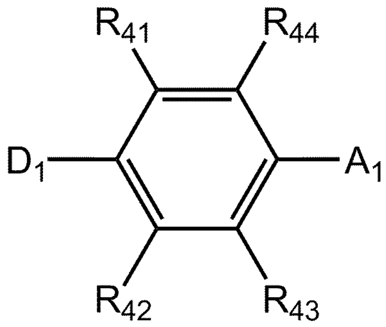

<Formula 13-1>

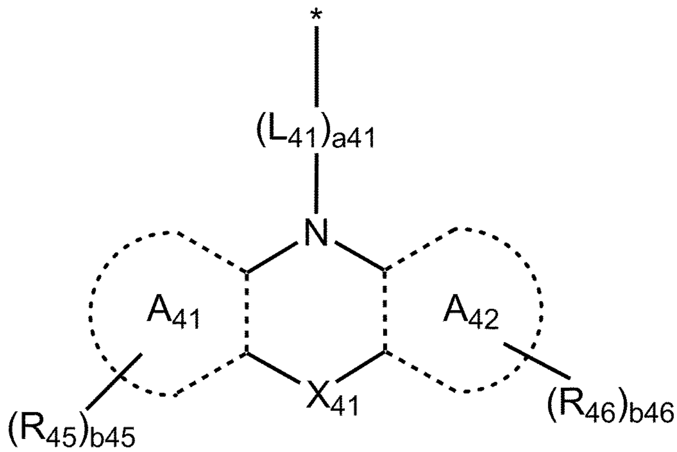

<Formula 14-1>

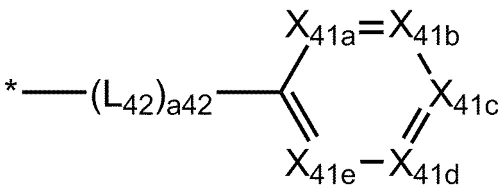

,

wherein, in Formulae 3, 4, 12-1, 12-2, 13-1, and 14-1,

$R_{31}$ to $R_{36}$ are each independently selected from a group represented by Formula 12-1, a group represented by Formula 12-2, hydrogen, deuterium, -F, -Cl,-Br, -I, a hydroxyl group, a cyano group, a substituted or unsubstituted $C_1$-$C_{60}$ alkyl group, a substituted or unsubstituted $C_1$-$C_{60}$ alkoxy group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, and a substituted or unsubstituted $C_1$-$C_{60}$ heteroaryl group,

at least one selected from $R_{31}$ to $R_{36}$ is a cyano group,

at least one selected from $R_{31}$ to $R_{36}$ is selected from a group represented by Formula 12-1 and a group represented by Formula 12-2,

$D_1$ is a group represented by Formula 13-1,

$A_1$ is a group represented by Formula 14-1,

$X_{41}$ is selected from a single bond, O, S, $N(R_{47})$, and $C(R_{47})(R_{48})$,

$A_{41}$ and $A_{42}$ are each independently selected from a benzene group, a fluorene group, a carbazole group, a dibenzofuran group, a dibenzothiophene group, an indolofluorene group, an indolocarbazole group, an indolodibenzofuran group, an indolodibenzothiophene group, an indenofluorene group, an indenocarbazole group, an

indenodibenzofuran group, an indenodibenzothiophene group, a benzofuranofluorene group, a benzofuranocarbazole group, a benzofuranodibenzofuran group, a benzofuranodibenzothiophene group, a benzothienofluorene group, a benzothienocarbazole group, a benzothienodibenzofuran group, and a benzothienodibenzothiophene group,

$L_{41}$ and $L_{42}$ are each independently selected from a substituted or unsubstituted $C_5$-$C_{30}$ carbocyclic group and a substituted or unsubstituted $C_1$-$C_{30}$ heterocyclic group,

a41 and a42 are each independently selected from 0, 1, 2, and 3,

$X_{41a}$ is N or C($R_{41a}$); $X_{41b}$ is N or C($R_{41b}$); $X_{41c}$ is N or C($R_{41c}$); $X_{41d}$ is N or C($R_{41d}$); and $X_{41e}$ is N or C($R_{41e}$), wherein at least one selected from $X_{41a}$ to $X_{41e}$ is N,

R32a to $R_{32h}$, $R_{41}$ to $R_{48}$, and $R_{41a}$ to $R_{41e}$ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -N($Q_4$)($Q_5$), and-B($Q_6$)($Q_7$),

b45 and b46 are independently selected from 1, 2, 3, 4, 5, 6, 7, and 8,

$Q_1$ to $Q_7$ are each independently selected from hydrogen, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group, and

* indicates a binding site to a neighboring atom.

**11.** The composition of claim 10, wherein
one, two, or three selected from $R_{31}$ to $R_{36}$ are a cyano group, and
one, two, three, four, or five selected from $R_{31}$ to $R_{36}$ are selected from a group represented by Formula 12-1 and a group represented by Formula 12-2; and/or
wherein
the third compound is represented by one selected from Formulae 3-1 to 3-5:

<Formula 3-1>

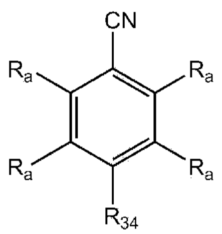

<Formula 3-2>

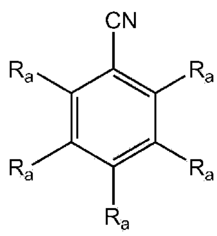

<Formula 3-3>

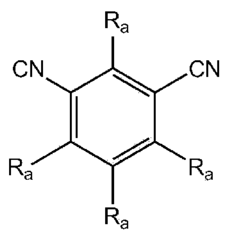

<Formula 3-4>

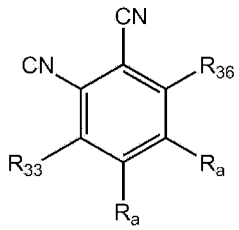

<Formula 3-5>

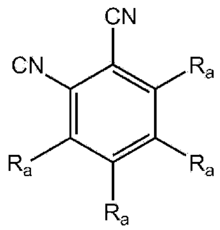

<Formula 12-11>

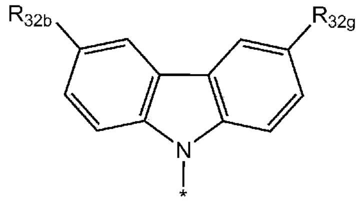

,

wherein, in Formulae 3-1 to 3-5 and 12-1 and 12-2,

$R_a$ is a group represented by Formula 12-11,
$R_{33}$, $R_{34}$, and $R_{36}$ are each independently selected from hydrogen, deuterium, -F, -Cl, -Br, -I, a hydroxyl group, a $C_1$-$C_{10}$ alkyl group, and a $C_1$-$C_{10}$ alkoxy group,
$R_{32b}$ and $R_{32g}$ are each independently selected from hydrogen, deuterium, -F, -Cl, -Br, -I, a hydroxyl group, a $C_1$-$C_{10}$ alkyl group, a $C_1$-$C_{10}$ alkoxy group, a $C_6$-$C_{30}$ aryl group, and a $C_1$-$C_{30}$ heteroaryl group, and
* indicates a binding site to a neighboring atom.

**12.** The composition of any of claims 1-11, wherein the third compound is selected from Compounds D-1 to D-23:

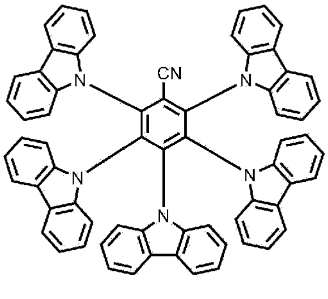

**D-1**

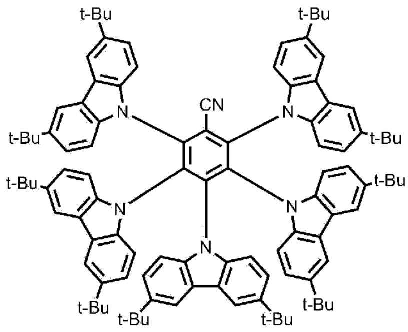

**D-2**

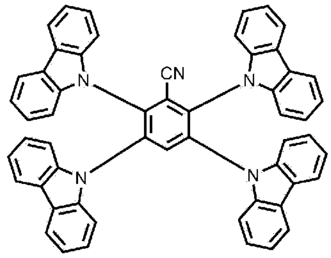

**D-3**

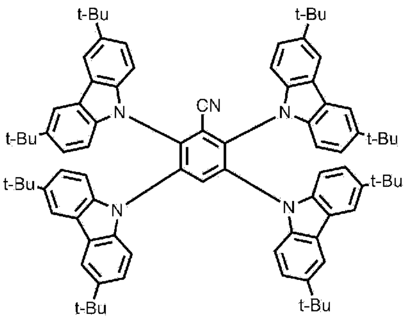

**D-4**

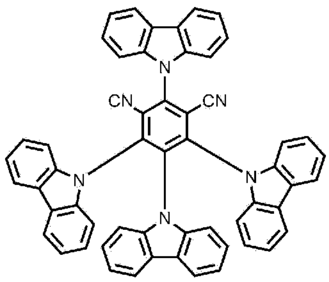

**D-5**

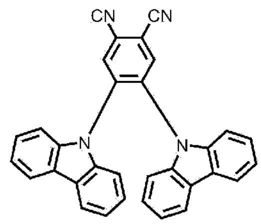

**D-6**

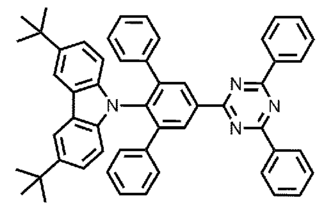
D-7

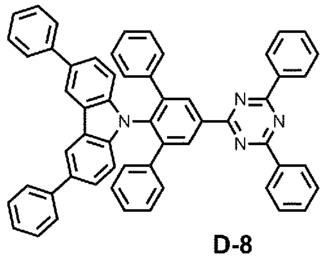
D-8

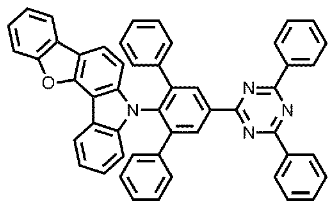
D-9

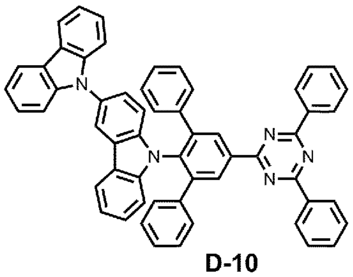
D-10

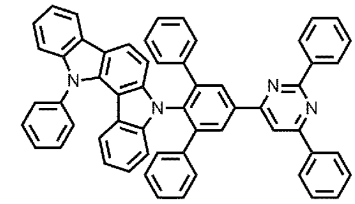
D-11

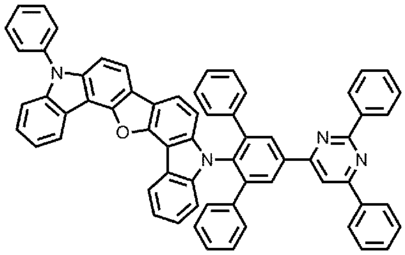
D-12

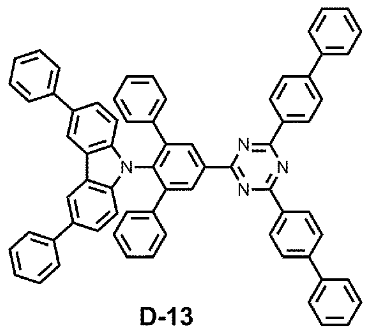
D-13

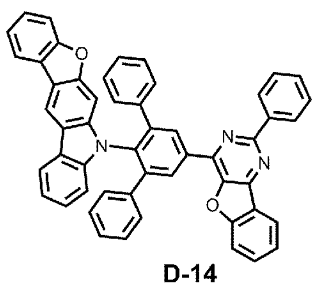
D-14

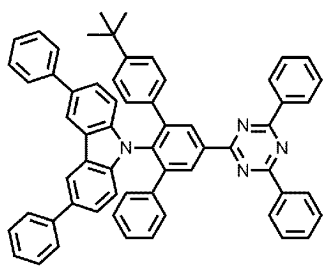
D-15

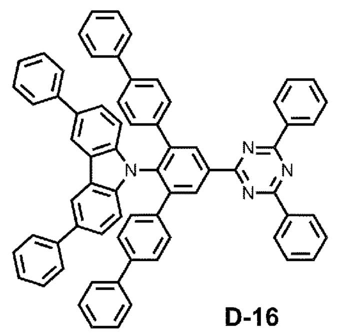
D-16

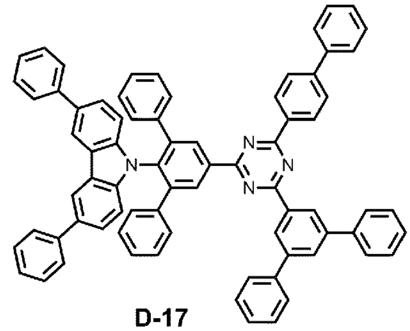
D-17

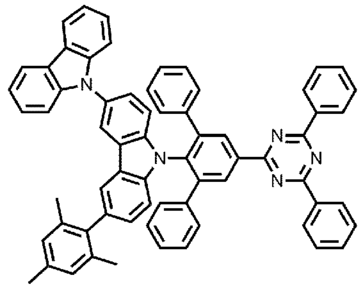
D-18

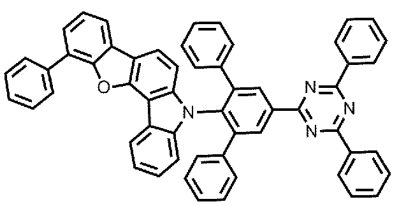
D-19

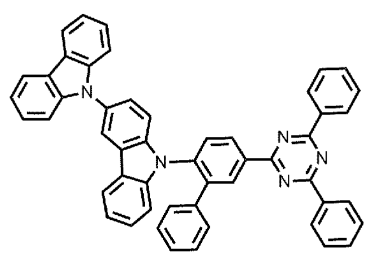
D-20

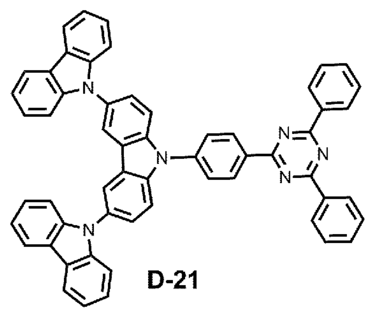
D-21

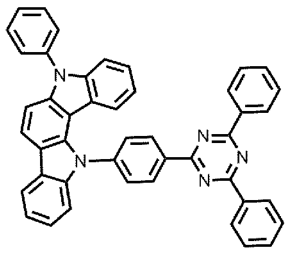

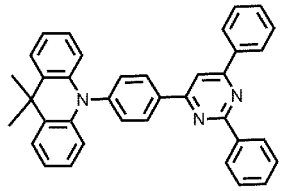

**D-22** **D-23**

**13.** The composition of any of claims 1-12, wherein the composition does not include a transition metal-containing organometallic compound.

**14.** A thin film comprising the composition of any of claims 1-13.

**15.** An organic light-emitting device comprising:

a first electrode,
a second electrode, and
an organic layer between the first electrode and the second electrode,
wherein the organic layer comprises the thin film of claim 14;
preferably wherein
the thin film is an emission layer.

**Patentansprüche**

**1.** Zusammensetzung, umfassend:

eine erste Verbindung, dargestellt durch Formel 1;
eine zweite Verbindung, dargestellt durch Formel 2;
eine dritte Verbindung, die Bedingung 1 erfüllt, und
die zweite Verbindung sich von der ersten Verbindung unterscheidet:

<Formel 1> $A_{11}\text{-}L_{11}\text{-}A_{12}$

<Formel 2> $A_{21}\text{-}(L_{21})_{a21}\text{-}A_{22}$

<Formel 10-1>

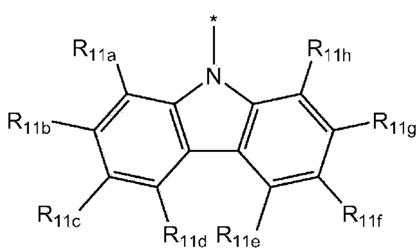

<Formel 10-2>

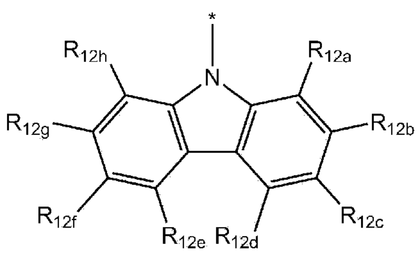

<Formel 11-1>

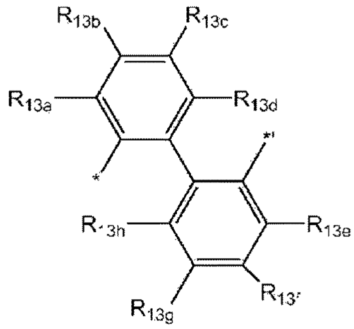

<Formel 11-2>

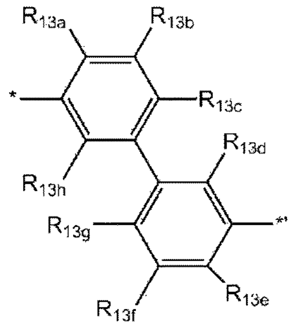

<Formel 11-3>

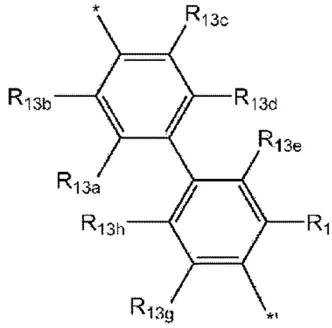

<Formel 20-1>

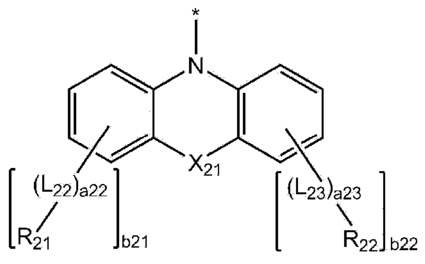

<Formel 20-2>

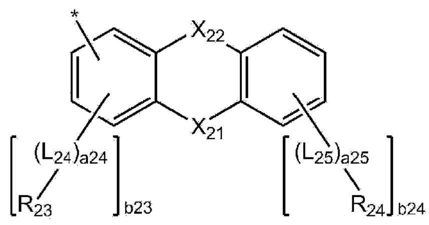

<Bedingung 1>

$$0 \text{ eV} \leq E_{S1}(C3) - E_{T1}(C3) \leq 0{,}3 \text{ eV},$$

wobei in Bedingung 1

$E_{S1}(C3)$ ein niedrigstes Singulett-Anregungs-Energieniveau der dritten Verbindung ist,
$E_{T1}(C3)$ ein niedrigstes Triplett-Anregungs-Energieniveau der dritten Verbindung ist und
$E_{S1}(C3)$ und $E_{T1}(C3)$ unter Verwendung eines DFT-Verfahrens bewertet werden, das bei einem Niveau von B3LYP/6-31G(d,p) strukturell optimiert ist, wobei in den Formeln 1 und 2,
$A_{11}$ eine Gruppe ist, dargestellt durch Formel 10-1,
$A_{12}$ eine Gruppe ist, dargestellt durch Formel 10-2,
$L_{11}$ eine Gruppe ist, dargestellt von einer der Formeln 11-1 bis 11-3,
$A_{21}$ eine Gruppe ist, dargestellt von einer der Formeln 20-1 und 20-2;
$A_{22}$ ausgewählt ist aus Gruppen, dargestellt durch die Formeln 20-1 und 20-2, einer Phenylgruppe, einer Naphthylgruppe und einer Benzimidazolylgruppe; und
wobei eine Phenylgruppe, eine Naphthylgruppe und eine Benzimidazolylgruppe jeweils mit zumindest einem ausgewählt aus Deuterium, einer Hydroxylgruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phophorsäuregruppe oder einem Salz davon, einer $C_1$-$C_{20}$-Alkylgruppe, einer $C_1$-$C_{20}$-Alkoxygruppe, einer Phenylgruppe, einer Naphthylgruppe, einer Fluorenylgruppe, einer Cabazolylgruppe, einer Dibenzofuranylgruppe und einer Dibenzothiophenylgruppe substituiert wird,
$X_{21}$ ausgewählt ist aus einer Einfachbindung, $C[(L_{27})_{a27}$-$R_{26}][(L_{28})_{a28}$-$R_{27}]$, O und S,
$X_{22}$ ausgewählt ist aus $N[(L_{26})_{a26}$-$R_{25}]$, $C[(L_{29})_{a29}$-$R_{28}][(L_{30})_{a30}$-$R_{29}]$, O und S,
$L_{21}$ bis $L_{30}$ jeweils unabhängig voneinander ausgewählt sind aus einer substituierten oder unsubstituierten $C_3$-$C_{10}$-Cycloalkylengruppe, einer substituierten oder unsubstituierten $C_1$-$C_{10}$-Heterocycloalkylengruppe, einer substituierten oder unsubstituierten $C_3$-$C_{10}$-Cycloalkenylengruppe, einer substituierten oder unsubstituierten $C_1$-$C_{10}$-Heterocycloalkenylengruppe, einer substituierten oder unsubstituierten $C_6$-$C_{60}$-Arylengruppe, einer substituierten oder unsubstituierten $C_1$-$C_{60}$-Heteroarylengruppe, einer substituierten oder unsubstituierten divalenten nicht aromatischen kondensierten polycyclischen Gruppe und einer substituierten oder unsubstituierten divalenten nicht aromatischen kondensierten heteropolycyclischen Gruppe,

a21 bis a30 jeweils unabhängig voneinander ausgewählt sind aus 0, 1, 2, 3, 4, und 5,

$R_{11a}$ bis $R_{11h}$, $R_{12a}$ bis $R_{12h}$, $R_{13a}$ bis $R_{13h}$ und $R_{21}$ bis $R_{29}$ jeweils unabhängig voneinander ausgewählt sind aus Wasserstoff, Deuterium, -F, -Cl, -Br, -I, einer Hydroxylgruppe, einer Cyanogruppe (CN), einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phophorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkinylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_1$-$C_{60}$-Heteroarylgruppe, einer substituierten oder unsubstituierten monovalenten nicht aromatischen kondensierten polycyclischen Gruppe, einer substituierten oder unsubstituierten monovalenten nicht aromatischen kondensierten heteropolycyclischen Gruppe, -Si($Q_1$)($Q_2$)($Q_3$), -N($Q_1$)($Q_2$), und -B($Q_1$)($Q_2$), wobei zwei oder mehr ausgewählt aus $R_{21}$ bis $R_{29}$ gegebenenfalls verbunden sind, um einen Ring zu bilden, wobei zumindest eines ausgewählt aus $R_{11a}$ bis $R_{11h}$, $R_{12a}$ bis $R_{12h}$ und $R_{13a}$ bis $R_{13h}$ eine Cyanogruppe ist,

b21, b22 und b24 jeweils unabhängig voneinander ausgewählt sind aus 1, 2, 3 und 4, b23 ausgewählt ist aus 1, 2 und 3,

$Q_1$ bis $Q_3$ jeweils unabhängig voneinander ausgewählt sind aus Wasserstoff, Deuterium,-F, -Cl, - Br, -I, einer Hydroxylgruppe, einer Cyanogruppe, einer Nitrogruppe, einer Amidinogruppe, einer Hydrazingruppe, einer Hydrazongruppe, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_1$-$C_{60}$-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe, und

*und *' jeweils eine Bindungsstelle zu einem benachbarten Atom anzeigt.

**2.** Zusammensetzung nach Anspruch 1, wobei eines, zwei oder drei ausgewählt aus $R_{11a}$ bis $R_{11h}$, $R_{12a}$ bis $R_{12h}$ und $R_{13a}$ bis $R_{13h}$ eine Cyanogruppe ist/sind; und/oder
wobei
$R_{11a}$ bis $R_{11h}$, $R_{12a}$ bis $R_{12h}$ und $R_{13a}$ bis $R_{13h}$ jeweils unabhängig voneinander ausgewählt sind aus:

Wasserstoff, Deuterium, einer Cyanogruppe, einer $C_1$-$C_{10}$-Alkylgruppe und einer $C_1$-$C_{10}$-Alkoxygruppe,
wobei eine $C_1$-$C_{10}$-Alkylgruppe und eine $C_1$-$C_{10}$-Alkoxygruppe jeweils mit zumindest einem ausgewählt aus Deuterium und einer Cyanogruppe,
einer Phenylgruppe, einer Biphenylgruppe, einer Terphenylgruppe, einer Naphthylgruppe, einer Fluorenylgruppe, einer Pyridinylgruppe, einer Pyrazinylgruppe, einer Pyrimidinylgruppe, einer Carbazolylgruppe, einer Dibenzofuranylgruppe und einer Dibenzothiophenylgruppe substituiert wird, und
wobei eine Phenylgruppe, eine Biphenylgruppe, eine Terphenylgruppe, eine Naphthylgruppe, eine Fluorenylgruppe, eine Pyridinylgruppe, eine Carbazolylgruppe, eine Dibenzofuranylgruppe und eine Dibenzothiophenylgruppe jeweils mit zumindest einem ausgewählt aus Deuterium, einer Cyanogruppe, einer $C_1$-$C_{10}$-Alkylgruppe, einer $C_1$-$C_{10}$-Alkoxygruppe, einer Phenylgruppe, einer Biphenylgruppe, einer Terphenylgruppe, einer Naphthylgruppe, einer Fluorenylgruppe, einer Pyridinylgruppe, einer Pyrazinylgruppe, einer Pyrimidinylgruppe, einer Carbazolylgruppe, einer Dibenzofuranylgruppe und einer Dibenzothiophenylgruppe substituiert wird.

**3.** Zusammensetzung nach Anspruch 1 oder 2, wobei $A_{11}$ durch Formel 10-11 dargestellt wird und $A_{12}$ durch Formel 10-21 dargestellt wird und $L_{11}$ durch eine ausgewählt aus den Formeln 11-15 bis 11-22, 11-27 bis 11- 34 und 11-37 bis 11-40 dargestellt wird;
$A_{11}$ durch eine ausgewählt aus den Formeln 10-12 und 10-13 dargestellt wird und $A_{12}$ durch eine ausgewählt aus den Formeln 10-21 bis 10-23 dargestellt wird und $L_{11}$ durch eine ausgewählt aus den Formeln 11-11 bis 11-40 dargestellt wird; oder
$A_{11}$ durch Formel 10-11 dargestellt wird, $A_{12}$ durch eine ausgewählt aus den Formeln 10-22 und 10-23 dargestellt wird und $L_{11}$ durch eine ausgewählt aus den Formeln 11-11 bis 11-40 dargestellt wird:

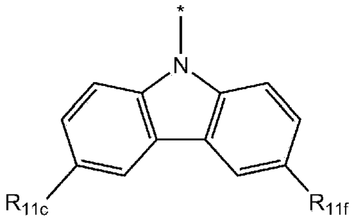
10-11

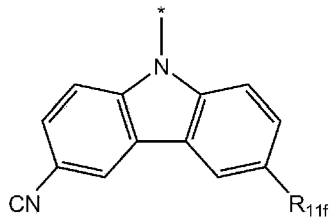
10-12

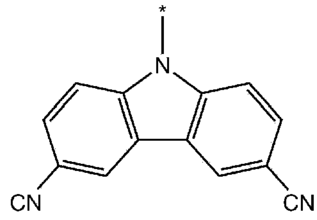
10-13

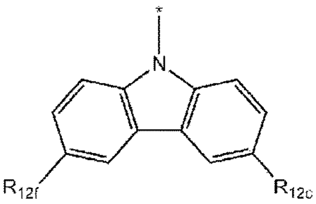
10-21

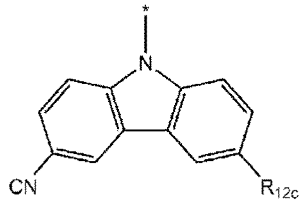
10-22

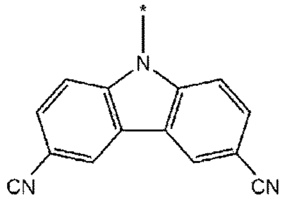
10-23

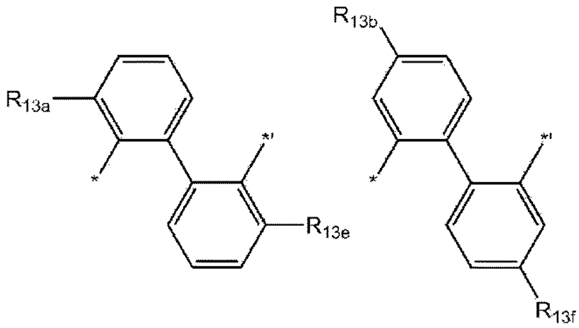
11-11

11-12

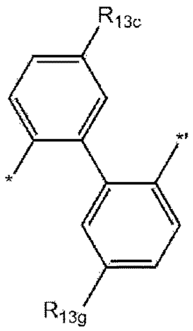
11-13

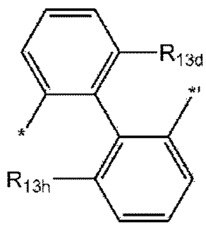
11-14

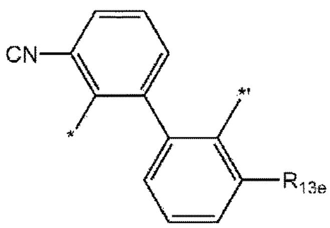
11-15

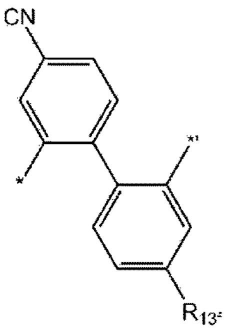
11-16

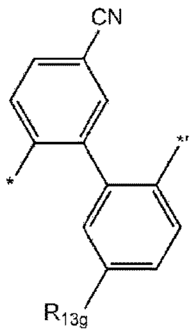
11-17

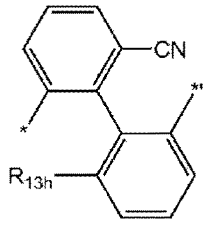
11-18

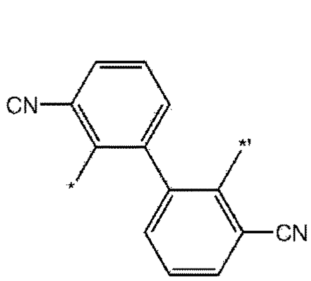

11-19

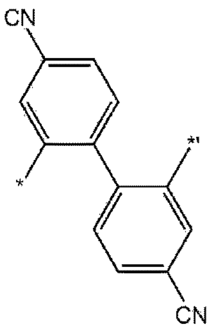

11-20

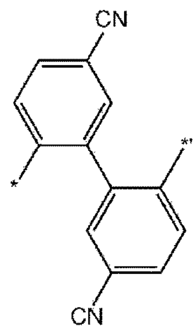

11-21

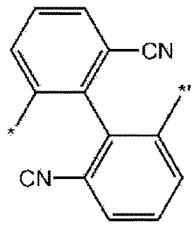

11-22

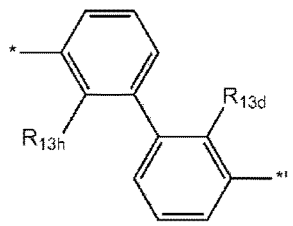

11-23

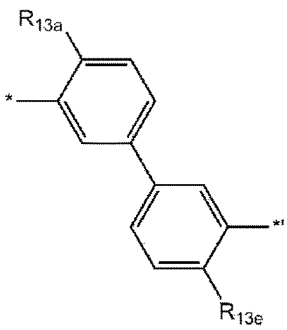

11-24

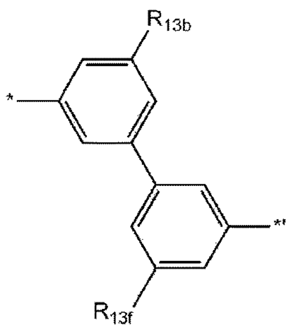

11-25

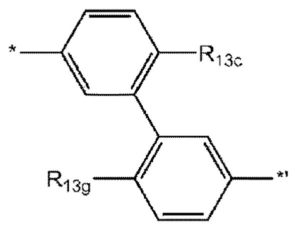

11-26

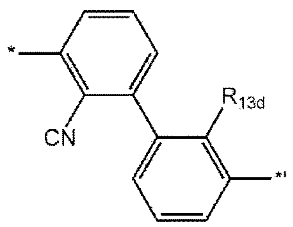

11-27

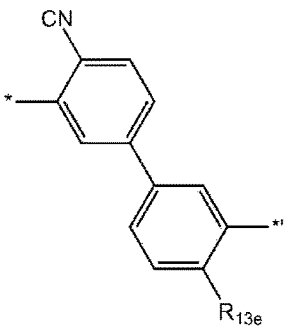

11-28

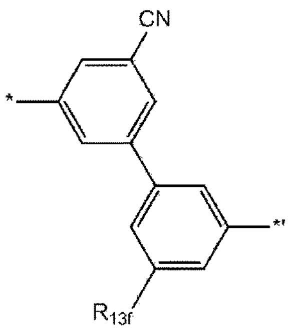

11-29

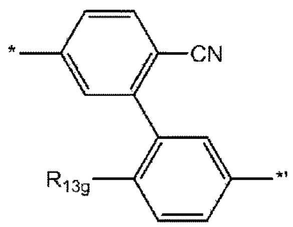

11-30

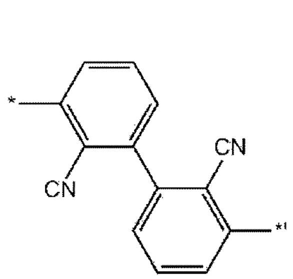

11-31

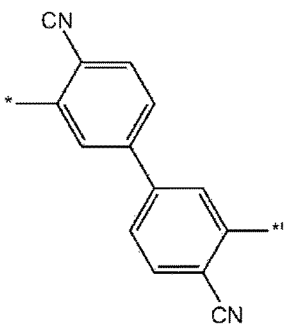

11-32

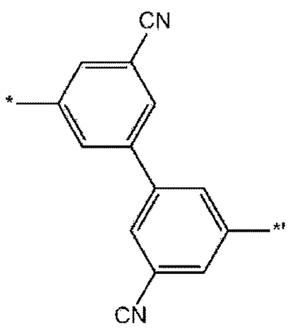

11-33

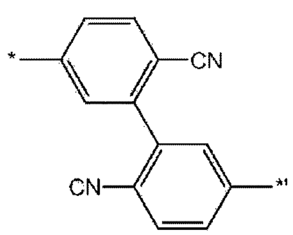

11-34

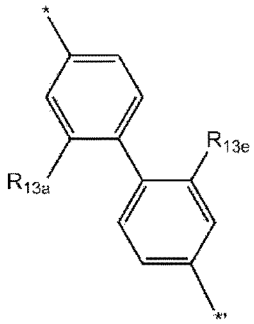
11-35

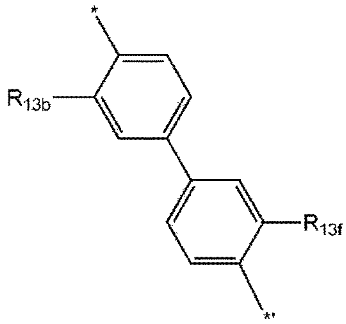
11-36

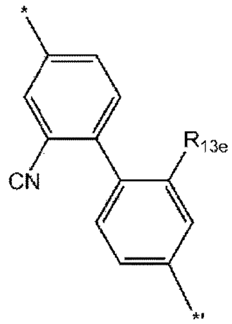
11-37

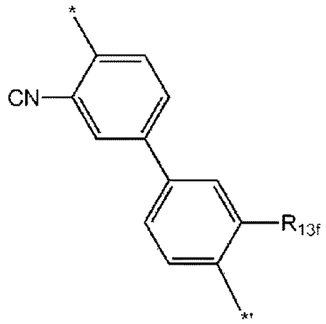
11-38

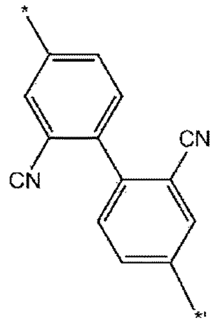
11-39

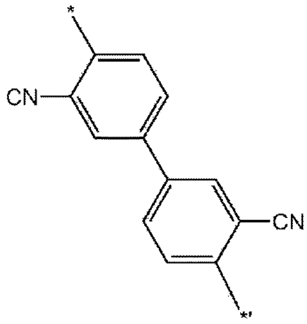
11-40

,

wobei in den Formeln 10-11 bis 10-13, 10-21 bis 10-23 und 11-11 bis 11-40

$R_{11c}$, $R_{11f}$, $R_{12c}$, $R_{12f}$ und $R_{13a}$ bis $R_{13f}$ jeweils unabhängig voneinander ausgewählt sind aus: Wasserstoff, Deuterium, einer $C_1$-$C_{10}$-Alkylgruppe, einer $C_1$-$C_{10}$-Alkoxygruppe, einer Phenylgruppe, einer Biphenylgruppe, einer Terphenylgruppe, einer Naphthylgruppe, einer Fluorenylgruppe, einer Pyridinylgruppe, einer Pyrazinylgruppe, einer Pyrimidinylgruppe, einer Carbazolylgruppe, einer Dibenzofuranylgruppe und einer Dibenzothiophenylgruppe;
wobei eine $C_1$-$C_{10}$-Alkylguppe und eine $C_1$-$C_{10}$-Alkoxygruppe jeweils mit Deuterium substituiert wird; und
wobei eine Phenylgruppe, eine Biphenylgruppe, eine Terphenylgruppe, eine Naphthylgruppe, eine Fluorenylgruppe, eine Pyridinylgruppe, eine Pyrazinylgruppe, eine Pyrimidinylgruppe, eine Carbazolylgruppe, eine Dibenzofuranylgruppe und eine Dibenzothiophenylgruppe jeweils mit zumindest einem ausgewählt aus Deuterium, einer $C_1$-$C_{10}$-Alkylgruppe, einer $C_1$-$C_{10}$-Alkoxygruppe, einer Phenylgruppe, einer Biphenylgruppe, einer Terphenylgruppe, einer Naphthylgruppe, einer Fluorenylgruppe, einer Pyridinylgruppe, einer Pyrazinylgruppe, einer Pyrimidinylgruppe, einer Carbazolylgruppe, einer Dibenzofuranylgruppe und einer Dibenzothiophenylgruppe substituiert wird, und
*und *' jeweils eine Bindungsstelle zu einem benachbarten Atom anzeigt.

**4.** Zusammensetzung nach einem der Ansprüche 1 - 3, wobei die erste Verbindung ausgewählt ist aus den Verbindungen E-1 bis E-20:

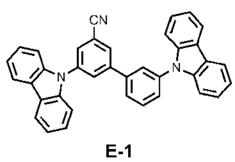
**E-1**

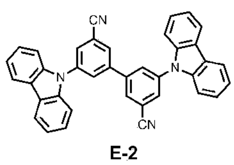
**E-2**

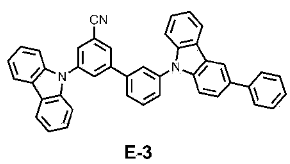
**E-3**

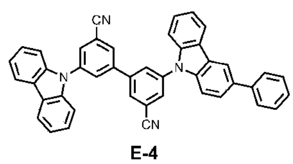
**E-4**

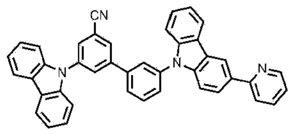
E-5

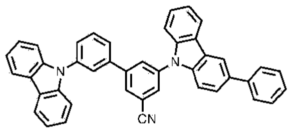
E-6

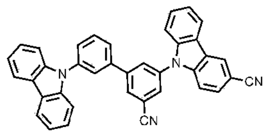
E-7

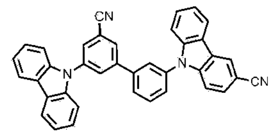
E-8

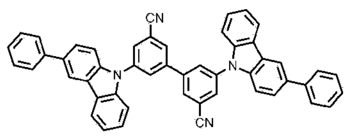
E-9

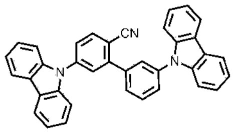
E-10

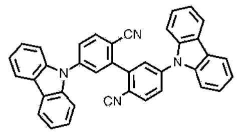
E-11

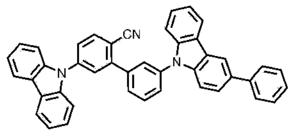
E-12

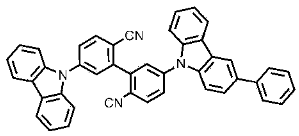
E-13

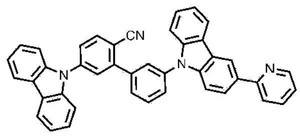
E-14

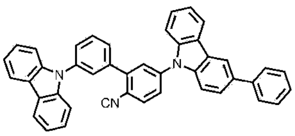
E-15

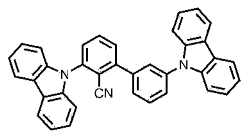
E-16

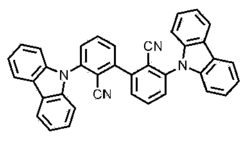
E-17

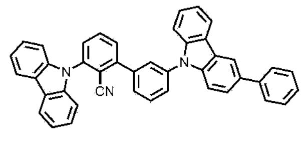
E-18

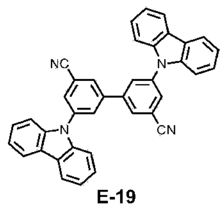
E-19

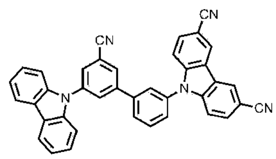
E-20

.

**5.** Zusammensetzung nach einem der Ansprüche 1 - 4, wobei
$A_{21}$ und $A_{22}$ jeweils unabhängig voneinander durch Formel 20-1 dargestellt werden,
$A_{21}$ durch Formel 20-1 dargestellt wird und $A_{22}$ durch Formel 20-2 dargestellt wird, oder
$A_{21}$ und $A_{22}$ jeweils unabhängig voneinander durch Formel 20-2 dargestellt werden; und/oder wobei
$X_{21}$ eine Einfachbindung ist, und
$X_{22}$ ausgewählt ist aus $N(R_{25})$, $C(R_{28})(R_{29})$, O und S.

**6.** Zusammensetzung nach einem der Ansprüche 1 - 5, wobei $R_{21}$ bis $R_{29}$ jeweils unabhängig voneinander ausgewählt sind aus:

Wasserstoff, Deuterium, -F, -Cl, -Br, -I, einer Cyanogruppe, einer $C_1$-$C_{10}$ -Alkylgruppe, einer $C_1$-$C_{10}$-Alkoxygruppe, einer $C_3$-$C_{10}$-Cycloalkylgruppe und einer $C_1$-$C_{10}$-Heterocycloalky lgruppe;
wobei eine $C_1$-$C_{10}$-Alkylgruppe, eine $C_1$-$C_{10}$-Alkoxygruppe, eine $C_3$-$C_{10}$-Cycloalkylgruppe und eine $C_1$-$C_{10}$-Heterocycloalkylgruppe jeweils mit zumindest einem ausgewählt aus Deuterium, -F, -Cl, -Br, -I und einer Cyanogruppe,
einer $C_6$-$C_{30}$-Arylgruppe, einer Biphenylgruppe, einer Terphenylgruppe, einer $C_6$-$C_{30}$-Aryloxygruppe, einer $C_6$-$C_{30}$-Arylthiogruppe, einer $C_1$-$C_{30}$-Heteroarylgruppe, einer monovalenten nicht aromatischen kondensierten polycyclischen Gruppe und einer monovalenten nicht aromatischen kondensierten heteropolycyclischen Gruppe substituiert wird,
wobei eine $C_6$-$C_{30}$-Arylgruppe, eine Biphenylgruppe, eine Terphenylgruppe, einer $C_6$-$C_{30}$-Aryloxygruppe, eine $C_6$-$C_{30}$-Arylthiogruppe, eine $C_1$-$C_{30}$-Heteroarylgruppe, eine monovalente nicht aromatische kondensierte polycyclische Gruppe und eine monovalente nicht aromatische kondensierte heteropolycyclische Gruppe j eweils mit zumindest einem ausgewählt aus Deuterium, -F, -Cl, -Br, -I, einer Cyanogruppe, einer $C_1$-$C_{10}$-Alkylgruppe, einer $C_1$-$C_{10}$-Alkoxygruppe, einer $C_3$-$C_{10}$-Cycloalkylgruppe, einer $C_1$-$C_{10}$-Heterocycloalkylgruppe, einer $C_6$-$C_{30}$-Arylgruppe, einer Biphenylgruppe, einer Terphenylgruppe, einer $C_6$-$C_{30}$-Aryloxygruppe, einer $C_6$-$C_{30}$-Arylthiogruppe, einer $C_1$-$C_{30}$-Heteroarylgruppe, einer monovalenten nicht aromatischen kondensierten polycyclischen Gruppe und einer monovalenten nicht aromatischen kondensierten heteropolycyclischen Gruppe und $-Si(Q_1)(Q_2)(Q_3)$, $-N(Q_1)(Q_2)$, und $-B(Q_1)(Q_2)$ substituiert wird, wobei zwei oder mehr ausgewählt aus $R_{21}$

bis $R_{29}$ gegebenenfalls verbunden sind, um einen Ring zu bilden, und wobei $Q_1$ bis $Q_3$ jeweils unabhängig voneinander ausgewählt sind aus Wasserstoff, einer $C_1$-$C_{10}$-Alkylgruppe, einer $C_6$-$C_{30}$-Arylgruppe, einer Biphenylgruppe, einer Terphenylgruppe, einer $C_1$-$C_{30}$-Heteroarylgruppe, einer monovalenten nicht aromatischen kondensierten polycyclischen Gruppe und einer monovalenten nicht aromatischen kondensierten heteropolycyclischen Gruppe; und/oder wobei
die Gruppe, dargestellt durch Formel 20-2 eine Gruppe ist, die durch eine ausgewählt aus den Formeln 20-21 bis 20-24 dargestellt ist:

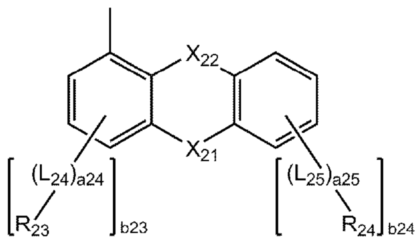

20-21

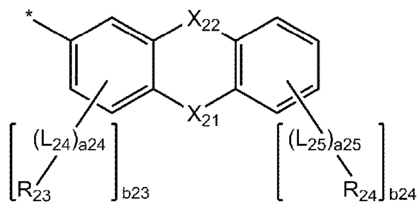

20-22

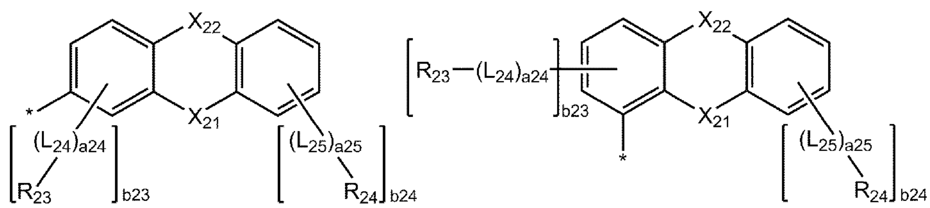

20-23

20-24

wobei in den Formeln 20-21 bis 20-24

$X_{21}$, $X_{22}$, $L_{24}$, $L_{25}$, a24, a25, $R_{23}$, $R_{24}$, b23 und b24 jeweils unabhängig voneinander dieselben, wie in Formel 20-2 definiert sind, und
* eine Bindungsstelle zu einem benachbarten Atom anzeigt.

**7.** Zusammensetzung nach einem der Ansprüche 1 - 6, wobei die zweite Verbindung durch eine der Formeln 2-1 bis 2-3 dargestellt wird:

<Formel 2-1>

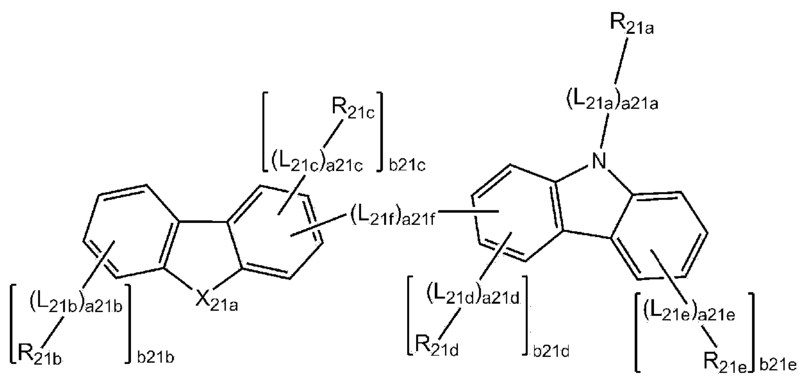

<Formel 2-2>

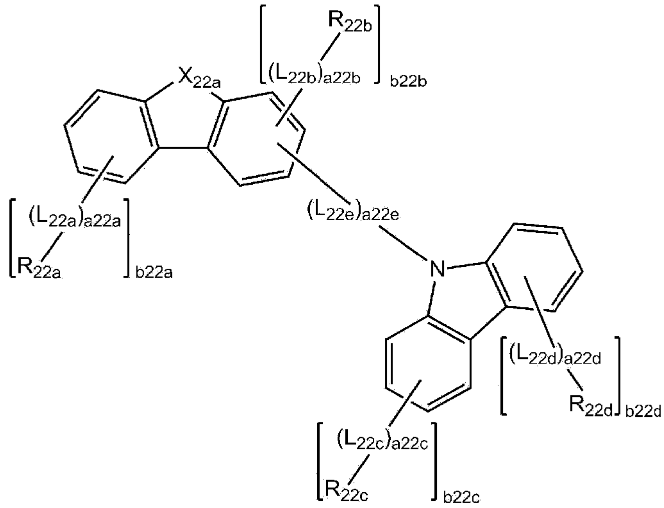

<Formel 2-3>

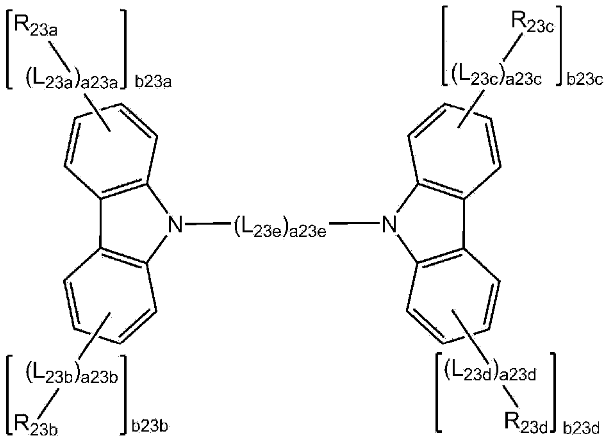

,

wobei in den Formeln 2-1 bis 2-3

$X_{21a}$ ausgewählt ist aus $N[(L_{21g})_{a21g}$-$R_{21f}]$, O und S, und $X_{22a}$ ausgewählt ist aus $N[(L_{22f})_{a22f}$-$R_{22e}]$, O und S,
$L_{21a}$ bis $L_{21g}$, $L_{22a}$ bis $L_{22f}$ und $L_{23a}$ bis $L_{23e}$ jeweils unabhängig voneinander dieselben wie im Hinblick auf $L_{21}$ in Formel 2 beschrieben sind,
a21a bis a21g, a22a bis a22f und a23a bis a23e jeweils unabhängig voneinander dieselben wie im Hinblick auf a21 in Formel 2 beschrieben sind,
$R_{21a}$ bis $R_{21f}$, $R_{22a}$ bis $R_{22e}$ und $R_{23a}$ bis $R_{23d}$ jeweils unabhängig voneinander dieselben wie im Hinblick auf $R_{21}$ in Formel 2 beschrieben sind,
b21b, b21e, b22a, b22c, b22d und b23a bis b23d jeweils unabhängig voneinander dieselben wie im Hinblick auf b21 in Formel 2 beschrieben sind, und
b21c, b21d und b22b jeweils unabhängig voneinander dieselben wie im Hinblick auf b23 in Formel 2 beschrieben sind;
wobei vorzugsweise
$(L_{23e})_{a23e}$ ausgewählt ist aus den Formeln 9-1 bis 9-6:

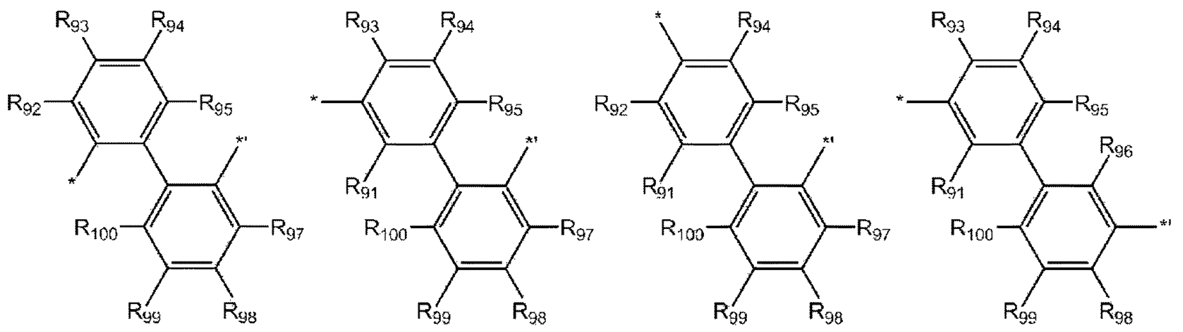

9-1 9-2 9-3 9-4

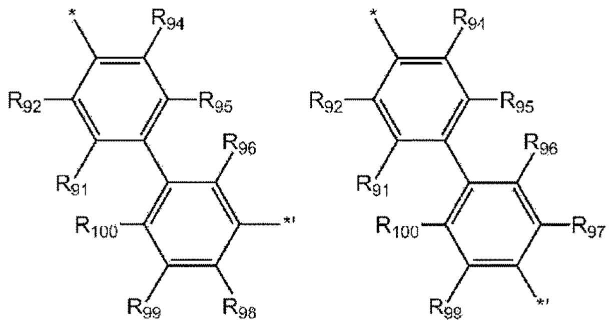

9-5 9-6

,

wobei in den Formeln 9-1 bis 9-6

$R_{91}$ bis $R_{100}$ jeweils unabhängig voneinander ausgewählt sind aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer Biphenylgruppe, einer Terphenylgruppe, einer $C_1$-$C_{60}$-Heteroarylgruppe, einer monovalenten nicht aromatischen kondensierten polycyclischen Gruppe, einer monovalenten nicht aromatischen kondensierten heteropolycyclischen Gruppe und -Si($Q_{31}$)($Q_{32}$)($Q_{33}$), und
wobei $Q_{31}$ bis $Q_{33}$ jeweils unabhängig voneinander ausgewählt sind aus Wasserstoff, einer $C_1$-$C_{10}$-Alkylgruppe, einer $C_6$-$C_{30}$-Arylgruppe, einer Biphenylgruppe, einer Terphenylgruppe, einer $C_1$-$C_{30}$-Heteroarylgruppe, einer monovalenten nicht aromatischen kondensierten polycyclischen Gruppe und einer monovalenten nicht aromatischen kondensierten heteropolycyclischen Gruppe.

**8.** Zusammensetzung nach einem der Ansprüche 1 - 7, wobei die zweite Verbindung durch eine ausgewählt aus den Formeln 2-11, 2-21 und 2-31 bis 2-33 dargestellt wird:

<Formel 2-11>

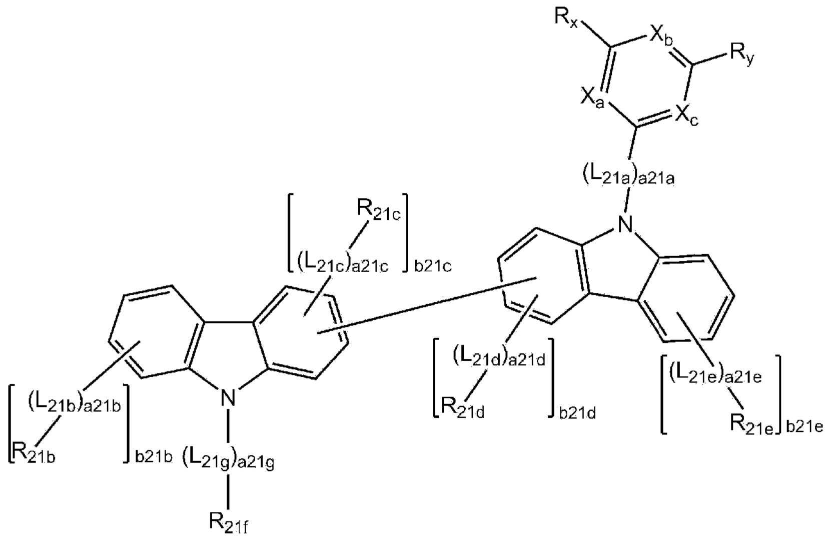

<Formel 2-21>

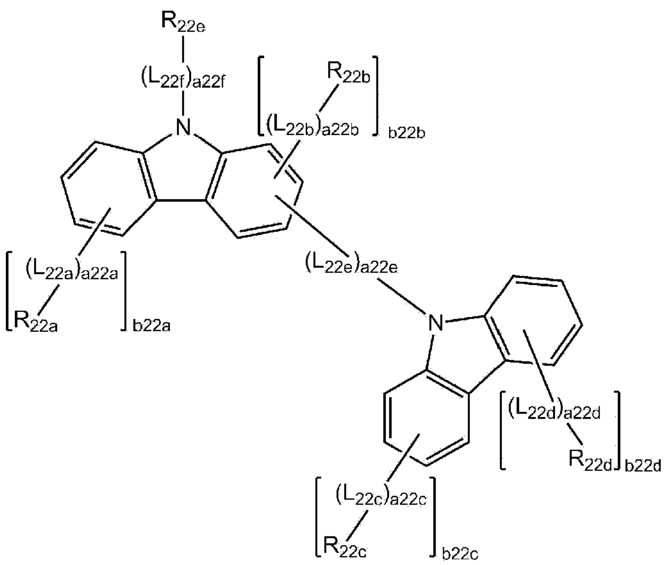

<Formel 2-31>

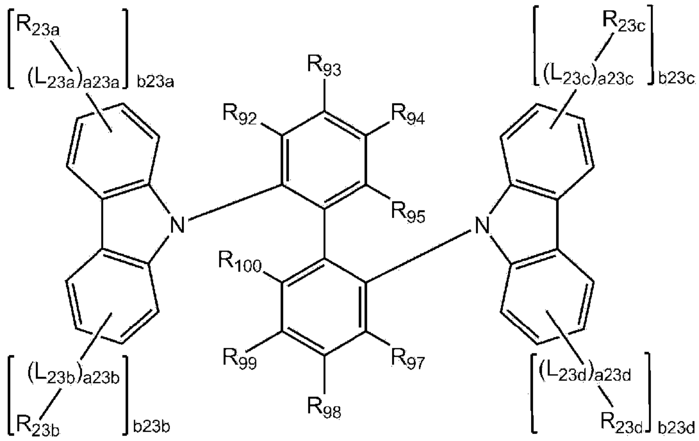

<Formel 2-32>

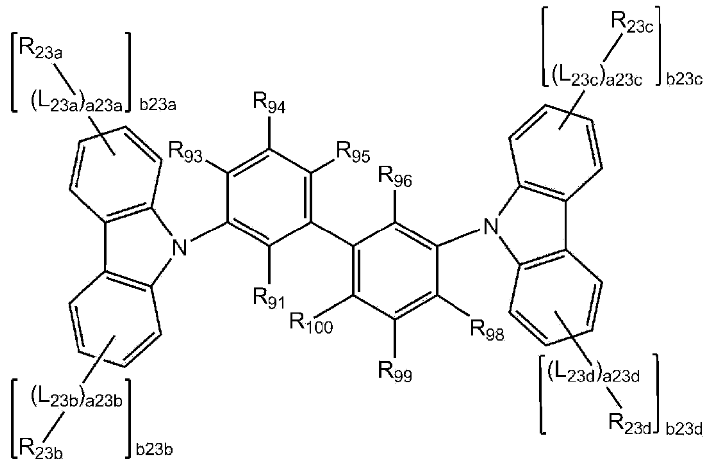

<Formel 2-33>

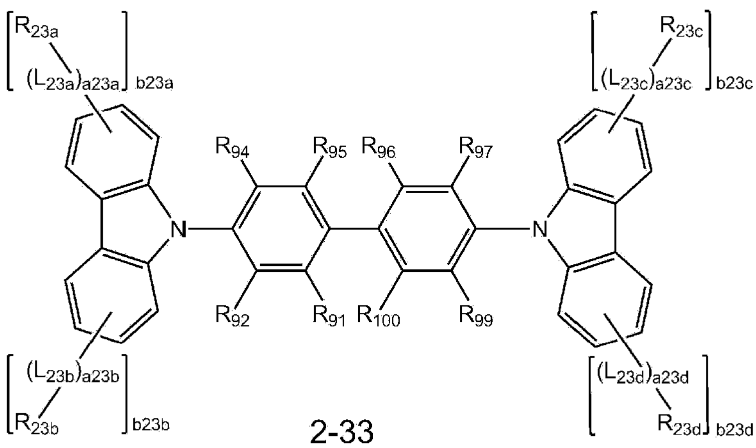

2-33

,

wobei in den Formeln 2-11, 2-21 und 2-31 bis 2-33

$X_a$, $X_b$, und $X_c$ jeweils unabhängig voneinander ausgewählt sind aus C und $N(R_z)$,

$X_a$, $X_b$, und $X_c$ nicht gleichzeitig $N(R_z)$ sind,
$L_{21a}$ bis $L_{21e}$, $L_{21g}$, $L_{22a}$ bis $L_{22f}$ und $L_{23a}$ bis $L_{23d}$ jeweils unabhängig voneinander dieselben wie im Hinblick auf $L_{21}$ in Formel 2 beschrieben sind,
a21a bis a21e, a21g, a22a bis a22f und a23a bis a23d jeweils unabhängig voneinander dieselben wie im Hinblick auf a21 in Formel 2 beschrieben sind,
$R_{21b}$ bis $R_{21f}$, $R_{22a}$ bis $R_{22e}$ und $R_{23a}$ bis $R_{23d}$ jeweils unabhängig voneinander dieselben wie im Hinblick auf $R_{21}$ in Formel 2 beschrieben sind,
b21b, b21e, b22a, b22c, b22d und b23a bis b23d jeweils unabhängig voneinander dieselben wie im Hinblick auf b21 in Formel 2 beschrieben sind,
b21c, b21d und b22b jeweils unabhängig voneinander dieselben wie im Hinblick auf b23 in Formel 2 beschrieben sind, und $R_{91}$ bis $R_{100}$, $R_x$, $R_y$ und $R_z$ jeweils unabhängig ausgewählt sind aus Wasserstoff, Deuterium, -F, -Cl, -Br, -I, einer Cyanogruppe, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer Phenylgruppe, einer Biphenylgruppe, einer Terphenylgruppe, einer Naphthylgruppe, einer Fluorenylgruppe, einer Pyridinylgruppe, einer Pyrazinylgruppe, einer Pyrimidinylgruppe, einer Chinolinylgruppe, einer Isochinolinylgruppe, einer Carbazolylgruppe, einer Dibenzofuranylgruppe und einer Dibenzothiophenylgruppe.

**9.** Zusammensetzung nach einem der Ansprüche 1 - 8, wobei die zweite Verbindung ausgewählt ist aus den Verbindungen H-1 bis H-19:

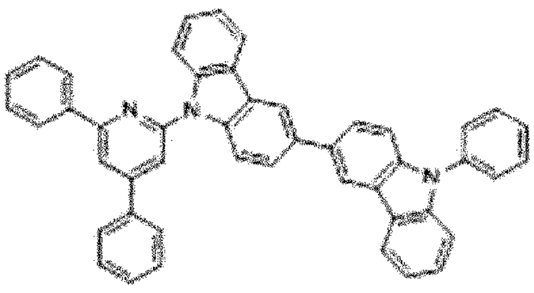

H-1

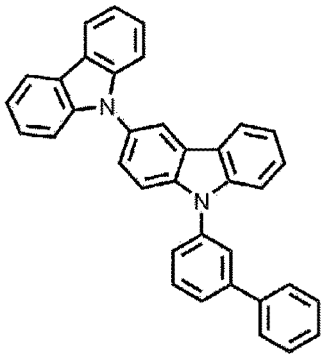

H-2

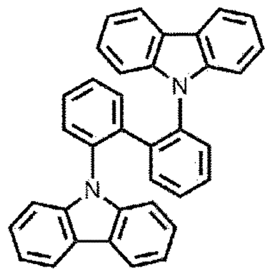

H-3

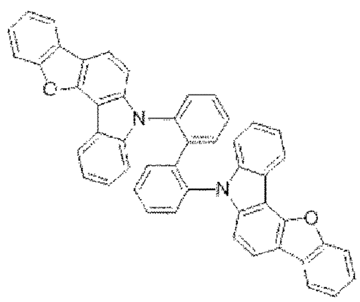

H-4

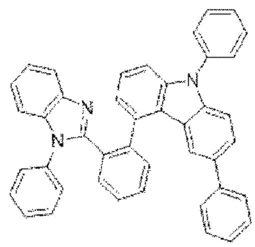

H-5

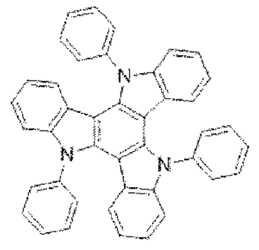

H-6

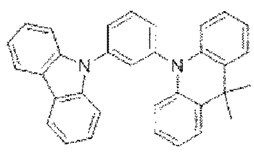

H-7

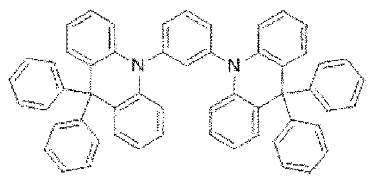

H-8

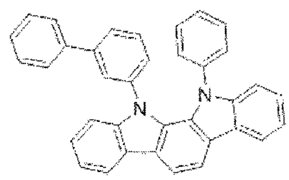

H-9

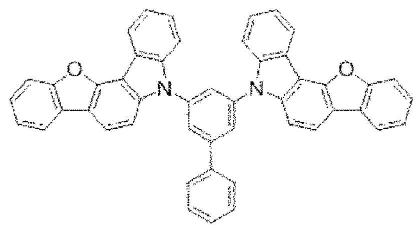

H-10

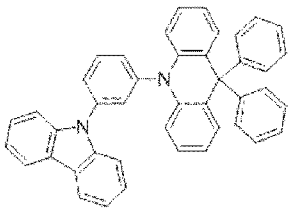
H-11

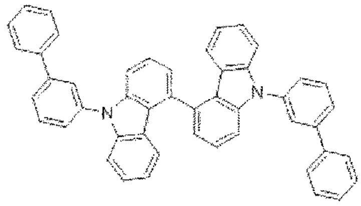
H-12

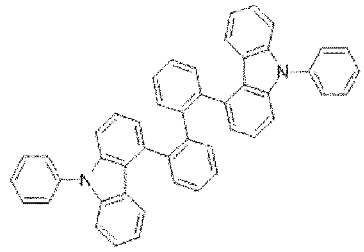
H-13

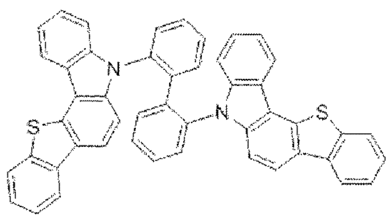
H-14

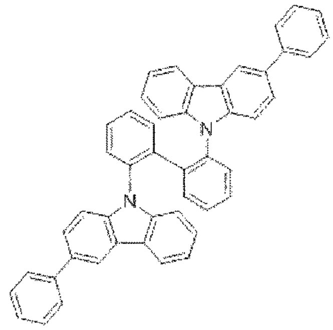
H-15

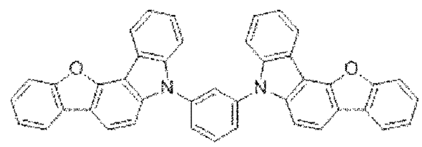
H-16

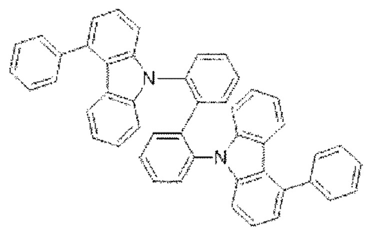
H-17

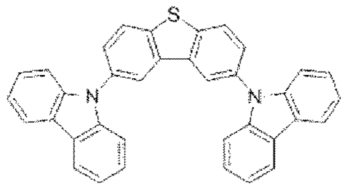
H-18

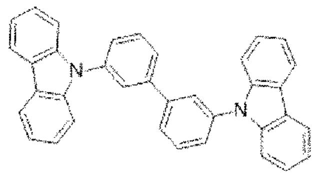
H-19

**10.** Zusammensetzung nach einem der Ansprüche 1 - 9, wobei die dritte Verbindung verzögerte Fluoreszenz emittiert; und/oder wobei die dritte Verbindung durch eine ausgewählt aus den Formeln 3 und 4 dargestellt wird:

<Formula 3>

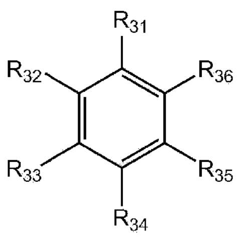

<Formel 12-1> <Formel 12-2>

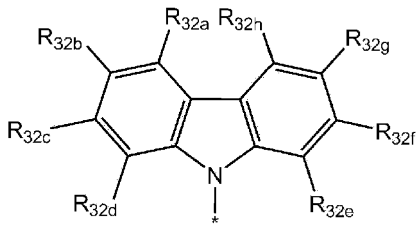

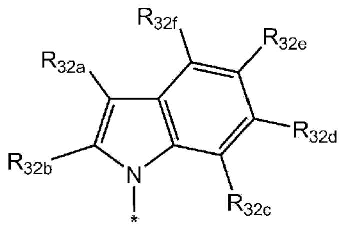

<Formel 4>

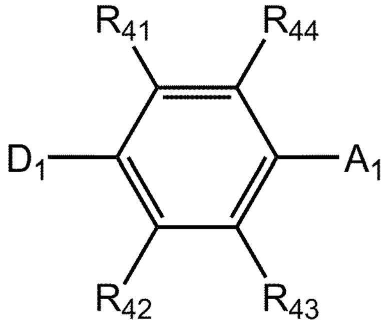

<Formel 13-1>

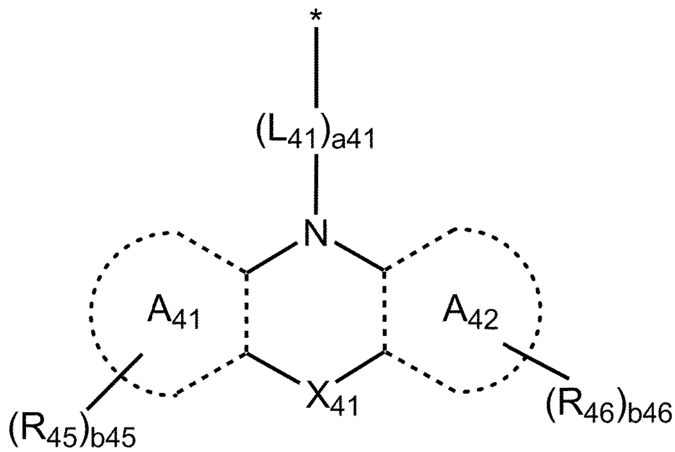

<Formel 14-1>

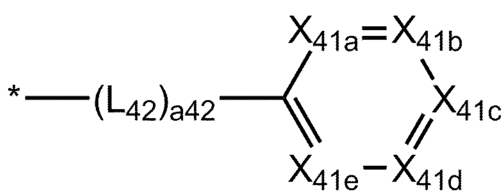

,

wobei in den Formeln 3, 4, 12-1, 12-2, 13-1 und 14-1

$R_{31}$ bis $R_{36}$ jeweils unabhängig voneinander ausgewählt sind aus einer Gruppe, dargestellt durch Formel 12-1, einer Gruppe, dargestellt durch Formel 12-2, Wasserstoff, Deuterium, -F, -Cl, - Br, -I, einer Hydroxylgruppe, einer Cyanogruppe, einer substituierten oder unsubstituierten $C_1$-$C_{60}$-Alkylgruppe, einer substituierten oder unsubstituierten $C_1$-$C_{60}$-Alkoxygruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten

$C_6$-$C_{60}$-Arylthiogruppe und einer substituierten oder unsubstituierten $C_1$-$C_{60}$-Heteroarylgruppe,
wobei zumindest eines ausgewählt aus $R_{31}$ bis $R_{36}$ eine Cyanogruppe ist,
wobei zumindest eines ausgewählt aus $R_{31}$ bis $R_{36}$ aus einer Gruppe, dargestellt durch Formel 12-1 und einer Gruppe, dargestellt durch Formel 12-2 ausgewählt ist,
$D_1$ eine Gruppe ist, dargestellt durch Formel 13-1,
$A_1$ eine Gruppe ist, dargestellt durch Formel 14-1,
$X_{41}$ ausgewählt ist aus der Einfachbindung, O, S, N($R_{47}$), und C($R_{47}$)($R_{48}$),
$A_{41}$ und $A_{42}$ jeweils unabhängig voneinander ausgewählt sind aus einer Benzolgruppe, einer Fluorengruppe, einer Carbazolgruppe, einer Dibenzofurangruppe, einer Dibenzothiophengruppe, einer Indolofluorengruppe, einer Indolocarbazolgruppe, einer Indolodibenzofurangruppe, einer Indolodibenzothiophengruppe, einer Indenofluorengruppe, einer Indenocarbazolgruppe, einer Indenodibenzofurangruppe, einer Indenodibenzothiophengruppe, einer Benzofuranofluorengruppe, einer Benzofuranocarbazolgruppe, einer Benzofuranodibenzofurangruppe, einer Benzofuranodibenzothiophengruppe, einer Benzothienofluorengruppe, einer Benzothienocarbazolgruppe, einer Benzothienodibenzofurangruppe und einer Benzothienodibenzothiophengruppe,
$L_{41}$ und $L_{42}$ jeweils unabhängig voneinander ausgewählt sind aus einer substituierten oder unsubstituierten $C_5$-$C_{30}$-carbocyclischen Gruppe und einer substituierten oder unsubstituierten $C_1$-$C_{30}$-heterocyclischen Gruppe,
a41 und a42 jeweils unabhängig voneinander ausgewählt sind aus 0, 1, 2, und 3,
wobei $X_{41a}$ N oder C($R_{41a}$) ist; $X_{41b}$ N oder C($R_{41b}$) ist; $X_{41c}$ N oder C($R_{41c}$) ist; $X_{41d}$ N oder C($R_{41d}$) ist; und $X_{41e}$ N oder C($R_{41e}$) ist, wobei zumindest eines ausgewählt aus $X_{41a}$ bis $X_{41e}$ N ist, $R_{32a}$ bis $R_{32h}$, $R_{41}$ bis $R_{48}$ und $R_{41a}$ bis $R_{41e}$ jeweils unabhängig voneinander ausgewählt sind aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phophorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkinylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_1$-$C_{60}$-Heteroarylgruppe, einer substituierten oder unsubstituierten monovalenten nicht aromatischen kondensierten polycyclischen Gruppe, einer substituierten oder unsubstituierten monovalenten nicht aromatischen kondensierten heteropolycyclischen Gruppe, -Si($Q_1$)($Q_2$)($Q_3$), -N($Q_4$)($Q_5$) und - B($Q_6$)($Q_7$),
b45 und b46 jeweils unabhängig voneinander ausgewählt sind aus 1, 2, 3, 4, 5, 6, 7, and 8,
$Q_1$ bis $Q_7$ jeweils unabhängig voneinander ausgewählt sind aus Wasserstoff, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_1$-$C_{60}$-Heteroarylgruppe, einer monovalenten nicht aromatischen kondensierten polycyclischen Gruppe, einer monovalenten nicht aromatischen kondensierten heteropolycyclischen Gruppe, und * eine Bindungsstelle zu einem benachbarten Atom anzeigt.

**11.** Zusammensetzung nach Anspruch 10, wobei eines, zwei oder drei ausgewählt aus $R_{31}$ bis $R_{36}$ eine Cyanogruppe ist/sind, und eines, zwei, drei, vier oder fünf ausgewählt aus $R_{31}$ bis $R_{36}$ aus einer Gruppe, dargestellt durch Formel 12-1 und einer Gruppe, dargestellt durch Formel 12-2 ausgewählt ist/sind; und/oder
wobei die dritte Verbindung durch eine ausgewählt aus den Formeln 3-1 bis 3-5 dargestellt wird:

<Formel 3-1> <Formel 3-2> <Formel 3-3>

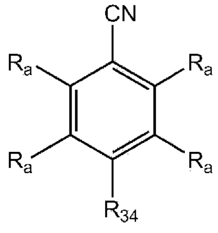
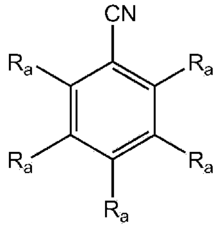
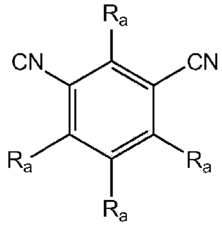

<Formel 3-4> <Formel 3-5>

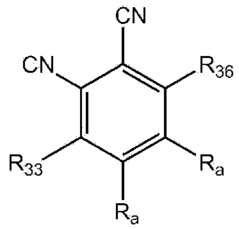

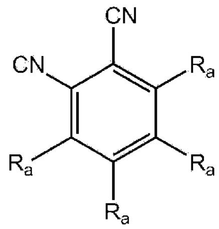

<Formel 12-11>

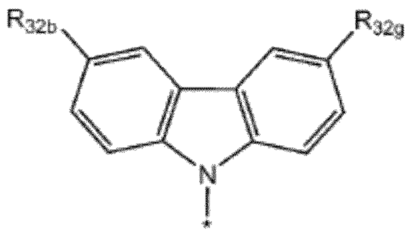

,

wobei in den Formeln 3-1 bis 3-5 und 12-1 bis 12-2

$R_a$ eine Gruppe ist, dargestellt durch Formel 12-11,
$R_{33}$, $R_{34}$ und $R_{36}$ jeweils unabhängig voneinander ausgewählt sind aus Wasserstoff, Deuterium, -F, -Cl, -Br, -I, einer Hydroxylgruppe, einer $C_1$-$C_{10}$-Alkylgruppe und einer $C_1$-$C_{10}$-Alkoxygruppe,
$R_{32b}$ und $R_{32g}$ jeweils unabhängig voneinander ausgewählt sind aus Wasserstoff, Deuterium, -F, -Cl, -Br, -I, einer Hydroxylgruppe, einer $C_1$-$C_{10}$-Alkylgruppe, einer $C_1$-$C_{10}$-Alkoxygruppe, einer $C_6$-$C_{30}$-Arylgruppe und einer $C_1$-$C_{30}$-Heteroarylgruppe und
* eine Bindungsstelle zu einem benachbarten Atom anzeigt.

**12.** Zusammensetzung nach einem der Ansprüche 1 - 11, wobei die dritte Verbindung ausgewählt ist aus den Verbindungen D-1 bis D-23:

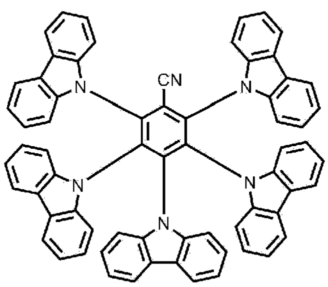

**D-1**

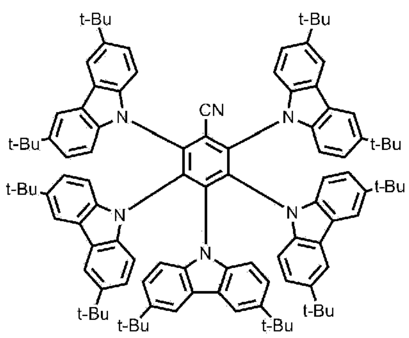

**D-2**

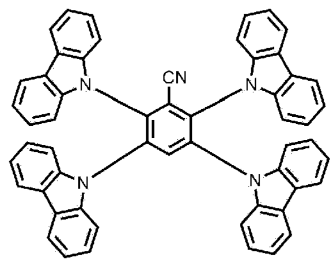

**D-3**

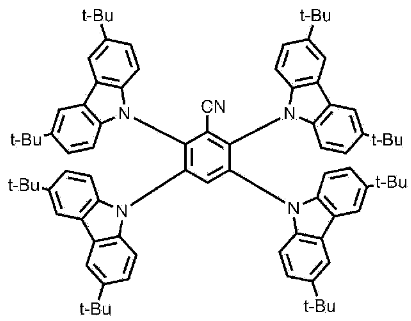

D-4

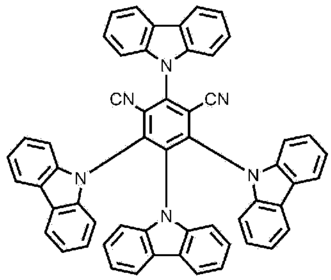

D-5

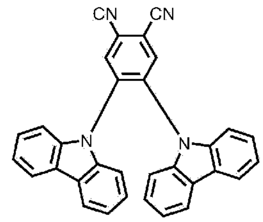

D-6

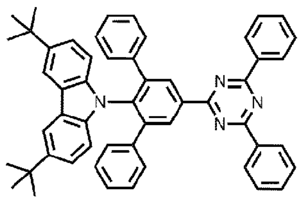

D-7

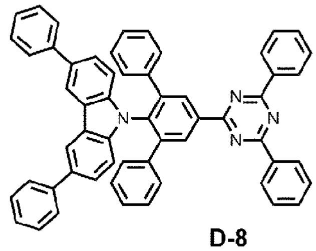

D-8

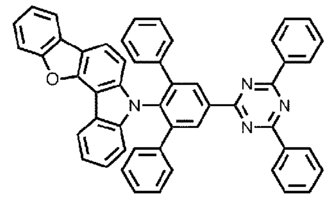

D-9

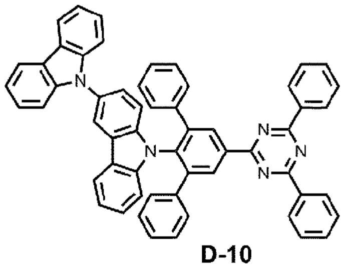

D-10

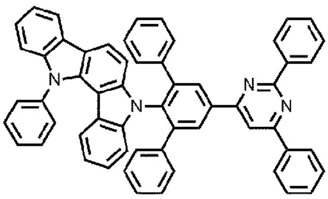

D-11

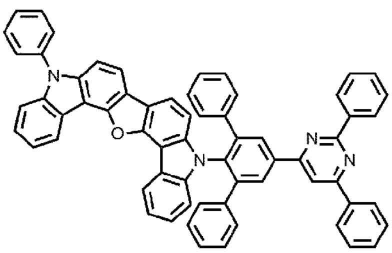

D-12

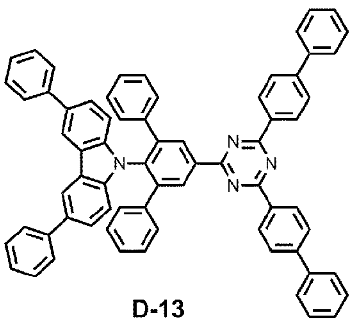

D-13

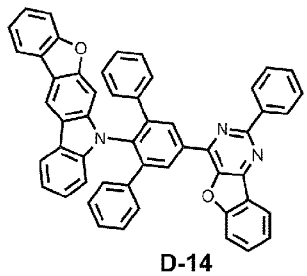

D-14

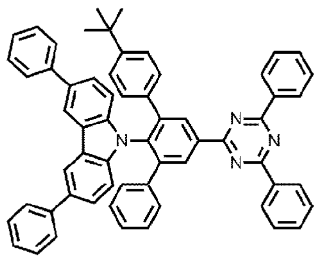

D-15

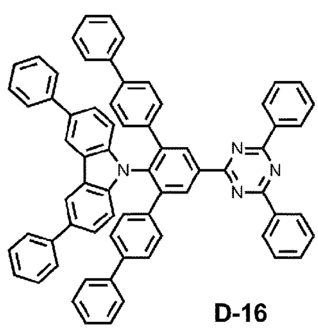

D-16

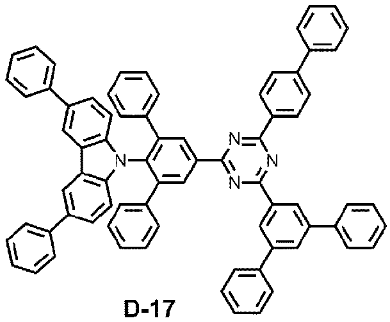

D-17

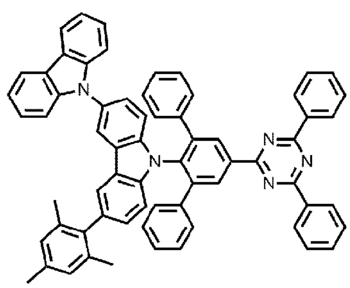

D-18

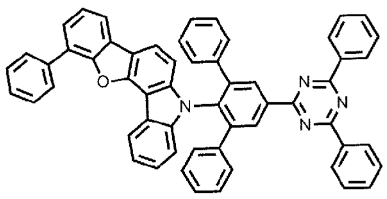

D-19

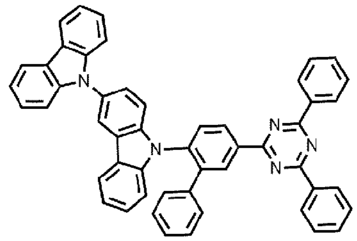

D-20

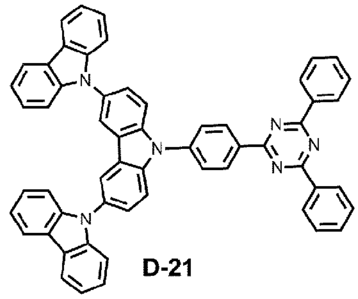

D-21

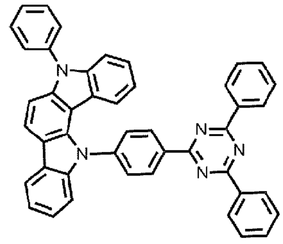

D-22

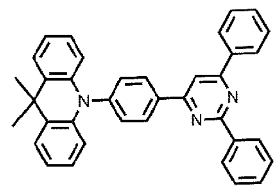

D-23

**13.** Zusammensetzung nach einem der Ansprüche 1 - 12, wobei die Zusammensetzung keine übergangsmetallhaltige organometallische Verbindung einschließt.

**14.** Dünnfilm, umfassend die Zusammensetzung nach einem der Ansprüche 1 - 13.

**15.** Organische lichtemittierende Vorrichtung, umfassend: eine erste Elektrode, eine zweite Elektrode und eine organische Schicht zwischen der ersten Elektrode und der zweiten Elektrode, wobei die organische Schicht einen Dünnfilm nach Anspruch 14 umfasst; wobei vorzugsweise der Dünnfilm eine Emissionsschicht ist.

## Revendications

**1.** Composition comprenant :
un premier composé représenté par la Formule 1 :
un deuxième composé représenté par la Formule 2 :

un troisième composé satisfaisant la Condition 1, et
le deuxième composé étant différent du premier composé :

<Formule 1> $A_{11}\text{-}L_{11}\text{-}A_{12}$

<Formule 2> $A_{21}\text{-}(L_{21})_{a21}\text{-}A_{22}$

<Formule 10-1>

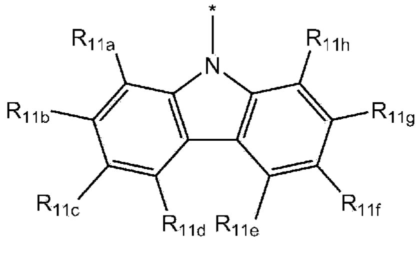

<Formule 10-2>

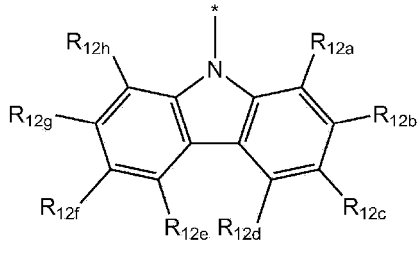

<Formule 11-1>

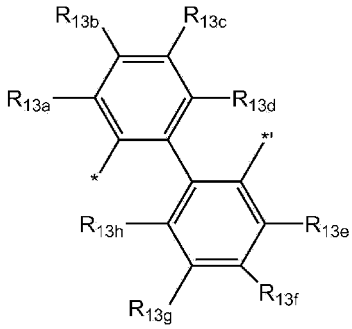

<Formule 11-2>

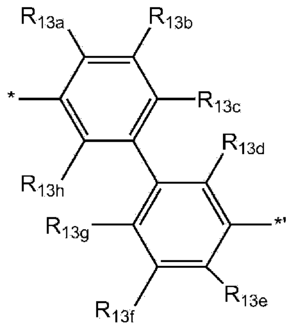

<Formule 11-3>

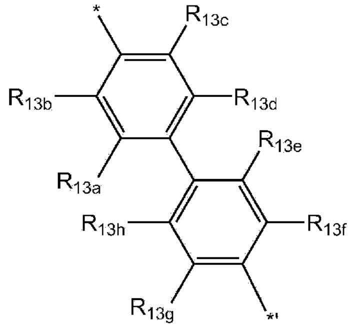

<Formule 20-1>

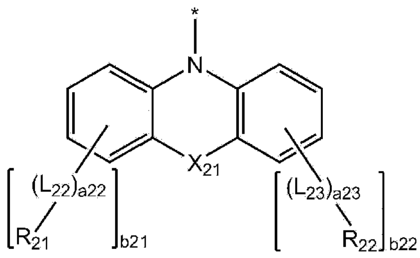

<Formule 20-2>

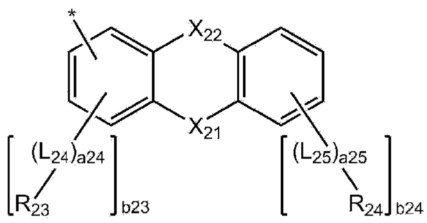

<Condition 1>

$$0 \text{ eV} \leq E_{S1}(C3) - E_{T1}(C3) \leq 0{,}3 \text{ eV},$$

où, dans la Condition 1,

$E_{S1}(C3)$ est un niveau énergétique d'état singulet excité le plus bas du troisième composé,
$E_{T1}(C3)$ est un niveau énergétique d'état triplet excité le plus bas du troisième composé, et
$E_{S1}(C3)$ et $E_{T1}(C3)$ sont évalués en utilisant une méthode DFT structurellement optimisée à un niveau de B3LYP/6-31G(d,p),

dans les Formules 1 et 2,

$A_{11}$ est un groupe représenté par la Formule 10-1,
$A_{12}$ est un groupe représenté par la Formule 10-2,
$L_{11}$ est un groupe représenté par une formule choisie parmi les Formules 11-1 à 11-3,
$A_{21}$ est un groupe représenté par une formule choisie entre les Formules 20-1 et 20-2 ;
$A_{22}$ est choisi parmi les groupes représentés par les Formules 20-1 et 20-2, groupe phényle, groupe naphthyle, et groupe benzimidazolyle ; et
groupe phényle, groupe naphthyle, et groupe benzimidazolyle, chacun étant substitué par au moins un élément choisi parmi deutérium, groupe hydroxyle, groupe amino, groupe amidino, groupe hydrazine, groupe hydrazone, groupe acide carboxylique ou un sel de celui-ci, groupe acide sulfonique ou un sel de celui-ci, groupe acide phosphorique ou un sel de celui-ci, groupe alkyle $C_1$-$C_{20}$, groupe alkoxy $C_1$-$C_{20}$, groupe phényle, groupe naphthyle, groupe fluorényle, groupe carbazolyle, groupe dibenzofuranyle, et groupe dibenzothiophényle,
$X_{21}$ est choisi parmi une liaison simple, $C[(L_{27})_{a27}\text{-}R_{26}][(L_{28})_{a28}\text{-}R_{27}]$, O, et S,
$X_{22}$ est choisi parmi $N[(L_{26})_{a26}\text{-}R_{25}]$, $C[(L_{29})_{a29}\text{-}R_{28}][(L_{30})_{a30}\text{-}R_{29}]$, O, et S,
$L_{21}$ à $L_{30}$ sont chacun indépendamment choisis parmi groupe cycloalkylène $C_3$-$C_{10}$ substitué ou non substitué, groupe hétérocycloalkylène $C_1$-$C_{10}$ substitué ou non substitué, groupe cycloalkénylène $C_3$-$C_{10}$ substitué ou non substitué, groupe hétérocycloalkénylène $C_1$-$C_{10}$ substitué ou non substitué, groupe arylène $C_6$-$C_{60}$ substitué ou non substitué, groupe hétéroarylène $C_1$-$C_{60}$ substitué ou non

substitué, groupe polycyclique condensé non aromatique divalent substitué ou non substitué, et groupe hétéropolycyclique condensé non aromatique divalent substitué ou non substitué,

a21 à a30 sont chacun indépendamment choisis parmi 0, 1, 2, 3, 4, et 5,

$R_{11a}$ à $R_{11h}$, $R_{12a}$ à $R_{12h}$, $R_{13a}$ à $R_{13h}$, et $R_{21}$ à $R_{29}$ sont chacun indépendamment choisis parmi hydrogène, deutérium, -F, -Cl, -Br, -I, groupe hydroxyle, groupe cyano (CN), groupe nitro, groupe amino, groupe amidino, groupe hydrazine, groupe hydrazone, groupe acide carboxylique ou un sel de celui-ci, groupe acide sulfonique ou un sel de celui-ci, groupe acide phosphorique ou un sel de celui-ci, groupe alkyle $C_1$-$C_{60}$ substitué ou non substitué, groupe alkényle $C_2$-$C_{60}$ substitué ou non substitué, groupe alkynyle $C_2$-$C_{60}$ substitué ou non substitué, groupe alkoxy $C_1$-$C_{60}$ substitué ou non substitué, groupe cycloalkyle $C_3$-$C_{10}$ substitué ou non substitué, groupe hétérocycloalkyle $C_1$-$C_{10}$ substitué ou non substitué, groupe cycloalkényle $C_3$-$C_{10}$ substitué ou non substitué, groupe hétérocycloalkényle $C_1$-$C_{10}$ substitué ou non substitué, groupe aryle $C_6$-$C_{60}$ substitué ou non substitué, groupe aryloxy $C_6$-$C_{60}$ substitué ou non substitué, groupe arylthio $C_6$-$C_{60}$ substitué ou non substitué, groupe hétéroaryle $C_1$-$C_{60}$ substitué ou non substitué, groupe polycyclique condensé non aromatique monovalent substitué ou non substitué, groupe hétéropolycyclique condensé non aromatique monovalent substitué ou non substitué, $-Si(Q_1)(Q_2)(Q_3)$, $-N(Q_1)(Q_2)$, et - $B(Q_1)(Q_2)$, deux éléments ou plus choisis parmi $R_{21}$ à $R_{29}$ étant éventuellement liés pour former un cycle,

au moins un élément choisi parmi $R_{11a}$ à $R_{11h}$, $R_{12a}$ à $R_{12h}$, et $R_{13a}$ à $R_{13h}$ est un groupe cyano,

b21, b22, et b24 sont chacun indépendamment choisis parmi 1, 2, 3, et 4,

b23 est choisi parmi 1, 2, et 3,

$Q_1$ à $Q_3$ sont chacun indépendamment choisis parmi hydrogène, deutérium, -F, -Cl, - Br,-I, groupe hydroxyle, groupe cyano, groupe nitro, groupe amidino, groupe hydrazino, groupe hydrazono, groupe alkyle $C_1$-$C_{60}$, groupe alkényle $C_2$-$C_{60}$, groupe alkynyle $C_2$-$C_{60}$, groupe alkoxy $C_1$-$C_{60}$, groupe cycloalkyle $C_3$-$C_{10}$, groupe hétérocycloalkyle $C_1$-$C_{10}$, groupe cycloalkényle $C_3$-$C_{10}$, groupe hétérocycloalkényle $C_1$-$C_{10}$, groupe aryle $C_6$-$C_{60}$, groupe hétéroaryle $C_1$-$C_{60}$, groupe polycyclique condensé non aromatique monovalent, groupe hétéropolycyclique condensé non aromatique monovalent, groupe biphényle, et groupe terphényle, et

* et *' indiquent chacun un site de liaison à un atome voisin.

**2.** Composition selon la revendication 1, dans laquelle un, deux, ou trois éléments choisis parmi $R_{11a}$ à $R_{11h}$, $R_{12a}$ à $R_{12h}$, et $R_{13a}$ à $R_{13h}$ sont un groupe cyano ; et/ou dans laquelle $R_{11a}$ à $R_{11h}$, $R_{12a}$ à $R_{12h}$, et $R_{13a}$ à $R_{13h}$ sont chacun indépendamment choisis parmi :

hydrogène, deutérium, groupe cyano, groupe alkyle $C_1$-$C_{10}$, et groupe alkoxy $C_1$-$C_{10}$,

groupe alkyle $C_1$-$C_{10}$ et groupe alkoxy $C_1$-$C_{10}$, chacun étant substitué par au moins un élément choisi parmi deutérium et groupe cyano,

groupe phényle, groupe biphényle, groupe terphényle, groupe naphthyle, groupe fluorényle, groupe pyridinyle, groupe pyrazinyle, groupe pyrimidinyle, groupe carbazolyle, groupe dibenzofuranyle, et groupe dibenzothiophényle, et

groupe phényle, groupe biphényle, groupe terphényle, groupe naphthyle, groupe fluorényle, groupe pyridinyle, groupe carbazolyle, groupe dibenzofuranyle, et groupe dibenzothiophényle, chacun étant substitué par au moins un élément choisi parmi deutérium, groupe cyano, groupe alkyle $C_1$-$C_{10}$, groupe alkoxy $C_1$-$C_{10}$, groupe phényle, groupe biphényle, groupe terphényle, groupe naphthyle, groupe fluorényle, groupe pyridinyle, groupe pyrazinyle, groupe pyrimidinyle, groupe carbazolyle, groupe dibenzofuranyle, et groupe dibenzothiophényle.

**3.** Composition selon la revendication 1 ou 2, dans laquelle

$A_{11}$ est représenté par la Formule 10-11, $A_{12}$ est représenté par la Formule 10-21, et $L_{11}$ est représenté par une formule choisie parmi les Formules 11-15 à 11-22, 11-27 à 11- 34, et 11-37 à 11-40 ;

$A_{11}$ est représenté par une formule choisie entre les Formules 10-12 et 10-13, $A_{12}$ est représenté par une formule choisie parmi les Formules 10-21 à 10-23, et $L_{11}$ est représenté par une formule choisie parmi les Formules 11-11 à 11-40 ; ou

$A_{11}$ est représenté par la Formule 10-11, $A_{12}$ est représenté par une formule choisie entre les Formules 10-22 et 10-23, et $L_{11}$ est représenté par une formule choisie parmi les Formules 11-11 à 11-40 :

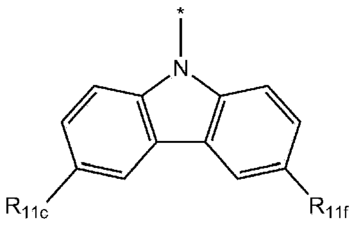
10-11

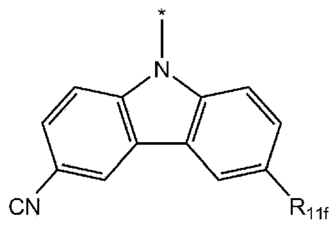
10-12

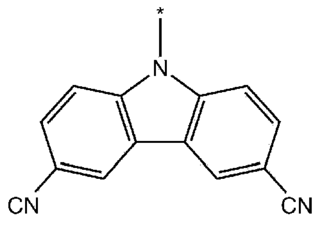
10-13

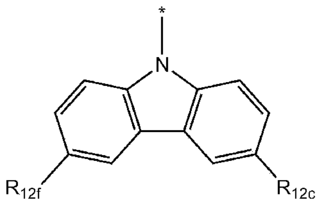
10-21

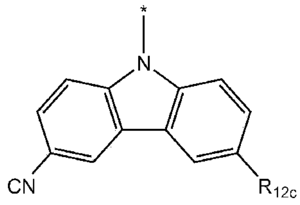
10-22

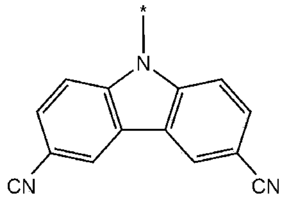
10-23

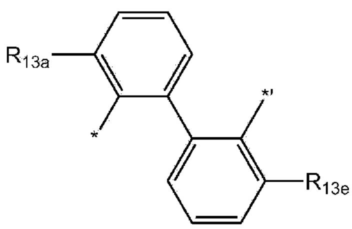
11-11

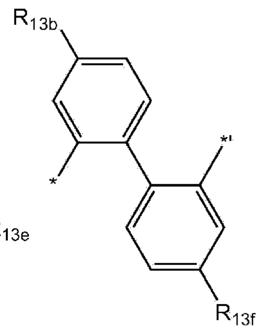
11-12

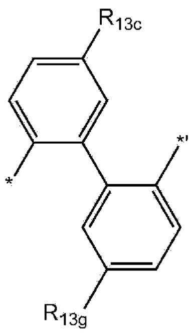
11-13

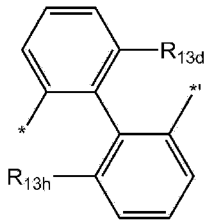
11-14

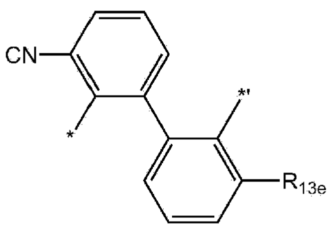
11-15

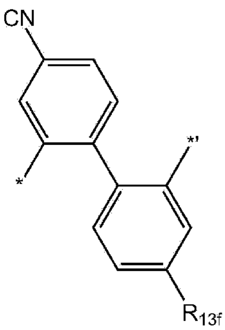
11-16

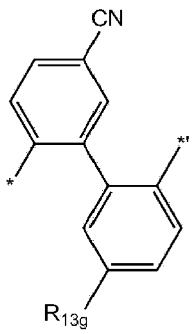
11-17

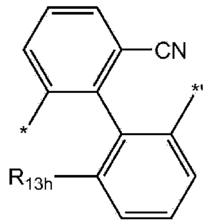
11-18

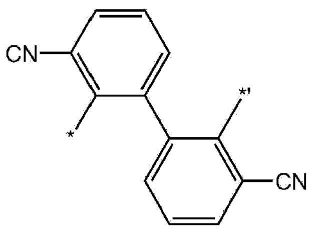
11-19

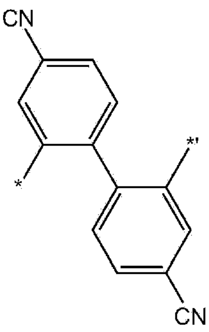
11-20

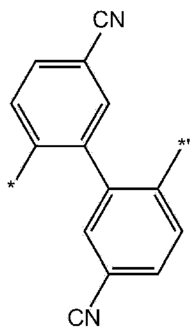
11-21

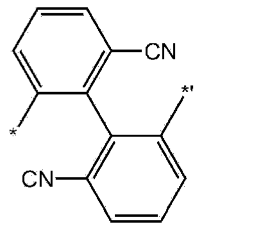
11-22

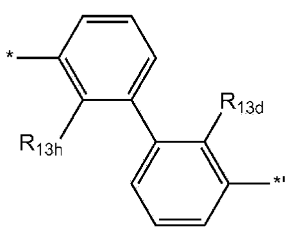
11-23

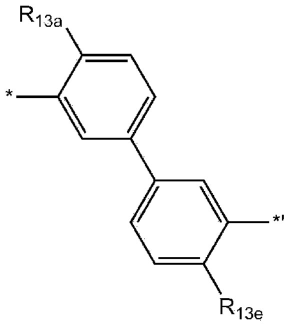
11-24

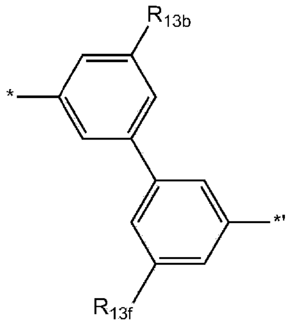
11-25

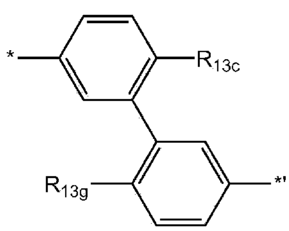
11-26

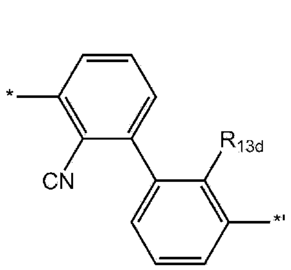
11-27

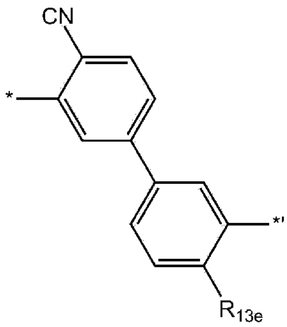
11-28

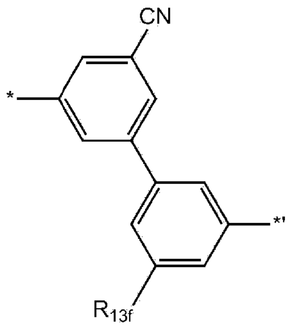
11-29

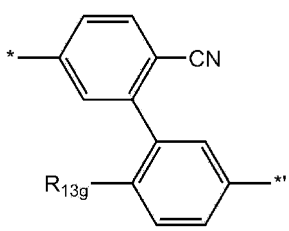
11-30

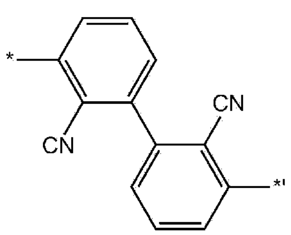
11-31

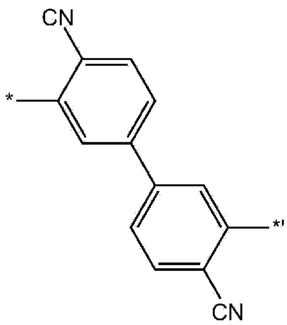
11-32

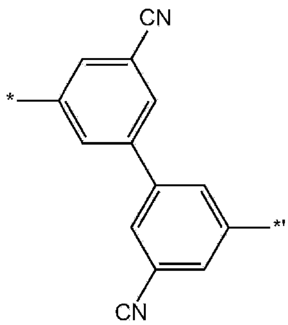
11-33

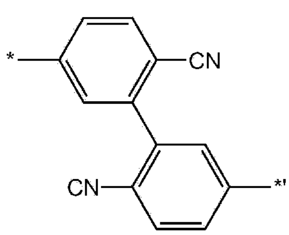
11-34

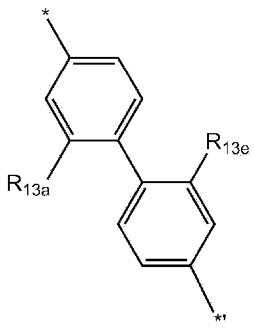

11-35

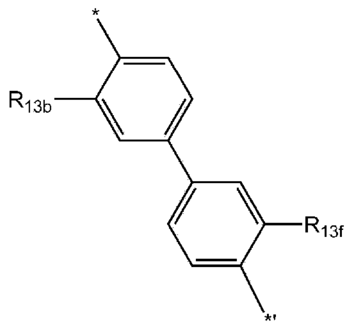

11-36

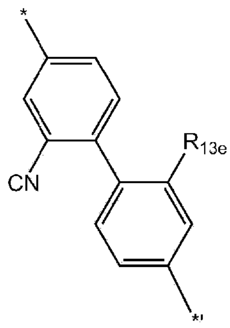

11-37

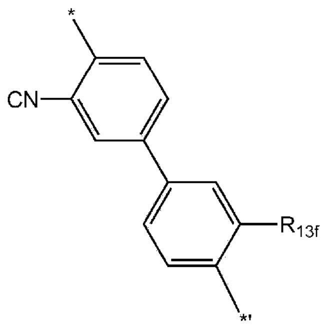

11-38

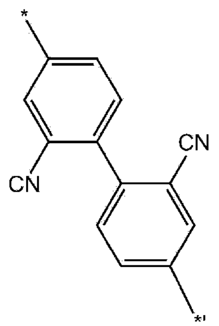

11-39

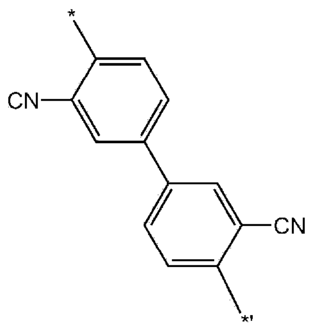

11-40

,

où, dans les Formules 10-11 à 10-13, 10-21 à 10-23, et 11-11 à 11-40,
$R_{11c}$, $R_{11f}$, $R_{12c}$, $R_{12f}$, et $R_{13a}$ à $R_{13f}$ sont chacun indépendamment choisis parmi :

hydrogène, deutérium, groupe alkyle $C_1$-$C_{10}$, groupe alkoxy $C_1$-$C_{10}$, groupe phényle, groupe biphényle, groupe terphényle, groupe naphthyle, groupe fluorényle, groupe pyridinyle, groupe pyrazinyle, groupe pyrimidinyle, groupe carbazolyle, groupe dibenzofuranyle, et groupe dibenzothiophényle ;
groupe alkyle $C_1$-$C_{10}$ et groupe alkoxy $C_1$-$C_{10}$, chacun étant substitué par deutérium ; et
groupe phényle, groupe biphényle, groupe terphényle, groupe naphthyle, groupe fluorényle, groupe pyridinyle, groupe pyrazinyle, groupe pyrimidinyle, groupe carbazolyle, groupe dibenzofuranyle, et groupe dibenzothiophényle, chacun étant substitué par au moins un élément choisi parmi deutérium, groupe alkyle $C_1$-$C_{10}$, groupe alkoxy $C_1$-$C_{10}$, groupe phényle, groupe biphényle, groupe terphényle, groupe naphthyle, groupe fluorényle, groupe pyridinyle, groupe pyrazinyle, groupe pyrimidinyle, groupe carbazolyle, groupe dibenzofuranyle, et groupe dibenzothiophényle, et
* et *' indiquent chacun un site de liaison à un atome voisin.

**4.** Composition selon l'une quelconque des revendications 1 à 3, dans laquelle le premier composé est choisi parmi les Composés E-1 à E-20 :

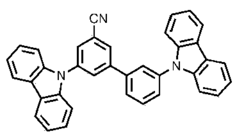

**E-1**

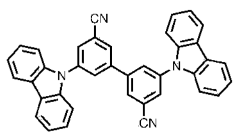

**E-2**

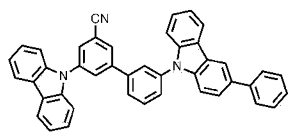

**E-3**

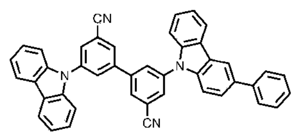

**E-4**

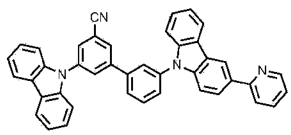
E-5

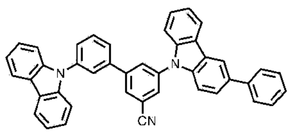
E-6

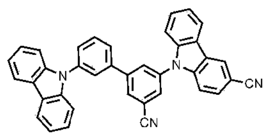
E-7

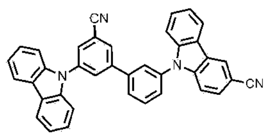
E-8

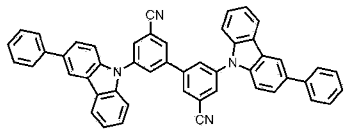
E-9

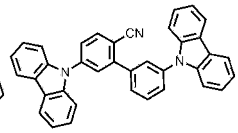
E-10

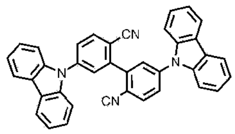
E-11

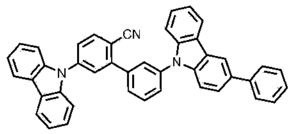
E-12

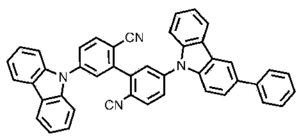
E-13

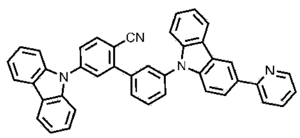
E-14

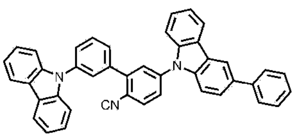
E-15

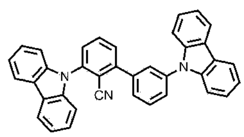
E-16

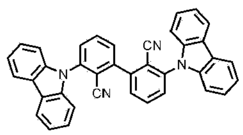
E-17

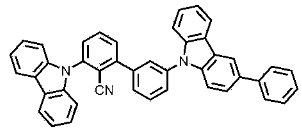
E-18

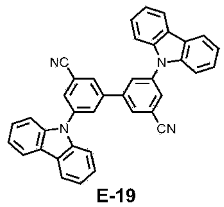
E-19

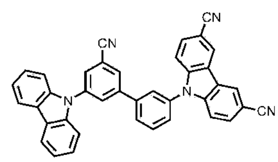
E-20

**5.** Composition selon l'une quelconque des revendications 1 à 4, dans laquelle $A_{21}$ et $A_{22}$ sont chacun indépendamment représentés par la Formule 20-1, $A_{21}$ est représenté par la Formule 20-1, et $A_{22}$ est représenté par la Formule 20-2, ou $A_{21}$ et $A_{22}$ sont chacun indépendamment représentés par la Formule 20-2 ; et/ou dans laquelle $X_{21}$ est une liaison simple, et $X_{22}$ est choisi parmi $N(R_{25})$, $C(R_{28})(R_{29})$, O, et S.

**6.** Composition selon l'une quelconque des revendications 1 à 5, dans laquelle $R_{21}$ à $R_{29}$ sont chacun indépendamment choisis parmi :

hydrogène, deutérium, -F, -Cl, -Br, -I, groupe cyano, groupe alkyle $C_1$-$C_{10}$, groupe alkoxy $C_1$-$C_{10}$, groupe cycloalkyle $C_3$-$C_{10}$, et groupe hétérocycloalkyle $C_1$-$C_{10}$ ;
groupe alkyle $C_1$-$C_{10}$, groupe alkoxy $C_1$-$C_{10}$, groupe cycloalkyle $C_3$-$C_{10}$, et groupe hétérocycloalkyle $C_1$-$C_{10}$, chacun étant substitué par au moins un élément choisi parmi deutérium, -F, -Cl, -Br, -I, et groupe cyano,
groupe aryle $C_6$-$C_{30}$, groupe biphényle, groupe terphényle, groupe aryloxy $C_6$-$C_{30}$, groupe arylthio $C_6$-$C_{30}$, groupe hétéroaryle $C_1$-$C_{30}$, groupe polycyclique condensé non aromatique monovalent, et groupe hétéropolycyclique condensé non aromatique monovalent,
groupe aryle $C_6$-$C_{30}$, groupe biphényle, groupe terphényle, groupe aryloxy $C_6$-$C_{30}$, groupe arylthio $C_6$-$C_{30}$, groupe hétéroaryle $C_1$-$C_{30}$, groupe polycyclique condensé non aromatique monovalent, et groupe hétéropolycyclique condensé non aromatique monovalent, chacun étant substitué par au moins un élément choisi parmi deutérium, - F, -Cl, -Br, -I, groupe cyano, groupe alkyle $C_1$-$C_{10}$, groupe alkoxy $C_1$-$C_{10}$, groupe cycloalkyle $C_3$-$C_{10}$, groupe hétérocycloalkyle $C_1$-$C_{10}$, groupe aryle $C_6$-$C_{30}$, groupe biphényle, groupe terphényle, groupe aryloxy $C_6$-$C_{30}$, groupe arylthio $C_6$-$C_{30}$, groupe hétéroaryle $C_1$-$C_{30}$, groupe polycyclique condensé non aromatique monovalent, et groupe hétéropolycyclique condensé non aromatique monovalent, et
$-Si(Q_1)(Q_2)(Q_3)$, $-N(Q_1)(Q_2)$, et $-B(Q_1)(Q_2)$,
deux éléments ou plus choisis parmi $R_{21}$ à $R_{29}$ étant éventuellement liés pour former un cycle, et
$Q_1$ à $Q_3$ étant indépendamment choisis parmi hydrogène, groupe alkyle $C_1$-$C_{10}$, groupe aryle $C_6$-$C_{30}$, groupe

biphényle, groupe terphényle, groupe hétéroaryle $C_1$-$C_{30}$, groupe polycyclique condensé non aromatique monovalent, et groupe hétéropolycyclique condensé non aromatique monovalent ; et/ou
dans laquelle
le groupe représenté par la Formule 20-2 est un groupe représenté par une formule choisie parmi les Formules 20-21 à 20-24 :

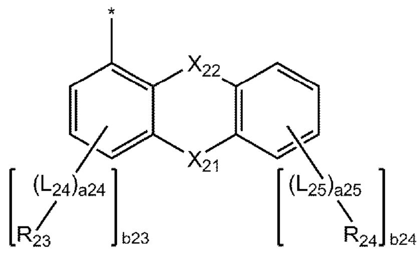

20-21

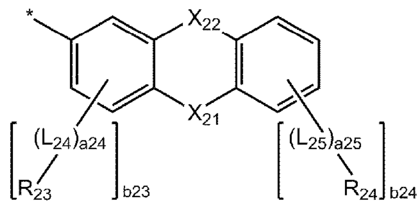

20-22

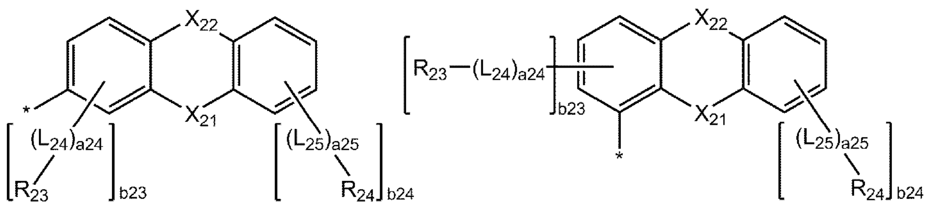

20-23

20-24

P

où, dans les formules 20-21 à 20-24,

$X_{21}$, $X_{22}$, $L_{24}$, $L_{25}$, a24, a25, $R_{23}$, $R_{24}$, b23 et b24 sont chacun indépendamment les mêmes que définis dans la Formule 20-2, et
* indique un site de liaison à un atome voisin.

**7.** Composition selon l'une quelconque des revendications 1 à 6, dans laquelle le deuxième composé est représenté par une formule choisie parmi les Formules 2-1 à 2-3

<Formule 2-1>

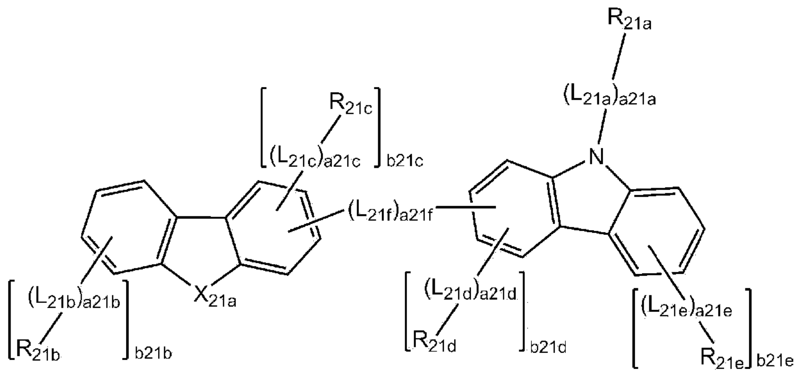

<Formule 2-2>

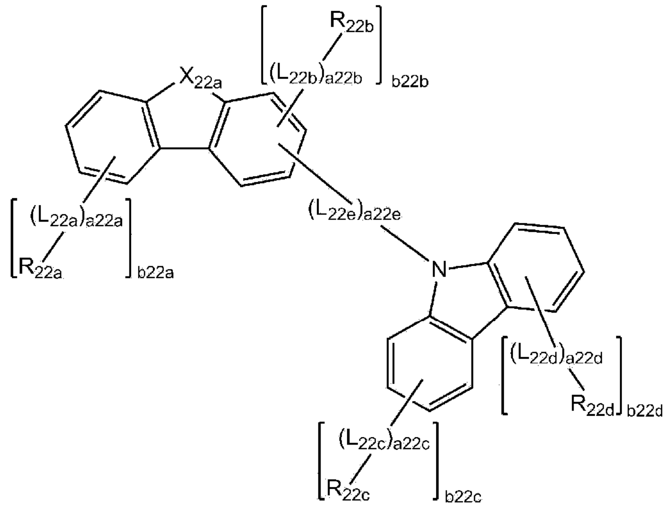

<Formule 2-3>

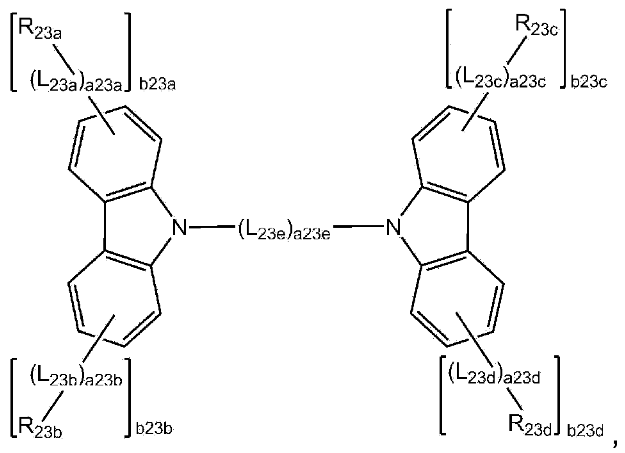

où, dans les formules 2-1 à 2-3,

$X_{21a}$ est choisi parmi N[$(L_{21g})_{a21g}$-$R_{21f}$], O, et S, et $X_{22a}$ est choisi parmi N[$(L_{22f})_{a22f}$-$R_{22e}$], O, et S,
$L_{21a}$ à $L_{21g}$, $L_{22a}$ à $L_{22f}$, et $L_{23a}$ à $L_{23e}$ sont chacun indépendamment les mêmes que décrits en relation avec $L_{21}$ dans la Formule 2,
a21a à a21g, a22a à a22f, et a23a à a23e sont chacun indépendamment les mêmes que décrits en relation avec a21 dans la Formule 2,
$R_{21a}$ à $R_{21f}$, $R_{22a}$ à $R_{22e}$, et $R_{23a}$ à $R_{23d}$ sont chacun indépendamment les mêmes que décrits en relation avec $R_{21}$ dans la Formule 2,
b21b, b21e, b22a, b22c, b22d, et b23a à b23d sont chacun indépendamment les mêmes que décrits en relation avec b21 dans la Formule 2, et
b21c, b21d, et b22b sont chacun indépendamment les mêmes que décrits en relation avec b23 dans la Formule 2 ;
de préférence où
$(L_{23e})_{a23e}$ est choisi parmi les Formules 9-1 à 9-6 :

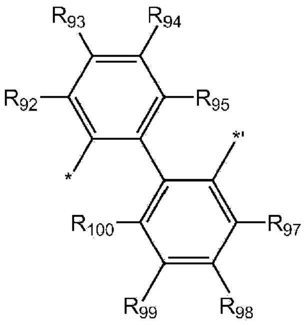
9-1

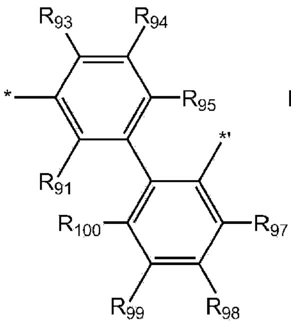
9-2

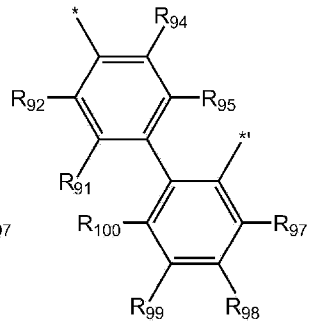
9-3

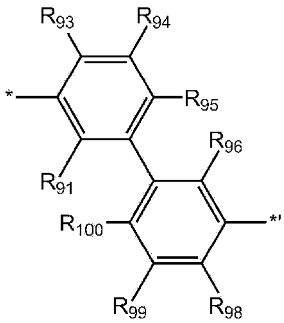
9-4

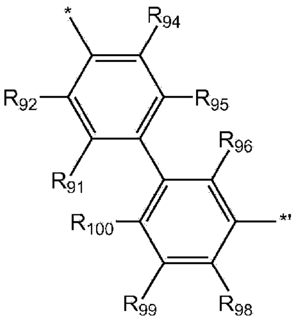
9-5

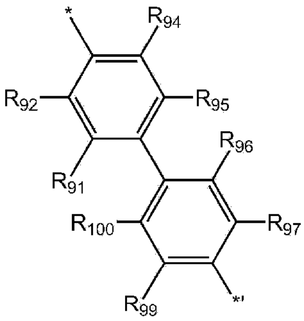
9-6

,

où, dans les formules 9-1 à 9-6,

$R_{91}$ à $R_{100}$ sont chacun indépendamment choisis parmi hydrogène, deutérium, -F, - Cl, -Br, -I, groupe hydroxyle, groupe cyano, groupe nitro, groupe amino, groupe amidino, groupe hydrazine, groupe hydrazone, groupe acide carboxylique ou un sel de celui-ci, groupe acide sulfonique ou un sel de celui-ci, groupe acide phosphorique ou un sel de celui-ci, groupe alkyle $C_1$-$C_{60}$, groupe alkényle $C_2$-$C_{60}$, groupe alkynyle $C_2$-$C_{60}$, groupe alkoxy $C_1$-$C_{60}$, groupe cycloalkyle $C_3$-$C_{10}$, groupe hétérocycloalkyle $C_1$-$C_{10}$, groupe cycloalkényle $C_3$-$C_{10}$, groupe hétérocycloalkényle $C_1$-$C_{10}$, groupe aryle $C_6$-$C_{60}$, groupe biphényle, groupe terphényle, groupe hétéroaryle $C_1$-$C_{60}$, groupe polycyclique condensé non aromatique monovalent, groupe hétéropolycyclique condensé non aromatique monovalent, et -Si($Q_{31}$)($Q_{32}$)($Q_{33}$), et

$Q_{31}$ to $Q_{33}$ sont chacun indépendamment choisis parmi hydrogène, groupe alkyle $C_1$-$C_{10}$, groupe aryle $C_6$-$C_{30}$, groupe biphényle, groupe terphényle, groupe hétéroaryle $C_1$-$C_{30}$, groupe polycyclique condensé non aromatique monovalent, et groupe hétéropolycyclique condensé non aromatique monovalent.

**8.** Composition selon l'une quelconque des revendications 1 à 7, dans laquelle le deuxième composé est représenté par une formule choisie parmi les Formules 2-11, 2-21, et 2-31 à 2-33 :

<Formule 2-11>

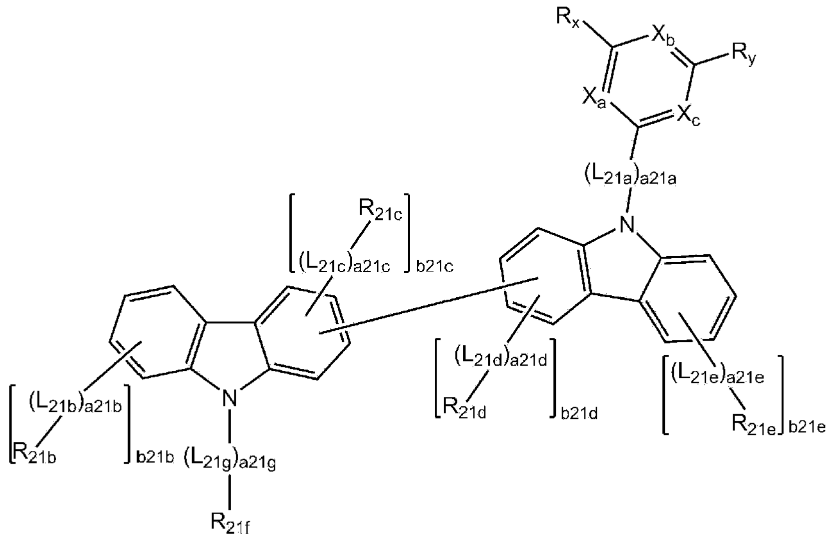

<Formule 2-21>

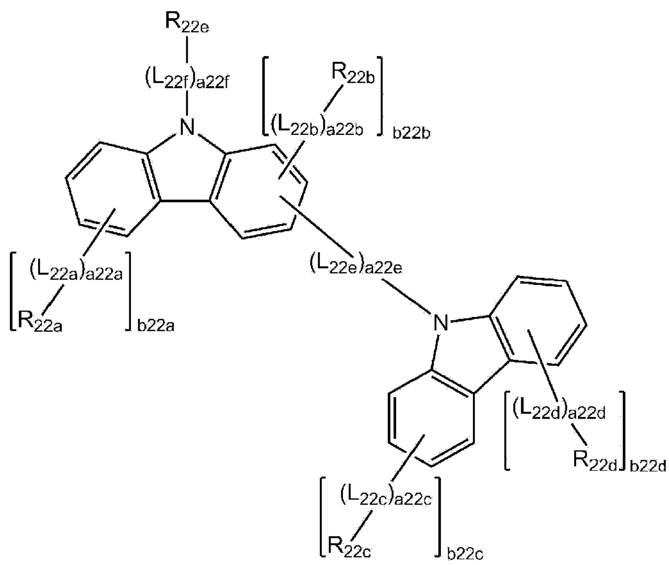

<Formule 2-31>

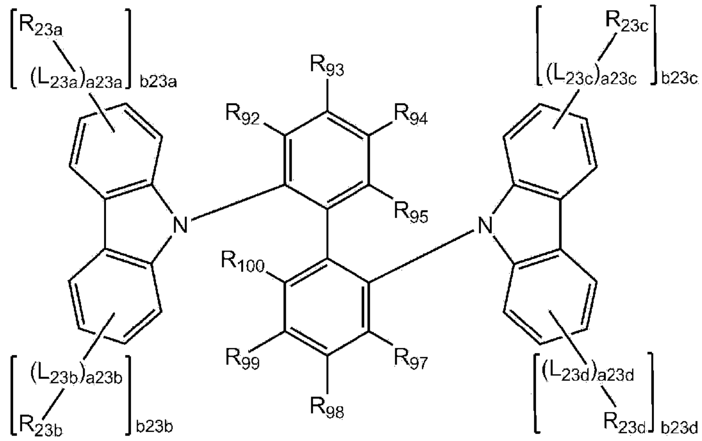

<Formule 2-32>

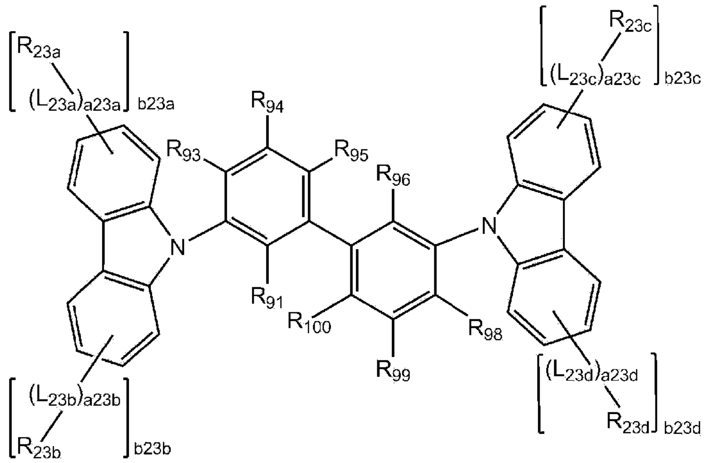

<Formule 2-33>

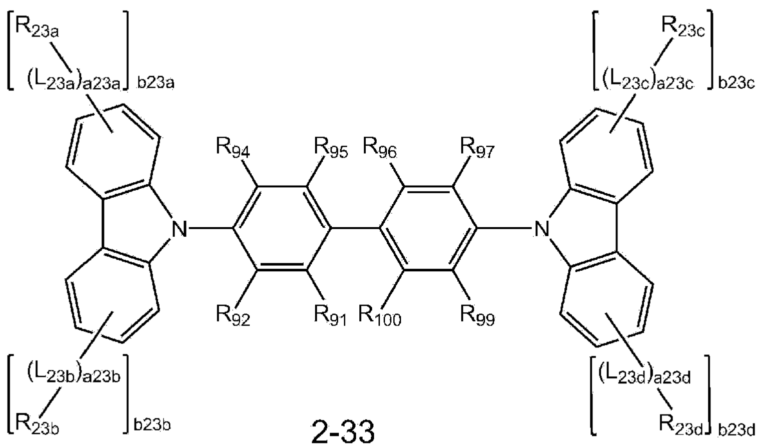

2-33

,

où, dans les formules 2-11, 2-21, et 2-31 à 2-33,

$X_a$, $X_b$, et $X_c$ sont chacun indépendamment choisis entre C et N(Rz),

$X_a$, $X_b$, et $X_c$ ne sont pas $N(R_z)$ simultanément,

$L_{21a}$ à $L_{21e}$, $L_{21g}$, $L_{22a}$ à $L_{22f}$, et $L_{23a}$ à $L_{23d}$ sont chacun indépendamment les mêmes que décrits en relation avec $L_{21}$ dans la Formule 2,

a21a à a21e, a21g, a22a à a22f, et a23a à a23d sont chacun indépendamment les mêmes que décrits en relation avec a21 dans la Formule 2,

$R_{21b}$ à $R_{21f}$, $R_{22a}$ à $R_{22e}$, et $R_{23a}$ à $R_{23d}$ sont chacun indépendamment les mêmes que décrits en relation avec $R_{21}$ dans la Formule 2,

b21b, b21e, b22a, b22c, b22d, et b23a à b23d sont chacun indépendamment les mêmes que décrits en relation avec b21 dans la Formule 2,

b21c, b21d, et b22b sont chacun indépendamment les mêmes que décrits en relation avec b23 dans la Formule 2, et

$R_{91}$ à $R_{100}$, $R_x$, $R_y$, et $R_z$ sont chacun indépendamment choisis parmi hydrogène, deutérium, -F, -Cl, -Br, -I, groupe cyano, groupe méthyle, groupe éthyle, groupe n-propyle, groupe isopropyle, groupe n-butyle, groupe isobutyle, groupe sec-butyle, groupe tert-butyle, groupe phényle, groupe biphényle, groupe terphényle, groupe naphthyle, groupe fluorényle, groupe pyridinyle, groupe pyrazinyle, groupe pyrimidinyle, groupe quinolinyle, groupe isoquinolinyle, groupe carbazolyle, groupe dibenzofuranyle, et groupe dibenzothiophényle.

**9.** Composition selon l'une quelconque des revendications 1 à 8, dans laquelle le deuxième composé est choisi parmi les Composés H-1 à H-19 :

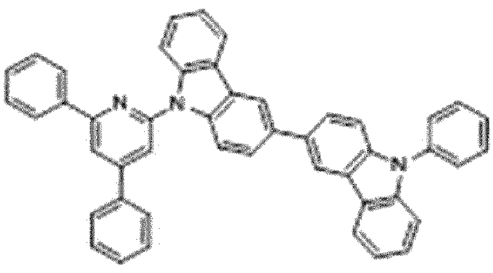

**H-1**

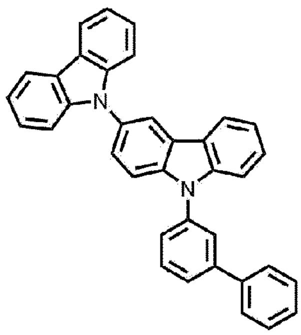

**H-2**

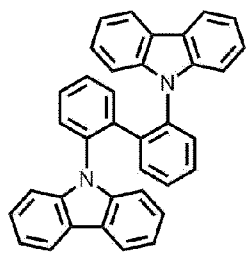

**H-3**

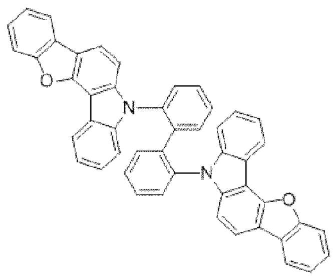

**H-4**

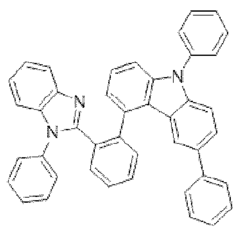

**H-5**

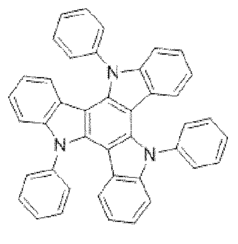

**H-6**

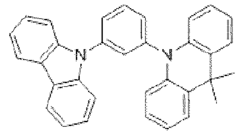

**H-7**

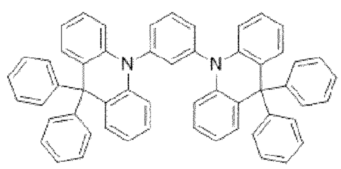

**H-8**

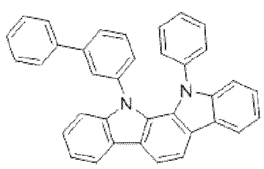

**H-9**

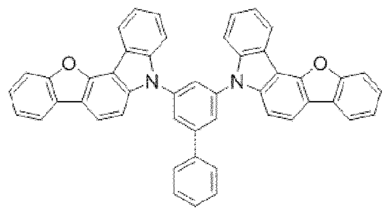

**H-10**

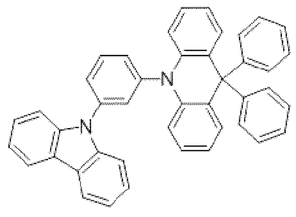

H-11

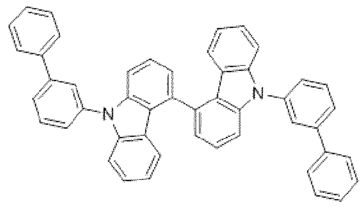

H-12

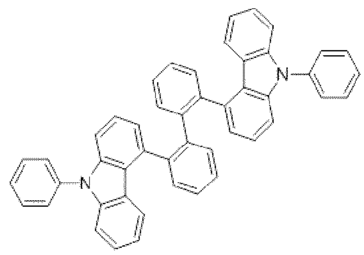

H-13

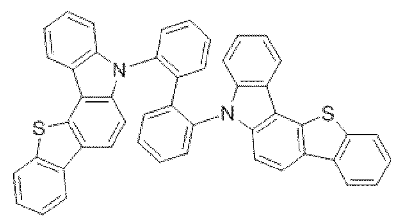

H-14

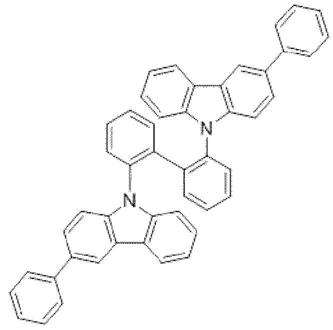

H-15

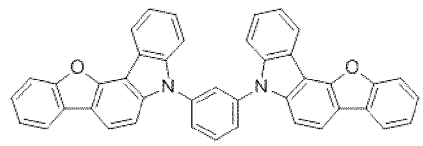

H-16

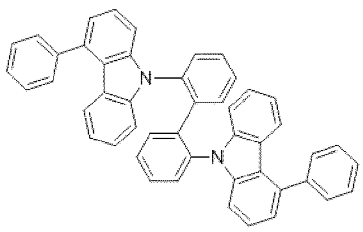

H-17

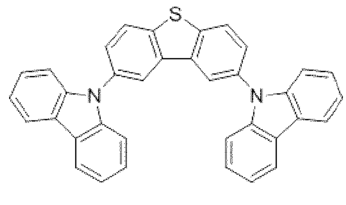

H-18

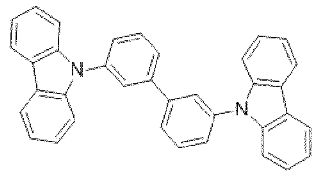

H-19

**10.** Composition selon l'une quelconque des revendications 1 à 9, dans laquelle
le troisième composé émet une fluorescence retardée ; et/ou
dans laquelle
le troisième composé est représenté par une formule choisie entre les Formules 3 et 4 :

<Formule 3>

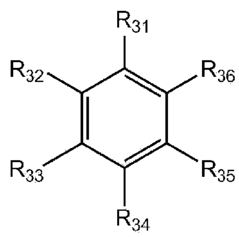

<Formule 12-1> <Formule 12-2>

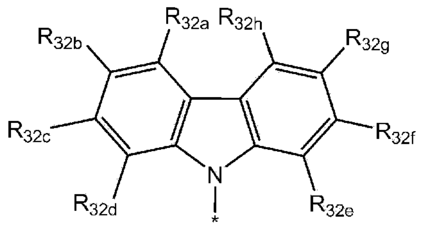

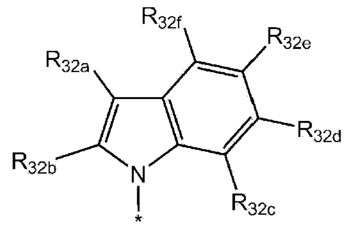

<Formule 4>

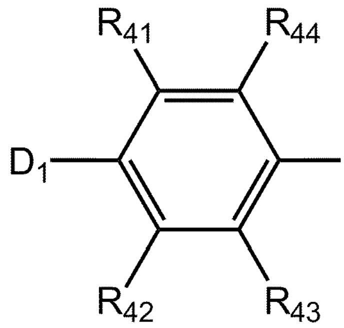

<Formule 13-1>

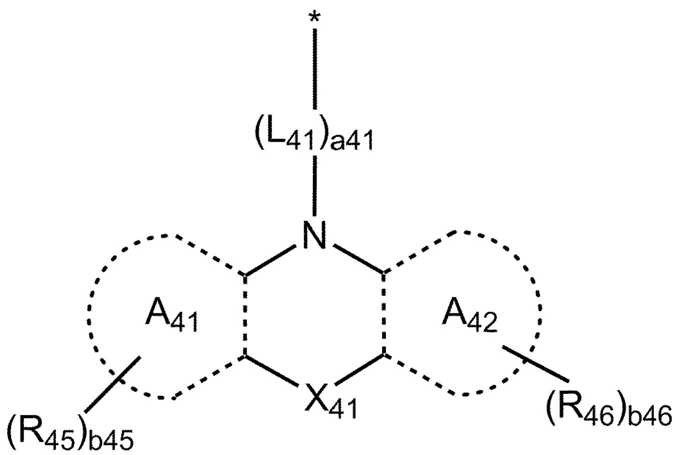

<Formule 14-1>

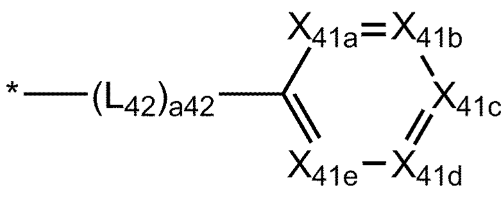

,

où, dans les Formules 3, 4, 12-1, 12-2, 13-1, et 14-1,

$R_{31}$ à $R_{36}$ sont chacun indépendamment choisis parmi un groupe représenté par la Formule 12-1, un groupe représenté par la Formule 12-2, hydrogène, deutérium, -F, -Cl, - Br, -I, groupe hydroxyle, groupe cyano, groupe alkyle $C_1$-$C_{60}$ substitué ou non substitué, groupe alkoxy $C_1$-$C_{60}$ substitué ou non substitué, groupe aryle $C_6$-$C_{60}$ substitué ou non substitué, groupe aryloxy $C_6$-$C_{60}$ substitué ou non substitué, groupe arylthio $C_6$-$C_{60}$ substitué ou non substitué, et groupe hétéroaryle $C_1$-$C_{60}$ substitué ou non substitué,

au moins un élément choisi parmi $R_{31}$ à $R_{36}$ est un groupe cyano,
au moins un élément choisi parmi $R_{31}$ à $R_{36}$ est choisi parmi un groupe représenté par la Formule 12-1 et un groupe représenté par la Formule 12-2,
$D_1$ est un groupe représenté par la Formule 13-1,
$A_1$ est un groupe représenté par la Formule 14-1,
$X_{41}$ est choisi parmi une liaison simple, O, S, $N(R_{47})$, et $C(R_{47})(R_{48})$,
$A_{41}$ et $A_{42}$ sont chacun indépendamment choisis parmi groupe benzène, groupe fluorène, groupe carbazole, groupe dibenzofurane, groupe dibenzothiophène, groupe indolofluorène, groupe indolocarbazole, groupe indolodibenzofurane, groupe indolodibenzothiophène, groupe indenofluorène, groupe indenocarbazole, groupe indenodibenzofurane, groupe indenodibenzothiophène, groupe benzofuranofluorène, groupe benzofuranocarbazole, groupe benzofuranodibenzofurane, groupe benzofuranodibenzothiophène, groupe benzothienofluorène, groupe benzothienocarbazole, groupe benzothienodibenzofurane, et groupe benzothienodibenzothiophène,
$L_{41}$ et $L_{42}$ sont chacun indépendamment choisis entre un groupe carbocyclique $C_5$-$C_{30}$ substitué et non substitué et un groupe hétérocyclique $C_1$-$C_{30}$ substitué et non substitué,
a41 et a42 sont chacun indépendamment choisis parmi 0, 1, 2, et 3,
$X_{41a}$ est N ou $C(R_{41a})$ ; $X_{41b}$ est N ou $C(R_{41b})$ ; $X_{41c}$ est N ou $C(R_{41c})$ ; $X_{41d}$ est N ou $C(R_{41d})$ ; et $X_{41e}$ est N ou $C(R_{41e})$, où au moins un élément choisi parmi $X_{41a}$ à $X_{41e}$ est N,
$R_{32a}$ à $R_{32h}$, $R_{41}$ à $R_{48}$, et $R_{41a}$ à $R_{41e}$ sont chacun indépendamment choisis parmi hydrogène, deutérium, -F, -Cl, -Br, -I, groupe hydroxyle, groupe cyano, groupe nitro, groupe amino, groupe amidino, groupe hydrazine, groupe hydrazone, groupe acide carboxylique ou un sel de celui-ci, groupe acide sulfonique ou un sel de celui-ci, groupe acide phosphorique ou un sel de celui-ci, groupe alkyle $C_1$-$C_{60}$ substitué ou non substitué, groupe alkényle $C_2$-$C_{60}$ substitué ou non substitué, groupe alkynyle $C_2$-$C_{60}$ substitué ou non substitué, groupe alkoxy $C_1$-$C_{60}$ substitué ou non substitué, groupe cycloalkyle $C_3$-$C_{10}$ substitué ou non substitué, groupe hétérocycloalkyle $C_1$-$C_{10}$ substitué ou non substitué, groupe cycloalkényle $C_3$-$C_{10}$ substitué ou non substitué, groupe hétérocycloalkényle $C_1$-$C_{10}$ substitué ou non substitué, groupe aryle $C_6$-$C_{60}$ substitué ou non substitué, groupe aryloxy $C_6$-$C_{60}$ substitué ou non substitué, groupe arylthio $C_6$-$C_{60}$ substitué ou non substitué, groupe hétéroaryle $C_1$-$C_{60}$ substitué ou non substitué, groupe polycyclique condensé non aromatique monovalent substitué ou non substitué, groupe hétéropolycyclique condensé non aromatique monovalent substitué ou non substitué, $-Si(Q_1)(Q_2)(Q_3)$, $-N(Q_4)(Q_5)$, et - $B(Q_6)(Q_7)$,
b45 et b46 sont chacun indépendamment choisis parmi 1, 2, 3, 4, 5, 6, 7, et 8,
$Q_1$ à $Q_7$ sont chacun indépendamment choisis parmi hydrogène, groupe alkyle $C_1$-$C_{60}$, groupe alkényle $C_2$-$C_{60}$, groupe alkynyle $C_2$-$C_{60}$, groupe alkoxy $C_1$-$C_{60}$, groupe cycloalkyle $C_3$-$C_{10}$, groupe hétérocycloalkyle $C_1$-$C_{10}$, groupe cycloalkényle $C_3$-$C_{10}$, groupe hétérocycloalkényle Ci-Cio, groupe aryle $C_6$-$C_{60}$, groupe hétéroaryle $C_1$-$C_{60}$, groupe polycyclique condensé non aromatique monovalent, et groupe hétéropolycyclique condensé non aromatique monovalent, et
* indique un site de liaison à un atome voisin.

**11.** Composition selon la revendication 10, dans laquelle
un, deux, ou trois éléments choisis parmi $R_{31}$ à $R_{36}$ sont un groupe cyano, et
un, deux, trois, quatre, ou cinq éléments choisis parmi $R_{31}$ à $R_{36}$ sont choisis entre un groupe représenté par la Formule 12-1 et un groupe représenté par la Formule 12-2 ; et/ou
dans laquelle
le troisième composé est représenté par une formule choisie parmi les Formules 3-1 à 3-5

<Formule 3-1>

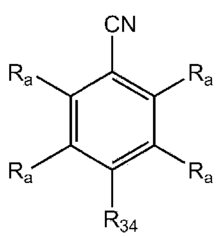

<Formule 3-2>

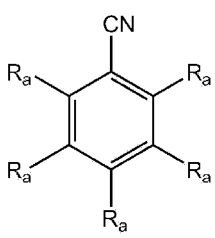

<Formule 3-3>

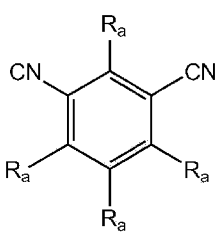

<Formule 3-4> <Formule 3-5>

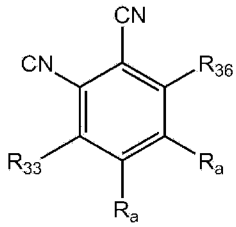

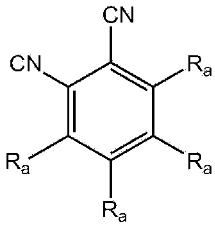

<Formule 12-11>

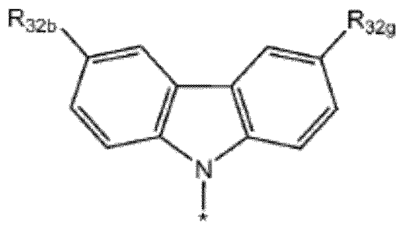

,

où, dans les formules 3-1 à 3-5 et 12-1 et 12-2,

$R_a$ est un groupe représenté par la Formule 12-11,
$R_{33}$, $R_{34}$, et $R_{36}$ sont chacun indépendamment choisis parmi hydrogène, deutérium, -F, -Cl, -Br, -I, groupe hydroxyle, groupe alkyle $C_1$-$C_{10}$, et groupe alkoxy $C_1$-$C_{10}$,
$R_{32b}$ et $R_{32g}$ sont chacun indépendamment choisis parmi hydrogène, deutérium, -F, -Cl,-Br, -I, groupe hydroxyle, groupe alkyle $C_1$-$C_{10}$, groupe alkoxy $C_1$-$C_{10}$, groupe aryle $C_6$-$C_{30}$, et groupe hétéroaryle $C_1$-$C_{30}$, et
* indique un site de liaison à un atome voisin.

**12.** Composition selon l'une quelconque des revendications 1 à 11, dans laquelle le troisième composé est choisi parmi les Composés D-1 à D-23 :

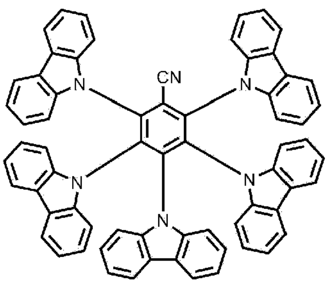

**D-1**

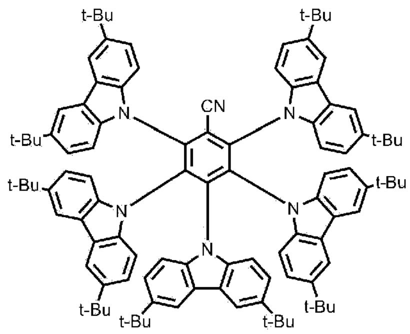

**D-2**

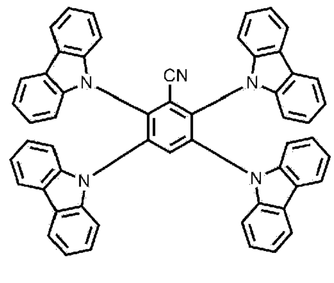

**D-3**

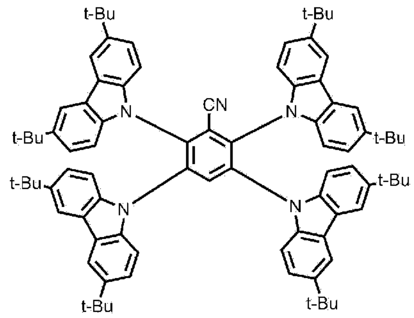

D-4

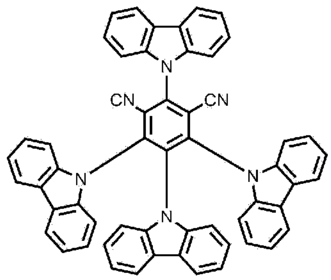

D-5

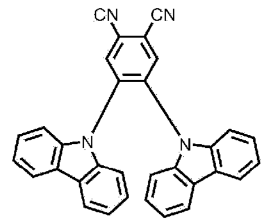

D-6

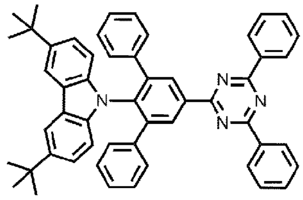

D-7

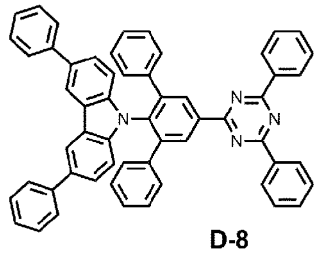

D-8

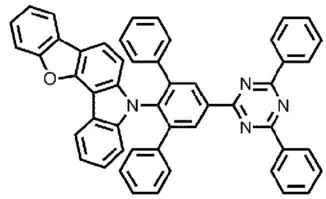

D-9

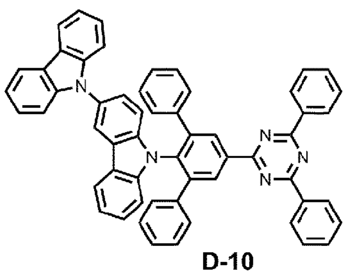

D-10

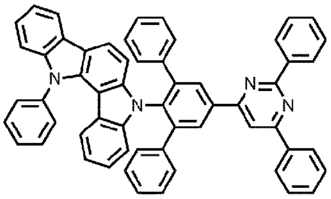

D-11

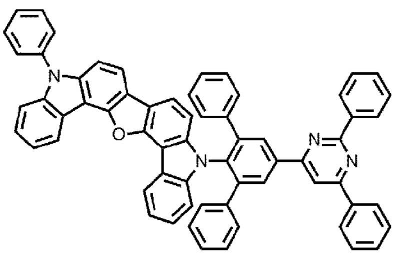

D-12

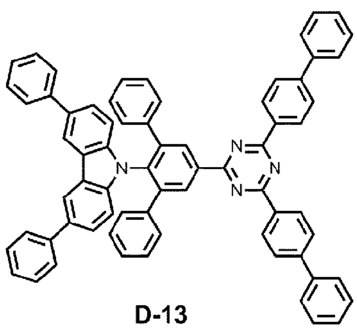

D-13

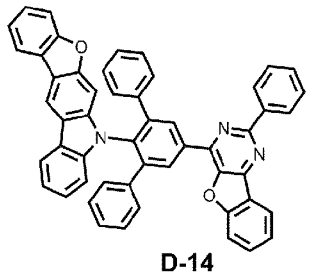

D-14

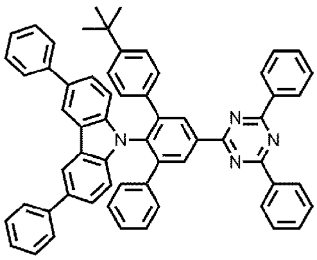

D-15

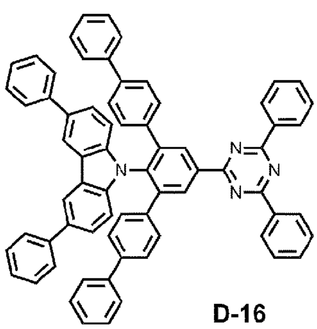

D-16

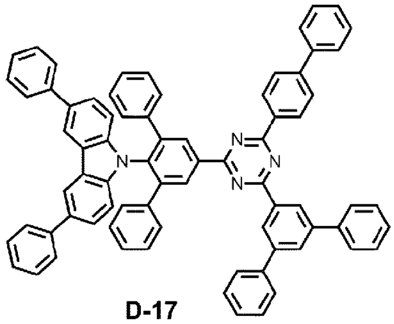

D-17

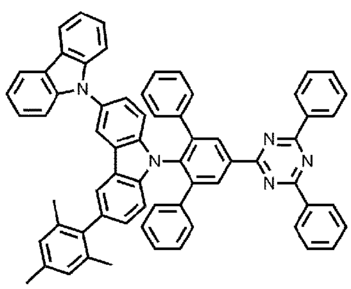

D-18

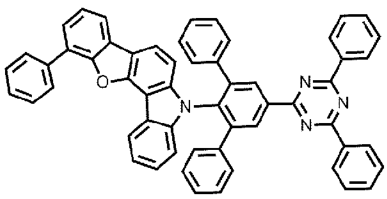

D-19

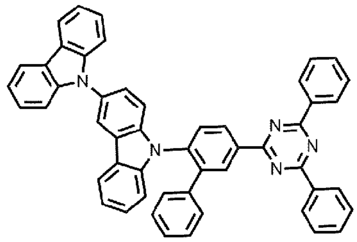

D-20

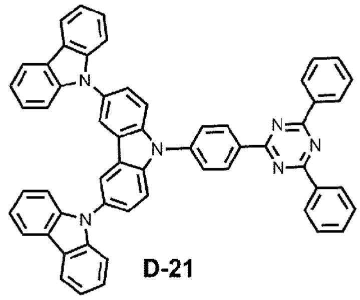

D-21

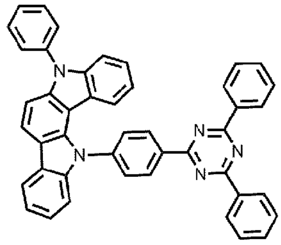

D-22

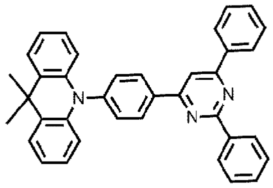

D-23

**13.** Composition selon l'une quelconque des revendications 1 à 12, dans laquelle la composition ne comprend pas de composé organométallique contenant un métal de transition.

**14.** Film mince comprenant la composition selon l'une quelconque des revendications 1 à 13.

**15.** Dispositif électroluminescent organique comprenant :

une première électrode,
une seconde électrode, et
une couche organique entre la première électrode et la seconde électrode,
la couche organique comprenant le film mince de la revendication 14 ;
de préférence
le film mince étant une couche d'émission.

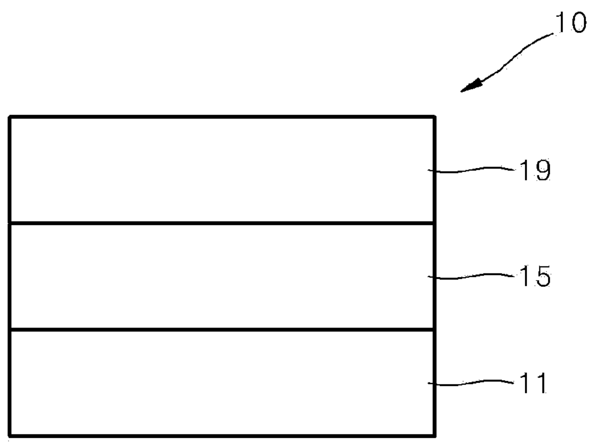
10
19
15
11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3142162 A1
- EP 2876698 A1


### Non-patent literature cited in the description


- *Adv. Mater.,* 2014, vol. 26, 5684-5688
- *Adv. Sci.,* 2017, vol. 4, 1600502